# EUROPEAN PATENT APPLICATION

(11) **EP 4 810 967 A1**
(43) Date of publication of application: **23.09.2026**
(21) Application number: 26165616.9
(22) Date of filing: 17.03.2026
(51) Int. Cl.: G01R 31/317, G01R 35/00, G01R 13/02

(54) **SYSTEMS AND METHODS FOR MULTI-CHANNEL PARALLEL DEVICE TESTING**

(30) Priority: 18.03.2025 US 202563773888 P; 10.11.2025 US 202519384259
(71) Applicant: Chroma ATE Inc., Taoyuan City 333001 (TW)
(72) Inventor: COSTELLO, Michael, Chandler, 85225 (US); HOPKINS, James, Chandler, 85225 (US); SAUM, Andrew, Chandler, 85225 (US); YU, Shih Kai, Chandler, 85225 (US); LEE, Yuan Hua, Chandler, 85225 (US); LU, Amy, Chandler, 85225 (US); YOCH, Brian, Chandler, 85225 (US); WATSON, Kyle, Chandler, 85225 (US); BRUYN, Michael, Chandler, 85225 (US); SAKAUYE, Miles, Chandler, 85225 (US); WU, Shan Pei, Chandler, 85225 (US); LISONBEE, Tanner, Chandler, 85225 (US); PAVLOVIC, Braymil, Chandler, 85225 (US)
(74) Representative: Finnegan Europe LLP

(57) **Abstract**

The disclosure describes systems and methods for parametric multi-channel testing of semiconductor devices. A system provides multiple test channels that include a pulse resource and a measuring resource with high-current (HC) and low-current (LC) switches coupled to a potential node connected to a testing pin. The pulse resource includes a first branch with a pulse generator, programmable-gain amplifier, switches for different branches or operations providing pulse current/voltage monitoring and a high-speed switch. A mode switch can be incorporated to selectively connect the potential node to the pulse resource for pulse testing, to the measuring resource with the HC switch closed for high-potential testing, or to the measuring resource with the LC switch closed for low-potential testing. Channels can further include direct digital synthesizers and processing circuits that generate calibrated test signals, perform analog-to-digital conversion, and execute frequency-domain transforms, with outputs using unique frequency/phase locked for coordinated, low-latency parallel operation.

## Description

### FIELD OF DISCLOSURE

The disclosed technology generally relates to systems, devices, apparatuses, and methods for multi-channel testing of devices, and improvements in parametric testing to facilitate accurate, synchronized, and parallel electrical measurements in circuits and/or semiconductor devices. In particular, and without limitation, the disclosed systems and methods involve multi-channel testing architectures that incorporate configurable test channels, synchronized timing mechanisms, direct digital synthesizers (DDS), and calibration routines for precise parametric analysis. The multi-channel testing systems described herein may be configurable to simultaneously perform various types of electrical measurements with systems that improve measurement accuracy, throughput, and efficiency in semiconductor device testing applications.

### BACKGROUND

Semiconductor devices are integral to modern electronics, powering everything from smartphones and computers to automobiles and medical equipment. As the complexity and miniaturization of these devices increase, ensuring their reliability and performance becomes paramount. Semiconductor testing is a useful process in the manufacturing of these devices, aimed at identifying defects and verifying that each component meets stringent quality standards before reaching the market.

Parametric testing is a subset of semiconductor testing that focuses on measuring the electrical parameters of semiconductor devices. These parameters include voltage, current, resistance, capacitance, impedance, leakage, breakdown voltage, I-V characteristic, or C-V characteristic, which are useful for assessing the functionality and performance of the devices. Parametric tests are conducted at various stages of the semiconductor manufacturing process, including wafer testing, package testing, and final testing.

Wafer testing, performed before the semiconductor wafer is cut into individual chips, is useful for detecting defects early in the production process. This stage involves probing the wafer to measure electrical characteristics and ensure they fall within specified limits. Package testing, conducted after the semiconductor die is assembled and encapsulated, verifies the integrity of the packaging and the connections between the die and the external leads. Final testing, the last stage in the production cycle, ensures that the assembled device meets all performance and reliability standards.

Wafer-level parametric testing can be useful because it provides direct insight into device behavior at an early stage, before packaging or assembly can obscure intrinsic electrical characteristics. By probing test structures and transistors distributed across a wafer, engineers can evaluate process uniformity, monitor shifts in threshold voltage, leakage, or capacitance, and generate statistical data on device variability. These measurements not only help identify defective dies but also guide process control and yield improvement, making parametric testing a cornerstone of both device characterization and manufacturing quality assurance.

### SUMMARY

Semiconductor devices often undergo parametric testing at the wafer stage to evaluate electrical characteristics, e.g., resistance, capacitance, inductance, current-voltage (I-V), and capacitance-voltage (C-V) behavior to monitor wafer manufacturing processes, control fabrication reliability, oversee process variations, and protect yields. A device under test (DUT) may be a single die on a wafer, a dedicated test structure, or a packaged component. Test setups can include a test head, a prober, an instrument tester, and host control software.

Some testing of semiconductor devices use a single-instrument approach, a single LCR (Inductance (L), Capacitance (C), and Resistance (R)) meter or measurement unit is routed through a switch matrix or multiplexer to exercise different test pins or DUTs in sequence. While this "single-instrument plus switching" architecture can reduce upfront complexity and cost, it imposes limitations in high-throughput and high-accuracy settings. For instance, the throughput may be constrained by per-switch settling and parasitic charge or discharge, and true simultaneous measurements are not available. Further, long routing and relay paths can also introduce added parasitics, leakage, crosstalk, and switching transients that degrade signal integrity and reduce bandwidth. Further, repeatability may suffer from temperature variations and contact drift.

The disclosed technology is directed at solving problems in testing systems and improving the speed, accuracy and overall process flow of semiconductor testing with a system that enables independent multi-channel parametric testing. The disclosed technology provides a parametric test platform that delivers improved measurement performance in a production environment, overcoming limitations of other systems that rely on centralized switch matrices and shared instrumentation. For example, some aspects of the disclosed technology incorporate a per-pin architecture in which each test pin can be equipped with dedicated source/measure resources. The disclosed technology eliminates switching delays, reduces measurement parasitics, and enables true parallel testing of multiple devices. Embodiments of the disclosed technology, thus, can provide higher throughput and improved data fidelity compared to other systems, which often requires serial testing and suffered from correlation gaps between benchtop analyzers and automated test equipment.

Moreover, the disclosed systems can integrate advanced resources such as high-frequency capacitance measurement units and pulse generators capable of delivering high-voltage, tri-state waveforms. For example, in embodiments of the disclosed systems these resources can be located within the test head to be routed directly to the probe card interface, shortening the analog path between the DUT and the instrument, which increases the effective bandwidth of the force and sense paths, lowers series inductance and RC loading, improves edge fidelity and settling, and reduces crosstalk and leakage. With these features, the disclosed systems can extend measurement coverage to advanced device nodes and multiple applications (including for example dielectric evaluation and memory technology assessment). Further, disclosed embodiments also incorporate specialized software platforms that permit faster and unified test development and execution across benchtop and production environments, allowing test algorithms to be created once and deployed seamlessly with more consistent results.

Some aspects of the disclosed technology introduce a channel that consolidates multiple measuring units-such as a source measure unit (SMU), a capacitance measurement unit (CMU), a frequency measurement unit (FMU), a pulse generator unit (PGU), and a Pulsed-IV path (PulseIV)-and can be reconfigured on demand to perform diverse measurements within a single channel. Such variable channel or xMU may incorporate the multiple resources and use a switch network for selectively route to a common interface consisting of a driven force terminal and a high-impedance sense terminal. The switch network allows selecting functions while protecting measurement integrity and preventing back-driving. For example, the CMU can be steered between its high and low paths to realize classic four-terminal techniques, whereas the pulsed engines can apply or capture fast waveforms at the same interface. This integrated, per-channel architecture enables rapid reconfiguration among DC, AC, and pulsed modes without external cabling or a shared matrix, reducing parasitics and improving parallel test throughput. For example, in one mode, the CMU performs four-terminal Kelvin C-V with driven guard while the SMU back-biases the DUT; in another, the PGU/PulseIV path delivers pulses, and the FMU counts periods reciprocally at a comparator threshold set by an DAC. Because these resources are co-located per pin and phase-locked across channels, the xMU system can support true parallel, low-parasitic measurements with reduced settling and repeatable timing, improving throughput and data fidelity without reliance on centralized switch matrices.

Some aspects are directed to a system for parametric multi-channel testing that includes a plurality of test channels. The test channels can include a pulse resource, a measuring resource having a high current (HC) switch and a low current (LC) switch, and/or a mode switch coupled to the pulse resource, the measuring resource, and/or a potential node that can be coupled to a testing pin. In operation, the potential node can be configured for pulse testing (which may include pulse delivery, pulse measurement, or both) when the mode switch connects the pulse resource with the potential node; the potential node can also be configured for high potential (HP) testing when the HC switch is closed and the mode switch connects the measuring resource with the potential node; and the potential node can be configured for low potential (LP) testing when the LC switch is closed and the mode switch connects the measuring resource with the potential node.

Other aspects are directed to a system for parallel testing including one or more processors, a system clock, and a plurality of test channels coupled to the one or more processors. The test channels may include at least one of: a pulse resource including a first branch and a second branch and a high-speed switch coupled to the first and second branches; or a measuring resource including a first configurable switch, a second configurable switch, and a direct digital synthesizer. These components can be coupled together with a mode switch that can be coupled to a testing pin. The first branch in the pulse resource can include a pulse generator, a programmable-gain amplifier (PGA), and a first-branch switch (e.g., a configurable switch); the second branch of the pulse resource can provide pulsed current and voltage measurements and includes a second-branch switch. Any of the test channels can be configurable as a high channel, a low channel, a pulse generator, or a measurement channel based on the configuration of the first configurable switch, the second configurable switch, and the mode switch. Further, the one or more processors can be configured to: configure the direct digital synthesizers in the test channels to generate test signals with unique frequency or phase; and simultaneously measure a group of the test channels by configuring corresponding direct digital synthesizers to generate test signals having phase and frequency determined based on the system clock.

Yet other aspects are directed to a system of parametric multi-channel testing including a plurality of test channels. The test channels include a resource including one or more of a pulse resource and a measuring resource, a channel processing circuit, a mode switch coupled to the pulse resource, the measuring resource, and the processing circuit, and a node coupled to the mode switch and a testing pin. The pulse resource can include a high-speed switch and a programmable-gain amplifier, and the measuring resource includes a first configurable switch, a second configurable switch, and a direct digital synthesizer. The test channels are configurable via a processor to operate as any of a high channel, a low channel, a pulse generator, or a measurement channel based on an arrangement of the first configurable switch, the second configurable switch, and the mode switch. The direct digital synthesizers in the test channels are configured to generate test signals with unique frequency or phase and are calibrated with respect to a system clock. The processing circuit is configured to perform operations including at least one of converting analog measurements to digital measurements, transforming signals from the time domain into the frequency domain, or transmitting digital data to a processor.

Yet some example implementations of the disclosed systems are directed to a system for parametric multi-channel testing. The system may include a plurality of test channels, each incorporating a pulse resource, a measuring resource having a first configurable switch and a second configurable switch, a channel processing circuit, and a node coupled to a corresponding testing pin. The mode and arrangement of the configurable switches determine whether the channel operates as a high channel, a low channel, a pulse generator, or a measurement channel, enabling per-channel reconfiguration without the need for external relay matrices. Each test channel further includes a direct digital synthesizer (DDS) that generates precisely timed analog test signals. The DDS units are synchronized and calibrated with respect to a global system clock to maintain consistent phase and frequency alignment across all channels. Through processor control, the DDS units can be programmed with unique phase offsets or frequencies, allowing channels to stimulate or measure distinct portions of a device under test while operating coherently within a unified timing domain.

The channel processing circuit in each test channel performs localized signal processing operations, which can include converting analog measurements to digital form using on-channel analog-to-digital conversion and transforming those digital signals from the time domain into the frequency domain using computational elements such as fast Fourier transform (FFT) circuitry. The processing circuit may also packetize and transmit processed data to a centralized processor or controller for higher-level analysis or storage. This distributed processing approach reduces data throughput bottlenecks and minimizes timing skew that can otherwise arise when all measurements are collected externally. By embedding generation, measurement, and signal processing capabilities at the channel level, the disclosed architecture enables scalable, low-latency, and phase-coherent multi-channel parametric testing. This configuration enhances overall test fidelity, supports high-speed device characterization, and allows complex synchronized measurement patterns that would be difficult to implement using conventional centralized test systems.

### BRIEF DESCRIPTION OF THE DRAWINGS

Details of one or more aspects of the subject matter described in this disclosure are set forth in the accompanying drawings and the description below. However, the accompanying drawings illustrate only some typical aspects of this disclosure and are therefore not to be considered limiting of its scope. Other features, aspects, and advantages will become apparent from the description, the drawings, and the claims.
FIG. 1 illustrates a schematic view of a multi-channel parallel device testing system according to an embodiment of the present disclosure.
FIG. 2 illustrates a top-front view of a test head of the multi-channel parallel device testing system according to an embodiment of the present disclosure.
FIG. 3 illustrates a bottom-back view of the test head of the multi-channel parallel device testing system according to an embodiment of the present disclosure.
FIG. 4 illustrates a front view of the test head of the multi-channel parallel device testing system according to an embodiment of the present disclosure.
FIG. 5 illustrates a schematic view of a retractable electrical contact interface apparatus in a retracted position according to an embodiment of the present disclosure.
FIG. 6 illustrates a schematic view of a power supply of the top assembly according to an embodiment of the present disclosure.
FIG. 7 illustrates a hub block diagram of the multi-channel parallel device testing system according to an embodiment of the present disclosure.
FIG. 8 illustrates a hub architecture and communication according to an embodiment of the present disclosure.
FIG. 9 illustrates a parameter block diagram of the top assembly according to an embodiment of the present disclosure.
FIG. 10 illustrates a schematic circuit of a test channel in the multi-channel parallel device testing system according to an embodiment of the present disclosure.
FIG. 11 illustrates a block diagram for an adaptable testing channel according to an embodiment of the present disclosure.
FIG. 12 illustrates a block diagram of a resource card according to an embodiment of the present disclosure.
FIG. 13 illustrates a schematic circuit of the pulse daughter board according to an embodiment of the present disclosure.
FIG. 14 illustrates a block diagram of a Frequency Measurement Unit (FMU) reciprocal mode according to an embodiment of the present disclosure.
FIG. 15 illustrates a measurement path of a Capacitance Measurement Unit (CMU) according to an embodiment of the present disclosure.
FIG. 16 illustrates a block diagram of the CMU according to an embodiment of the present disclosure.
FIG. 17 illustrates a block diagram of Measuring Unit (MU) with Transimpedance Amplifier (TIA) according to an embodiment of the present disclosure.
FIG. 18 illustrates a schematic circuit of the test channel of the multi-channel parallel device testing system according to an embodiment of the present disclosure.
FIG. 19 illustrates a schematic circuit of the test channel of the multi-channel parallel device testing system for high impedance DUT according to an embodiment of the present disclosure.
FIG. 20 illustrates a block diagram of multiple test channels in a multi-channel parallel device testing system according to an embodiment of the present disclosure.
FIG. 21 illustrates a block diagram of multiple test channels in a multi-channel parallel device testing system for high impedance DUT according to an embodiment of the present disclosure.
FIG. 22 illustrates an embodiment of a test system according to an embodiment of the present disclosure.
FIG. 23 illustrates another embodiment of a test system for high impedance DUT according to an embodiment of the present disclosure.
FIG. 24 illustrates a schematic circuit for measuring a C-V characteristic of a MOSFET on a wafer that the multi-channel parallel device testing system is mounted according to an embodiment of the present disclosure.
FIG. 25 illustrates a schematic circuit for measuring a C-V characteristic according to an embodiment of the present disclosure.
FIG. 26 illustrates a schematic of a single high channel and other low channels testing according to an embodiment of the present disclosure.
FIG. 27A illustrates a schematic of a first high-speed pulse IV test according to an embodiment of the present disclosure.
FIG. 27B illustrates a schematic of a second high-speed pulse IV test according to an embodiment of the present disclosure.
FIG. 28 illustrates a calibration block diagram according to an embodiment of the present disclosure.
FIG. 29 illustrates a flow chart of a calibration method according to an embodiment of the present disclosure.
FIG. 30 illustrates a flow chart of a calibration method according to an embodiment of the present disclosure.
FIG. 31 illustrates a flow chart of a calibration method according to an embodiment of the present disclosure.
FIG. 32 illustrates a flow chart of a method for configuration digital synthesizers according to an embodiment of the present disclosure.
FIG. 33 illustrates a flow chart of a method for configuration processors and/or digital synthesizers according to an embodiment of the present disclosure.

### DETAILED DESCRIPTION

Some of the disclosed embodiments are described with reference to the accompanying drawings. In the figures, the left-most digit(s) of a reference number identifies the figure in which the reference number first appears. Wherever convenient, the same reference numbers are used throughout the drawings to refer to the same or like parts. In the following detailed description, numerous specific details are set forth in order to provide a thorough understanding of the disclosed example systems or methods. However, it will be understood by those skilled in the art that the principles of the example methods and systems may be practiced without every specific detail. Well-known methods, procedures, and components have not been described in detail so as not to obscure the principles of some of the disclosed methods and systems. Unless explicitly stated, the example methods and processes described herein are neither constrained to a particular order or sequence nor constrained to a particular system configuration. Additionally, some of the described methods and systems or elements thereof can occur or be performed (e.g., executed) simultaneously, at the same point in time, or concurrently.

It is to be understood that both the foregoing general description and the following detailed description are example and explanatory only and are not restrictive of this disclosure. The accompanying drawings, which are incorporated in and constitute a part of this specification, illustrate several disclosed methods and systems and together with the description, serve to outline principles of some of the disclosed methods and systems.

In some aspects of the disclosed technology, a parametric multi-channel tester includes a plurality of test channels, each built with a pulse resource, a measuring resource that provides a high-current (HC) switch and a low-current (LC) switch, and a mode switch coupled among the pulse resource, the measuring resource, and a channel potential node that connects to a testing pin. A system clock distributes timing to the channels to maintain precise coordination. When the mode switch couples the pulse resource to the potential node, the channel delivers a programmed pulse to the pin; when the mode switch instead couples the measuring resource and the HC switch is closed, the node operates in a high-potential (HP) test condition; and when the LC switch is closed, the node operates in a low-potential (LP) test condition. By embedding both pulse testing and measurement functions in the same signal path, the architecture eliminates the delay and parasitics associated with external switching matrices. This integration allows each channel to change operating mode electronically, reducing transition time and improving the accuracy of voltage and current control directly at the device under test (DUT).

In certain implementations, each channel of the testing system can include a local channel clock (e.g., a per-test channel clock) that locks in frequency and phase to a shared system clock, ensuring precise synchronization across the test array. Calibration logic programs a per-channel phase offset that compensates propagation delay so the effective timing of each channel aligns at the DUT. And safety interlocks enforce alternate operation of the HC and LC switches, such that when one branch closes, the other remains open. This clocking and switching scheme provides deterministic synchronization and protects against overcurrent or range overlap. As a result, timing skew between channels is minimized, allowing simultaneous measurements with sub-nanosecond phase consistency and significantly improving test repeatability in high-speed device characterization.

In some implementations, each channel of the system may include a force conductor that connects from the potential node through the mode and range switches to the DUT, and a sense conductor that couples the measuring resource to the DUT for feedback. The force line can provide the programmed excitation or bias, while the sense line monitors the true potential at the DUT. This four-wire arrangement allows the measurement circuitry to regulate voltage based on the sensed potential rather than the output driver voltage, thereby compensating for lead and contact resistance.

In some implementations, a measuring resource per channel can incorporate both a capacitance-measuring unit (CMU) and a source measuring unit (SMU), and the system instantiates at least four channels. Control logic drives the first, second, and third channels to a first dynamic potential and the fourth channel to a second dynamic potential that differs from the first. The CMU applies a voltage sweep and measures capacitance as a function of these potentials, generating capacitance-voltage characteristics under differential bias conditions.

In some aspects, each channel of the disclosed system may include a direct digital synthesizer (DDS) configured to generate a test waveform that is both phase- and frequency-locked to the system clock. Because each channel derives its timing from the same reference, multiple channels can stimulate or sample the DUT in a coherent manner. The channels can be configured to be phase-aligned, improving the accuracy of cross-channel correlation.

In certain embodiments, each channel integrates a local memory, a pair of analog-to-digital converters (ADCs), and two direct digital synthesizers (DDSs). The first DDS may drive the potential node with a programmable excitation waveform, while the second DDS provides a sampling clock or phase marker for the ADCs. Both ADC can capture response data and store it in channel memory for real-time or deferred analysis.

In some implementations, each channel also includes first and second fast Fourier transform (FFT) circuits coupled to the corresponding ADCs and memory. The FFT circuits convert digitized samples into frequency-domain spectra directly within the hardware channel. By performing these transformations locally, the tester avoids the latency of transferring large data sets to a central processor and can instead compute harmonic distortion, gain response, or impedance in near real time. This localized processing improves test throughput and enables adaptive measurement control based on frequency-domain feedback. Further, DDS units can generate the measurement stimulus while the ADC and FFT chain captures and analyzes the resulting DUT response. The close coupling between signal generation and acquisition allows phase-coherent operation with minimal timing uncertainty. Performing both tasks within the same channel reduces external cabling and can improve signal integrity, enabling rapid extraction of amplitude, phase, and impedance characteristics under controlled timing.

In some aspects of the disclosed technology, the tester can provide at least eight synchronized channels, each with independently programmable amplitude and phase settings that remain calibrated to a shared system clock. Each channel's pulse resource may include a digital-to-analog converter (DAC) driving multiple programmable-gain amplifiers (PGAs), with their outputs selectable through a high-speed switch. This configuration may support dynamic range scaling and flexible waveform shaping without losing phase alignment. As a result, the tester can drive and measure multiple DUT pins concurrently, achieving high throughput with consistent amplitude and phase accuracy across all channels.

In another aspect, a processor coupled to the system clock coordinates channel calibration. Each channel includes a DDS that accepts calibration data from the processor. During a calibration routine, the processor can output a reference, measures the relative phase delay of each channel, and writes a corresponding correction into a phase-shift register of each DDS. Once stored, these offsets may automatically adjust subsequent waveform generation so that all channels remain phase-aligned.

In some embodiments, each DDS in the channels may generate its waveform using a numerically controlled oscillator (NCO) that operates on the system clock. A programmable phase offset applied within the NCO may compensate for per-channel skew measured during calibration. Because the correction may be implemented directly in the digital phase accumulator, synchronization accuracy is preserved even during frequency changes or waveform modulation. The approach improves phase coherence and timing precision across channels, particularly in high-frequency or pulsed tests.

In coordinated operation, DDS units across the test channels can produce test signals that are phase-aligned to the same system clock reference. Such synchronization enables coherent pulsing, step-bias sequencing, and other time-sensitive measurements that depend on simultaneous excitation of multiple pins. The alignment of waveform phase and timing across channels results in cleaner multi-pin correlation and reduces uncertainty in transient and frequency-domain data.

In certain embodiments, each channel may be configured to incorporate separate high-potential (HP) and low-potential (LP) circuits, and control logic alternates operation between these circuits using the HC and LC switches. This configuration allows the tester to apply large-signal pulses or measure high-voltage behavior in HP mode and then seamlessly transition to low-noise, high-sensitivity LP mode without physically disconnecting the DUT. The dual-path architecture may support wide dynamic range characterization while preserving signal integrity and minimizing mechanical wear from repeated switching.

In some calibration routines, the processor may multiplex a reference signal into both the HP and LP circuits of each channel and aligns that signal to a global trigger to maintain uniform phase across the tester. The processor then measures each circuit's amplitude and phase response, generates a second reference signal for comparison, and computes correction coefficients for each path. These coefficients update the channel's gain and phase characteristics so that HP and LP modes remain precisely matched. Automated calibration of this type improves range-to-range consistency and ensures accurate cross-mode data correlation.

In an example implementation, the first reference signal can be set up a sine wave and the second reference may be an internally generated calibration tone. After calibrating the HP circuit, the processor determines any residual phase offset between the HP and LP circuits and writes a compensating phase correction for the LP path.

In some implementations, the processor may store the computed gain and phase correction values in per-channel nonvolatile memory. For example, each channel retrieves its calibration data at startup and applies the stored coefficients automatically during test operation. By embedding calibration at the hardware level, the tester maintains consistent measurement accuracy across environmental variations and reduces setup time between test sessions, improving system stability and repeatability.

In another aspect of the disclosed technology, a system includes one or more processors, a system clock, and a plurality of configurable test channels. Each channel includes a pulse resource, a measuring resource with first and second configurable switches and a DDS, a mode switch, and a potential node coupled to a testing pin. Under processor control, any channel can function as a high, low, pulse, or measurement channel depending on the programmed switch states. The processors synchronize all DDS units to the system clock, allowing each channel to operate at a unique frequency or phase while remaining time-aligned. This reconfigurable structure enables per-pin assignment without hardware modification, dramatically improving throughput and utilization in multi-site wafer or device testing.

In certain embodiments, each channel may include a local processor that executes FFT analysis on captured waveforms, while the main system assigns stimulus frequencies that align with distinct FFT bins to isolate responses across channels. The pulse resource may reside on a pulse board including a programmable-gain amplifier, a slew-rate limiter, and a high-speed switch, together forming clean, high-speed pulses with controlled edge rates. By distributing FFT processing among channels, the system minimizes data-transfer overhead and achieves faster, parallel spectral characterization with high signal isolation.

In some arrangements, each DDS can include a programmable phase-shift register that stores a correction value for that channel. During waveform synthesis, the DDS applies the stored offset to its internal phase accumulator so the channel output remains aligned with the system clock. This self-compensating capability allows long-duration or high-frequency tests to maintain phase alignment without recalibration, ensuring consistent cross-channel timing and repeatable measurement accuracy over extended operation.

Yet some other aspects of the disclosed technology involve a system that integrates, within each channel, a pulse resource, a measuring resource having configurable switches and a DDS, a channel processing circuit, and a mode switch coupled to a node connected to the testing pin. The processor may configure each channel as a high, low, pulse, or measurement path by setting the switch states and DDS parameters, which are all calibrated to the system clock. The processing circuit can digitize analog signals, perform frequency-domain transforms, or transmit data to the host controller. By embedding generation, acquisition, and processing at the channel level, the system achieves reduced latency, higher data fidelity, and scalable, phase-coherent testing across many DUT pins in parallel.

Some aspects of the disclosed technology are directed to systems for parametric multi-channel testing that employ per-channel pulse control and measurement circuitry synchronized by a global system clock. In such systems, a plurality of test channels are provided, each including a pulse resource, a measuring resource having a high-current (HC) switch and a low-current (LC) switch, and a mode switch coupled to a potential node that connects to a corresponding testing pin. The pulse resource in each test channel generates controlled drive waveforms that can be shaped or timed according to calibration or test parameters received from a controller. The mode switch selectively connects the potential node either to the pulse resource or to the measuring resource, thereby determining whether the channel delivers a test pulse or performs a measurement operation. When the mode switch connects the pulse resource to the potential node, the channel applies a pulse waveform to a device under test (DUT) through its testing pin. When the mode switch connects the measuring resource to the potential node and the HC switch is closed, the channel operates in a high-potential (HP) measurement mode suitable for sourcing or measuring high-voltage or large-signal conditions. When the LC switch is closed, the channel operates in a low-potential (LP) mode that supports precision low-current or high-sensitivity measurements. Each test channel can operate under timing signals derived from a common system clock, which maintains frequency and phase alignment across all channels. This synchronization enables simultaneous pulse testing (e.g., both delivery and measurement or each one independently) and parameter testing across multiple pins of the DUT with deterministic timing and minimal skew. The per-channel configuration and timing control allow the system to dynamically reassign roles-such as pulse generation/measurement., high-potential measurement, or low-potential measurement-without relying on external switching matrices or mechanical relays. By combining independent pulse control, synchronized measurement capability, and integrated high- and low-current switching within each channel, the disclosed architecture supports high-speed, flexible, and parallel parametric testing with improved accuracy, reduced switching latency, and enhanced timing coherence across test channels.

Another aspect of the present disclosure is directed to a system for parallel testing that enables flexible per-channel configuration and coordinated signal generation under centralized processor control. In such systems, one or more processors manage a plurality of test channels synchronized by a system clock. Each test channel can include a pulse resource, a measuring resource including a first configurable switch, a second configurable switch, and a direct digital synthesizer (DDS), a mode switch coupled to the pulse resource and the measuring resource, and a potential node connected to a corresponding testing pin. The potential node forms the interface to the device under test (DUT) and serves as the point at which pulse, sourcing, or measurement operations occur. The mode switch determines whether the potential node is coupled to the pulse resource for waveform delivery or to the measuring resource for measurement functions. The configurable switches within the measuring resource allow each channel to be dynamically assigned as a high channel, a low channel, a pulse generator, or a measurement channel. For instance, closing one switch may configure the channel for high-potential operation, while closing the other may configure it for low-potential or sensitive measurement conditions. The DDS in each channel generates a programmable analog waveform whose frequency and phase are derived from the global system clock, ensuring all test channels operate in precise timing alignment. Through coordinated control, the processors configure each DDS to produce test signals with unique frequencies or phases, allowing simultaneous stimulation of multiple DUT pins without cross-interference. The processors can also command the channels to perform concurrent measurements, using timing derived from the same system clock to preserve coherence across the entire test array. By integrating per-channel DDS generation, configurable switching, and mode selection under processor control, the disclosed parallel testing system supports true simultaneous operation across multiple channels. This arrangement allows each channel to independently perform drive or measurement functions while maintaining global phase and frequency synchronization. As a result, the system achieves high-throughput testing with reduced measurement skew and significantly shorter overall test time compared to traditional sequential testers, while maintaining precise timing correlation among all channels.

Yet other aspects of the disclosed technology can involve a system for enhanced multi-channel parametric testing by integrating a channel processing circuit directly within each test channel, along with configurable switches and a dedicated direct digital synthesizer. With this structure, each channel can be reconfigured on demand to act as a high channel, low channel, or measurement channel, giving flexibility in test setup. The local processing circuit can be configured to support analog-to-digital conversion and even frequency-domain transforms, which can reduce data transfer overhead and enable faster, more localized analysis. Combined with calibrated DDS outputs tied to the system clock, the disclosed systems permit a scalable architecture where many channels can work in parallel while delivering precise, synchronized measurement data, something centralized systems could not achieve without significant latency and/or complexity.

Reference will now be made in detail to some of the disclosed methods and systems, examples of which are illustrated in the accompanying drawings.

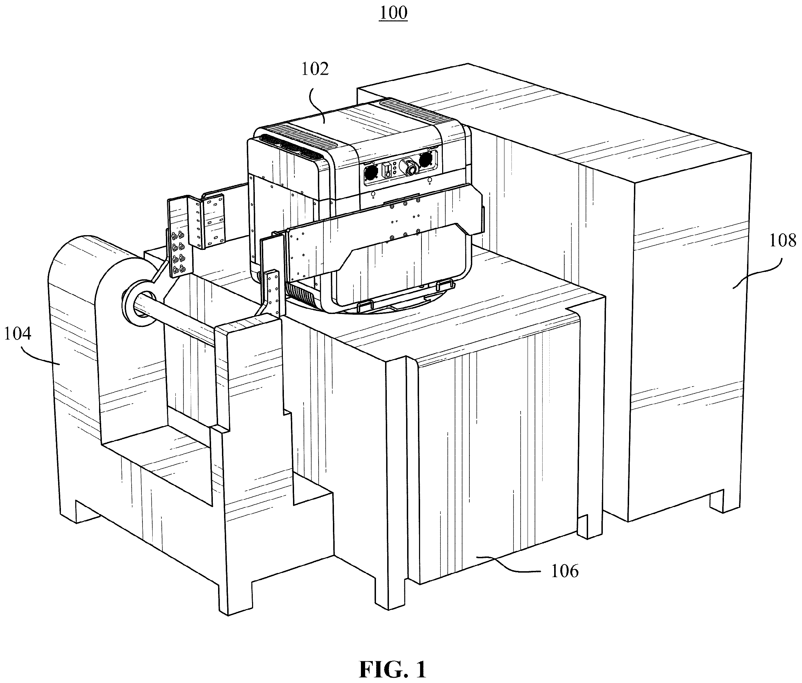

FIG. 1 illustrates a schematic view of a multi-channel parallel device testing system 100 according to an embodiment of the present disclosure. Multi-channel parallel device testing system 100 may include prober 102, tester manipulator 104, prober interface 106, and cabinet 108.

Prober 102 may be rotatably mounted on tester manipulator 104, and may be electrically connected to components in cabinet 108 by high-density cabling or a blind-mate backplane for receiving power, clock, trigger signal, and data. Tester manipulator 104 can be mounted on one side of prober interface 106. Cabinet 108 can be mounted on the other side of prober interface 106. In some embodiments, prober interface 106 can be located between tester manipulator 104 and cabinet 108. Tester manipulator 104 may mechanically center the assembly, hold, and locate prober 102 for aligning to a mating face of prober interface 106. Prober interface 106 may locate beneath prober 102 and be docked to tester manipulator 104.

When tester manipulator 104 rotates, prober 102 may be lowered onto a DUT held by prober interface 106 or may be raised away from the DUT. Cabinet 108 can be connected to prober 102 via coax/differential bundles or a blind-mate back-plane to communicate with the host PC over Ethernet/PCIe.

In some embodiments, prober 102 may function as a main instrumentation module or test head positioned at the front of system 100. In some embodiments, prober 102 can house parametric measurement electronics such as source measure units (SMUs), switching circuits, timing generators, and associated control hardware. Prober 102 may provide the primary electrical interface to a wafer or DUT, and can be configured with high-density triaxial connectors, blind-mate coaxial assemblies, or differential interfaces to reduce insertion loss and signal distortion. In certain embodiments, prober 102 may also include shielding structures, guarded pathways, or integrated calibration circuitry to maintain low leakage and high accuracy across a wide voltage and current range.

In certain embodiments, cabinet 108 may house one or more parametric measurement units, switching assemblies, power distribution modules, and/or cooling systems. Cabinet 108 can be fabricated from sheet metal, aluminum alloy, stainless steel, or composite structures depending on thermal and mechanical requirements. In some embodiments, cabinet 108 may include modular bays or racks for accommodating resource cards or measurement modules, thereby enabling flexible channel expansion. Thermal management can be provided by forced-air cooling, liquid cooling, or hybrid configurations, and cabinet 108 may further include vibration isolation mounts or shock absorbers to reduce external disturbances during sensitive measurements.

Prober 102 and tester manipulator 104 may be constructed from rigid, low-expansion materials such as granite, ceramic composites, or stabilized metal alloys to ensure positional accuracy and mechanical stability during wafer probing operations. In some embodiments, tester manipulator 104 may incorporate linear actuators, pneumatic lifts, or rotary bearings to enable controlled motion when docking and undocking prober 102. Prober interface 106 can include socketed connectors, blind-mate triaxial contacts, or custom high-density pin blocks to electrically couple the prober to cabinet 108. In alternative embodiments, prober interface 106 may incorporate shielding structures or guard traces formed from conductive materials to minimize electrical noise and crosstalk between adjacent test channels.

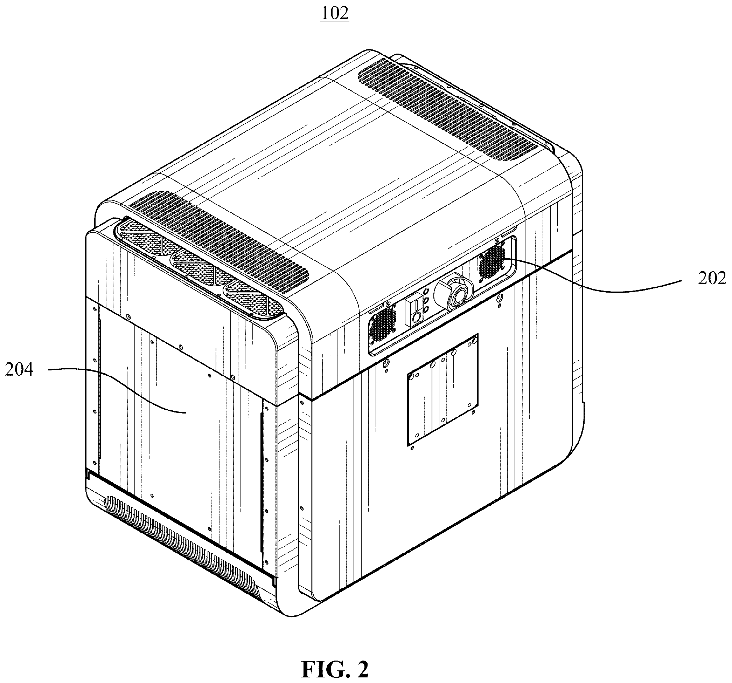

FIG. 2 illustrates a top-front view of prober 102 of system 100 according to embodiments of the present disclosure. As shown in FIG. 2, prober 102 may include interface panel 202 and side panel 204. Interface panel 202 may be located on the front upper region of prober 102. Interface panel 202 may concentrate the connectors used to link prober 102 to cabinet 108 and tester manipulator 104. Interface panel 202 may carry high-density signal connectors, power inlets, clock and trigger ports, and high-rate data links, along with interlock or status terminals. Vent grilles visible near interface panel 202 may provide airflow for cooling and may include dust filtering.

Side panel 204 may be an enclosure plate secured by multiple screws on the side of prober 102. Side panel 204 may provide service access to internal channel electronics for installation, maintenance, or replacement of modules such as HC and LC switching, analog front ends, direct digital synthesizers, analog-to-digital converters, phase-correction registers, and memory. Side panel 204 may incorporate Electro Magnetic Interference (EMI) gaskets, grounding springs, and locating features so that shielding and mechanical rigidity are maintained after reassembly.

In some embodiments, prober 102 may further include ventilation assemblies integrated into the upper and lower regions of the housing. These ventilation assemblies can be configured with forced-air fans, heat exchangers, or liquid cooling conduits to regulate internal temperatures of high-density electronics. The vent grilles may be fabricated from corrosion-resistant alloys or polymer composites, and may incorporate removable filter media to prevent dust accumulation. The placement of these cooling features proximate to interface panel 202 enables localized thermal management near high-power connectors and data links.

Prober 102 may also be constructed with modular exterior panels, including side panel 204, to facilitate flexible servicing and upgrade paths. In some embodiments, the panels may be manufactured from aluminum, stainless steel, or carbon fiber composites depending on weight and shielding requirements. The enclosure can be sealed with EMI gaskets to reduce radiated emissions, and fasteners securing the panels may be configured for tool-less or quick-release access to accelerate maintenance cycles. Optional structural reinforcements, such as internal ribs or honeycomb plates, may be included within prober 102 to improve rigidity and reduce vibration transmission during sensitive measurements.

In alternative embodiments, interface panel 202 may incorporate additional or alternative connector types depending on system configuration. For example, interface panel 202 can include fiber-optic transceivers for high-bandwidth, low-latency data transfer, or wireless communication modules to reduce cabling complexity in certain installations. Redundant power inlets and signal connectors may also be provided to support fault tolerance and hot-swap capability. In some configurations, interface panel 202 can be reconfigurable or replaceable as a module, allowing different connector layouts to be deployed based on application requirements or customer specifications.

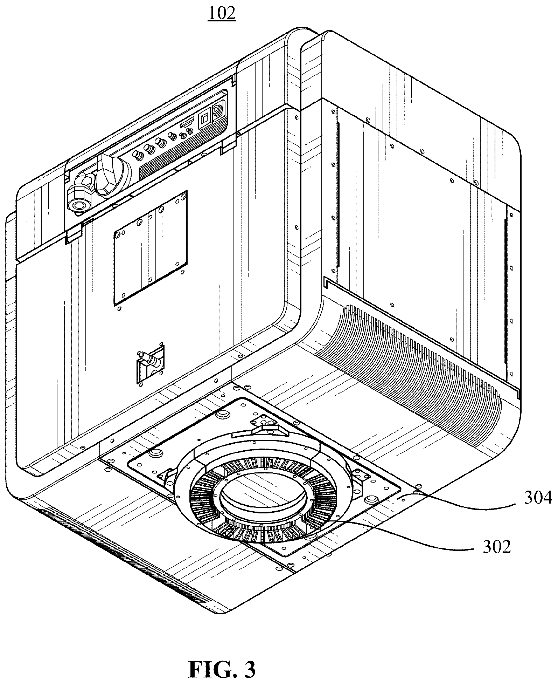

FIG. 3 illustrates a bottom-back view of prober 102 of multi-channel parallel device testing system 100 according to an embodiment of the present disclosure. As shown in FIG. 3, prober 102 may include probe card interface 302 and docking plane 304. Probe card interface 302 may be mounted at the center of docking plane 304 of prober 102 by an annular frame with multiple fasteners and alignment features. Probe card interface 302 may carry an array of probes arranged to contact wafer test points and interfaces electrically to prober 102 through blind-mate connectors that route force and sense signals to the channel front ends within prober 102.

When testing a wafer DUT, the wafer may be raised to engage the probes of probe card interface 302, while prober 102 provides mechanical alignment, shielding, and thermal management, and communicates with the DUT to deliver stimuli and acquire measurement data.

Docking plane 304 may further include mechanical guides, dowel pins, and kinematic mounts that ensure repeatable alignment between probe card interface 302 and the mating connectors within prober 102. In some embodiments, docking plane 304 can be fabricated from aluminum alloy, stainless steel, or ceramic composites to provide a stable, low-expansion platform that maintains positional accuracy across temperature variations. Docking plane 304 may also incorporate shielding layers or conductive coatings to reduce electromagnetic interference and preserve signal integrity during high-precision measurements.

Probe card interface 302 may be configured with interchangeable probe arrays to accommodate different wafer technologies, device geometries, or pad layouts. In some embodiments, probe card interface 302 can employ vertical probe needles or tips, MEMS probe tips, or cantilevered spring contacts, depending on the required pitch and current-handling capacity. The probe card may also include embedded passive components, such as decoupling capacitors or termination resistors, to improve high-frequency performance. For thermal management, probe card interface 302 and docking plane 304 may be coupled to integrated airflow channels or liquid cooling features positioned along the underside of prober 102.

Pins or connectors probe card interface 302 may be arranged in a variety of configurations to permit customization for different testing applications. In some embodiments, the pins may be organized in linear arrays, radial patterns, or high-density grids to match the pad geometry of different wafers or packaged devices. The probe tips may employ vertical spring probes, MEMS micro-springs, or cantilevered needles to accommodate variations in contact force, pitch, and current capacity. Alternative mechanisms can include adjustable probe blocks, replaceable pin inserts, or modular probe arrays that allow rapid reconfiguration without replacing the entire probe card assembly. This flexibility can enable probe card interface 302 to be adapted for logic devices, memory arrays, power semiconductors, or mixed-signal circuits with differing electrical and mechanical requirements.

In some embodiments, probe card interface 302 may further incorporate calibration and alignment mechanisms to ensure consistent electrical contact across the entire pin array. Such mechanisms can include self-planarizing probe structures that adjust tip height during initial touchdown, optical fiducials embedded in docking plane 304 to guide automated vision alignment systems, or mechanical micro-adjusters configured to fine-tune the vertical and lateral position of the probe array. Additional implementations may include integrated height sensors, strain gauges, or capacitive sensors that detect planarity deviations and provide feedback for automated compensation. These features enable probe card interface 302 to maintain accurate contact with wafer pads across varying topographies and thermal conditions, thereby improving repeatability and reducing setup time between tests.

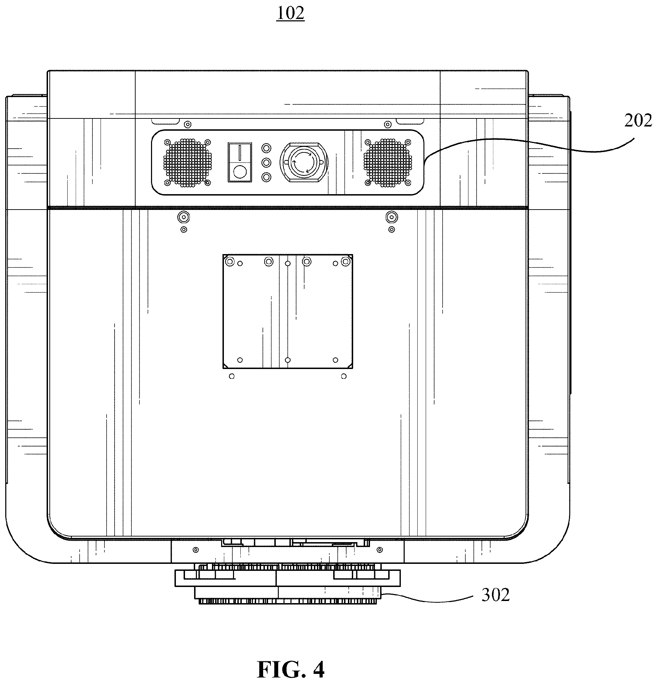

FIG. 4 illustrates a front view of prober 102 of multi-channel parallel device testing system 100 according to an embodiment of the present disclosure. An elongated I/O panel disposed near the upper front groups connectors and indicators for power input, clock and trigger signals, and high-rate data links. Vent grilles adjacent to the panel promote airflow. Fasteners and alignment features around the panel facilitate secure mounting and reliable mating to cable harnesses or a blind-mate backplane. A rectangular service cover located in the mid-lower region provides access for installation, maintenance, or replacement of internal channel electronics and cabling while preserving enclosure shielding and rigidity. Along the lower edge, a docking assembly protrudes to define a mating interface for a probe card interface 302, including an annular structure with mechanical guides and locking points that maintain planarity and repeatable alignment and provide the electrical connection to the channel front ends within the test head. The housing forms a rounded rectangular enclosure with perimeter fasteners and seams that establish a rigid frame and define airflow paths for thermal management. The positions, geometries, and number of the features shown are exemplary and may be varied to meet routing, thermal, or mechanical requirements.

In some embodiments, interface panel 202 may further incorporate modular connector blocks that allow customized layouts depending on system configuration. These blocks can be designed to carry coaxial, triaxial, differential, or fiber-optic terminations, and may be arranged in swappable sub-panels to adapt the prober 102 for different measurement environments. Indicators on interface panel 202 can include LEDs for power status, clock synchronization, error reporting, and thermal alarms, while optional LCD or touchscreen interfaces may provide direct operator feedback and local configuration.

The docking assembly coupled to probe card interface 302 may additionally be configured with spring-loaded clamps, cam locks, or quick-release latches to permit rapid exchange of probe cards without disturbing the mechanical calibration of prober 102. In certain embodiments, the assembly may incorporate precision dowel pins, keyed slots, or optical fiducials to ensure repeatable alignment across repeated docking cycles. To further maintain signal integrity, the annular structure of the docking assembly can include embedded ground rings or shield collars that provide continuous electrical shielding when probe card interface 302 is engaged.

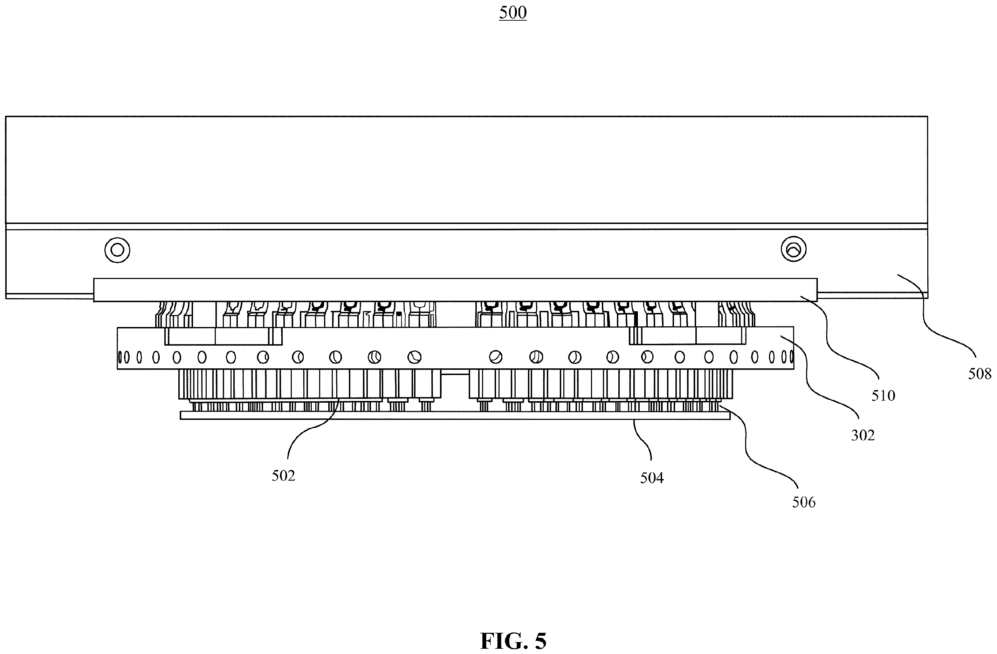

FIG. 5 illustrates a schematic view of a retractable electrical contact interface apparatus 500 in a retracted position according to an embodiment of the present disclosure. Retractable electrical contact interface apparatus 500 may include electrical contact interface assembly 502, electrical connection point 504, spring pins 506, test head housing 508, and retractable electrical contact interface module 510. Electrical connection point 504 may represent a target location for electrical connection, such as an interface of probe card interface 302 or calibration equipment.

Test head housing 508 may mechanically support retractable electrical contact interface, define an opening through which the assembly 502 travels, and provide structural alignment and electromagnetic shielding for the connection to probe card interface 302. Test head housing 508 couples to the test head chassis and presents datum surfaces that set Z-height and planarity relative to the prober. retractable electrical contact interface module 510 mounted to the test head housing 508. Retractable electrical contact module 510 may include a movable electrical contact interface assembly 502 carrying spring pins 506 and may dock to an external electrical connection point 504 on probe card interface 302.

In the retracted state shown in FIG. 5, electrical contact interface assembly 502 may be separated from the electrical connection point 504, so spring pins 506 may not be connected to or pressed by the electrical connection point 504. Assembly 502 may be partially recessed within test head housing 508 so that the leading ends of spring pins 506 may be shrouded and protected from accidental contact, debris, or electrostatic discharge. In contrast to FIG. 5, when electrical contact interface assembly 502 is moved downward to make spring pins 506 contact electrical connection point 504, and therefore establishing an electrical connection.

Accordingly, retractable electrical contact interface apparatus 500 of the present disclosure allows electrical contact interface assembly 502 to extend or retract from electrical connection point 504. This is accomplished by the movement of an actuator lever on the side of multi-channel parallel device testing system 100 which rotates the cylindrical cams to move entire retractable electrical contact interface apparatus 500 into position.

By the design of the retractable electrical contact interface apparatus 500, there may be less chance of damaging spring pins 506 and the wafer prober when docking multi-channel parallel device testing system 100, and may provide more reliable and easier attachment of tester accessories such as calibration equipment.

In addition, test head housing 508 may shield the interface when not engaged to further reduce the risk of pin damage and improving EMI/ESD containment and contamination control during docking and undocking.

In some embodiments, retractable electrical contact interface assembly 502 may be actuated by various mechanisms including motor-driven lead screws, pneumatic cylinders, or cam-based linkages that provide precise and repeatable vertical displacement. The actuation mechanism may further incorporate position sensors, encoders, or limit switches to detect the retracted and engaged states, thereby enabling automated docking sequences under software control. This configuration can reduce operator variability and ensure consistent contact force when spring pins 506 engage electrical connection point 504.

Spring pins 506 may be arranged in customizable patterns to correspond with different electrical connection point geometries. For example, spring pins 506 may be distributed in concentric rings, staggered arrays, or high-density grids depending on the interface requirements of probe card interface 302 or external calibration modules. Each spring pin may include a plunger and barrel assembly formed from conductive alloys such as beryllium copper, plated with gold or palladium for enhanced wear resistance and low contact resistance. Optional compliant bushings or elastomeric supports may also be incorporated to absorb mechanical stress and extend service life under repeated cycling.

Retractable electrical contact interface apparatus 500 may further incorporate environmental sealing or contamination barriers to preserve interface integrity. A retractable dust cover, gasket seals, or positive-pressure airflow may be used to prevent debris from entering test head housing 508 during retraction. In certain embodiments, retractable electrical contact module 510 may include integrated shielding plates or guard rings positioned adjacent to spring pins 506, thereby reducing electromagnetic interference and cross-talk between high-frequency channels.

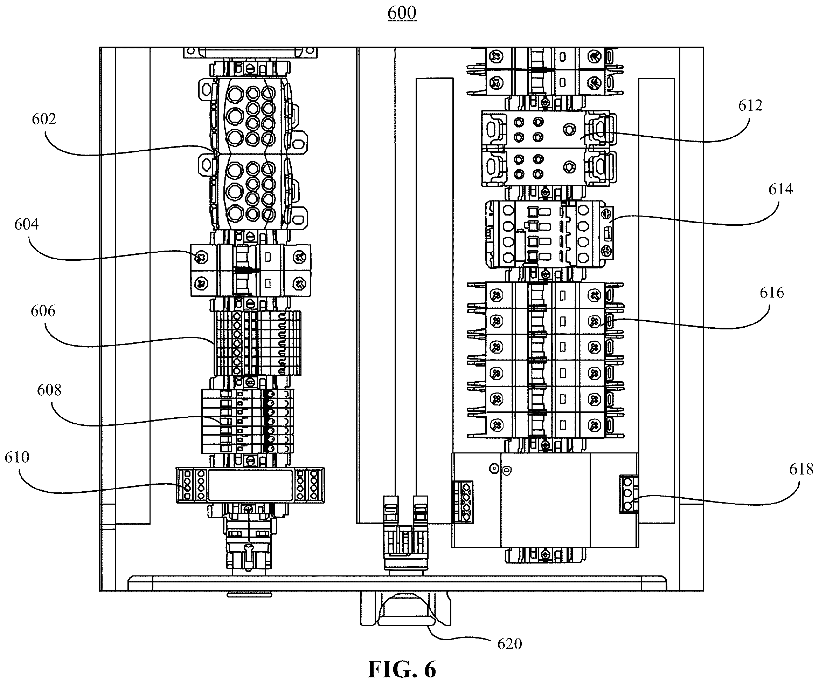

FIG. 6 illustrates a schematic view of a power supply 600 of the top assembly according to an embodiment of the present disclosure. As shown in FIG. 6, power supply 600 may include high-current multi-pin power terminal 602, breaker 604, breaker stack 606, control terminal 608, AC contactor 610, safety relay 612, thermal protection module 614, DC distribution bus 616, DC-DC power module 618, cable entry component 620.

Power supply 600 may provide voltage and current delivery to the resource cards, test elements, and probe interface. Power supply 600 may support various testing requirements, and may incorporate protection circuitry to prevent overvoltage, overcurrent, and overheating, implemented using protective devices such as fuses or breakers, contactors or relays, and thermal sensing. An external emergency shut-off button may be provided to remove power quickly and enhance operational safety. The component positions shown are exemplary and may be varied without departing from the described function.

High-current multi-pin power terminal 602 may distribute controlled power and ground to the test-head backplane and/or the resource cards and may employ keyed and locking features to prevent mis-mating. Breaker 604 may provide first-stage isolation and over-current protection for the AC input and may be tied to an emergency-off (EMO) loop. Breaker stack 606 may supply per-branch protection and, in some embodiments, may incorporate current-sensing elements for load telemetry. Control terminal 608 may accept interlock signals, trigger I/O, fan control, and status lines. AC contactor 610 may close only when host authorization is present and all interlocks are satisfied, thereby serving as the primary connect/disconnect device. Safety relay 612 may aggregate high-voltage and docking interlocks and removes power upon detection of a fault.

Thermal protection module 614 may monitor enclosure or supply temperature and assert alerts upon over-temperature. DC distribution bus 616 may fan out rails, e.g., +48 V, +12 V, +5 V-to the resource slots and may provide per-branch protection and test points. DC-DC power module 618 may convert the AC input or an intermediate bus to the required DC rails and, in some embodiments, supports redundancy, hot-swap, power-factor correction, and EMI filtering. The cable entry component 620 may guide incoming harnesses, provide strain relief, and may furnish a consolidated protective-earth bonding point to enhance electrical safety.

In typical operation, AC power may pass through breaker 604 and AC contactor 610 for isolation and protection, then enter DC-DC power module 618 to generate the required DC rails. These rails may be distributed by the DC distribution bus 616 and may be delivered to the backplane and resource cards via high-current multi-pin power terminal 602. Control and safety signaling may be handled through the control terminal 608, safety relay 612, and thermal protection module 614, ensuring immediate removal of power upon EMO activation or fault detection. The locations and types of the foregoing components may be varied without departing from the function and scope of the power supply 600.

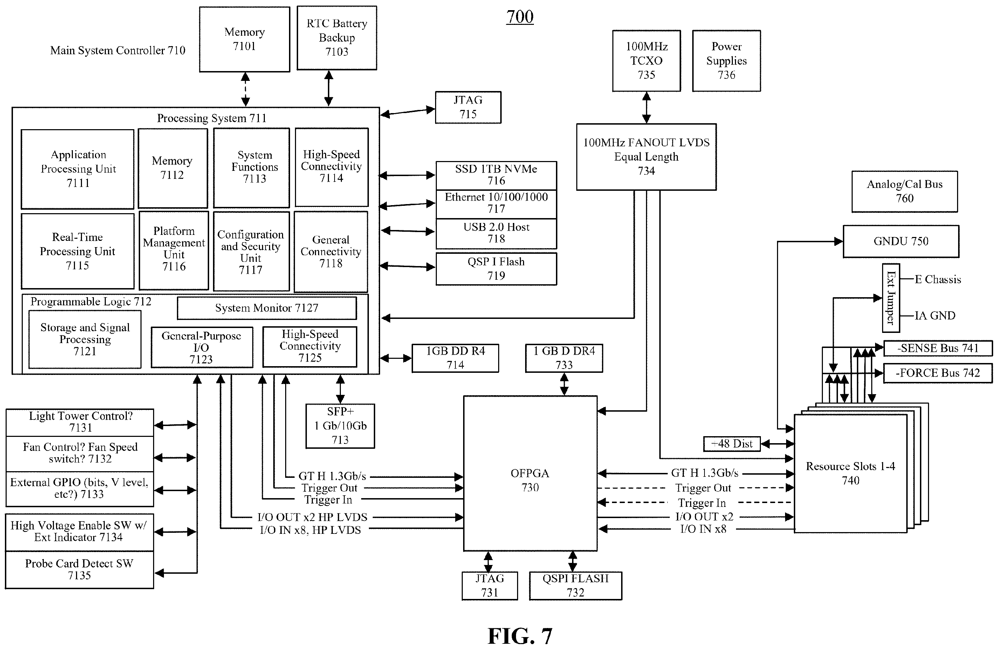

FIG. 7 illustrates a block diagram 700 of multi-channel parallel device testing system 100 in accordance with some embodiments of the present disclosure. A main system controller 710 can coordinate timing, data movement, and system services. Main system controller 710 may include a processing system 711 and programmable logic 712, supervised by a system monitor 7127.

Within processing system 711, application processing unit 7111 may execute high-level test control. Memory 7112 may represent on-chip or attached memory. System functions 7113 may provide timers and peripherals. High-speed connectivity 7114 may expose fast I/O. Real-time processing unit 7115 may service deterministic tasks. Platform management unit 7116 may handle health or telemetry. Configuration and security unit 7117 may manage secure boot or keys. General connectivity 7118 may provide standard serial and general-purpose I/O (GPIO) interfaces. Programmable logic 712 may implement data-plane functions including storage and signal processing 7121, general-purpose I/O 7123, and high-speed connectivity 7125.

Main system controller 710 may interface to external memory and debug. Memory 7101 can be a 4-gigabyte DDR4 memory module with error-correcting code (ECC), and may supply large working memory. Real-Time Clock (RTC) battery backup 7103 may preserve RTC and retention domains. Joint Test Action Group (JTAG) 715 may provide boundary scan and firmware debug.

Output/Front-End Field Programmable Gate Array (OFPGA) 730 may perform channel timing, capture, and distribution. It can have local JTAG 731 for debug, Quad Serial Peripheral Interface (QSPI) flash 732 for bitstream storage, and local memory 733 (e.g., 1-GB DDR4) for buffering vectors and results. A precision Temperature-Compensated Crystal Oscillator (TCXO) 735 feeds Low-Voltage Differential Signaling (LVDS) 734 with equal-length fan-out that distributes a phase-aligned reference to the controller and to the OFPGA (and onward to resources). System power supplies 736 energize these subsystems.

Resources may reside in Resource Slots 1-4 740. Each slot can receive distributions and clock/trigger lines, and connects to shared analog busses: a SENSE Bus 741 and a FORCE Bus 742 for Kelvin routing. A grounding subsystem includes GNDU 750 (ground/force unit) and selectable references, and an Analog/Cal Bus 760 used to inject calibration stimuli and route analog references across slots. The OFPGA 730 fans out high-speed serial links (e.g., GT ~1.3 Gb/s), trigger out/in, and digital I/O OUT ×2 / I/O IN ×8 to the resource slots 740 to support synchronized stimulus and measurement.

In some embodiments, main system controller 710 may further include redundant power domain management and supervisory circuits, such as voltage supervisors, detectors, and over-current protection. Processing system 711 and programmable logic 712 may be connected via a high-bandwidth internal bus to enable configuration, data movement, and control hand-off. Additionally, the system monitor 7127 may oversee temperature sensors, fan control, and thermal alarms located on resource slots, OFPGA 730, and analog/digital front-end modules. The controller may also establish secure communications to external equipment via Ethernet with supported protocols such as TCP/IP, possibly over fiber optics, and may implement TLS or other encryption for data in transit.

OFPGA 730 may receive the common system reference clock (e.g. 100-MHz TCXO 735) and distribute phase-aligned clock and trigger signals both to resource slots 740 and to front-end measurement modules. For example, OFPGA 730 may drive LVDS lines, matched in trace length, to each resource slot to ensure synchronization.

Within resource slots 1-4 (e.g., 740), each slot may include several parametric channels that share analog common buses (sense bus 741, force bus 742), for measurements. Each channel may also have local digital-to-analog or analog-to-digital conversion, and may communicate with OFPGA 730 via dedicated high-speed lines. The Analog/Cal Bus 760 may allow calibration references (voltage, current) to be injected into analog front ends of each resource slot; these references may be provided by precision Digital Analog Converters (DACs) or by external calibration sources. Grounding via ground unit 750 ensures consistent common reference among slots and may allow selection between internal chassis ground, isolated analog ground, or external ground via jumper or connector.

Optional configurations might include additional resource slots beyond four, linked by expansion connectors for large channel counts, or hierarchical OFPGAs for multi-tier synchronization. There may be selectable filter networks in line with force or sense paths for noise suppression, e.g. RC or LC filters, perhaps switchable depending on test requirements. Also, the system could include programmable attenuation or scaling blocks in force lines to support both high current (for legacy or power devices) and low current (for leakage or modern scaled devices) within the same slot.

Collectively, the elements numbered 710-736 provide secure compute, storage, timing, and power for the digital backplane; elements 740-742, 750, 760 implement the resource-side analog/digital distribution and grounding needed for phase-coherent, parallel parametric testing.

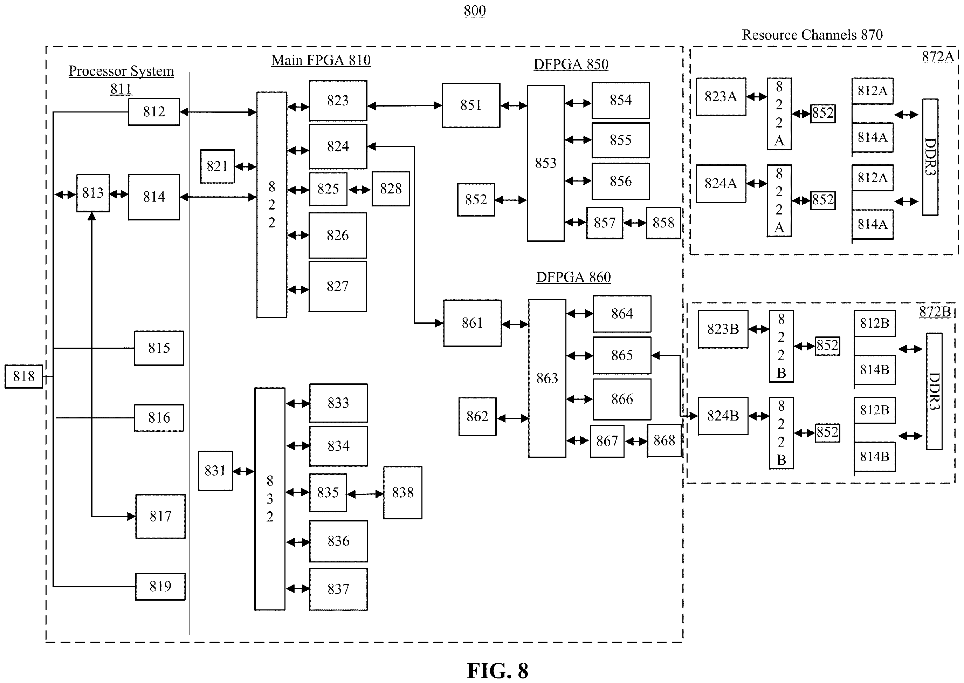

FIG. 8 illustrates a hub architecture and communication 800 according to an embodiment of the present disclosure. As shown in FIG. 8, an exemplary configuration of the present disclosure provides a multi-FPGA hierarchical architecture including a Main FPGA 810, dedicated FPGA (Distributed Field Programmable Gate Array (DFPGA) 850 and DFPGA 860), and a plurality of Resource Channels 870 (shown as Resource Channels 872A and 872B). Through this three-tier structure, large-scale parallel computation and multi-channel data processing may be achieved.

As shown in FIG. 8, Main FPGA 810 can interface with Processor System 811 via ports 812, 815, 816, and 817, each of which may be implemented with Advanced eXtensible Interface (AXI) High Performance interfaces enabling data flow between the programmable logic and processor 813, and peripheral/control logic 814.

External memory module 818 can serve as a buffer for high-capacity storage. Within Main FPGA 810, AXI Interconnect 822 and AXI Interconnect 831 distribute AXI transactions among masters-including processing core 813 and Direct Memory Access (DMA) logic 821- and slaves including DDR4 memory module 828 and multiple Chip2Chip blocks 823, 824, 825, 826, 827, 833, 834, 835, 836, and 837. Blocks 851 and 861 represent Chip2Chip & Aurora link endpoints connecting Main FPGA 810 to DFPGA 850 and DFPGA 860 respectively, thereby enabling high-speed serialized link communication.

Moreover, Resource Channels 870 can include first Resource Channel 872A and second resource channel 872B and each include components analogous to those in Main FPGA 810 and the DFPGAs 850 and 860. For example, Resource Channels may use of AXI-HP interfaces denoted 812A and 812B, control logic denoted 814A and 814B, local DMA logic 852, and local DDR3 memory modules present on each resource channel board. Resource Channels 870 may communicate upstream via Chip2Chip blocks 823-837 in Main FPGA 810 / DFPGAs 850 and 860, enabling scalable fan-out of channel count with local buffering, local control logic, and stimulus/measurement path capability in each resource module.

Main FPGA 810 can also include Processor System 811 and programmable logic fabric. Processor System 811 can include processing core 813 and peripheral/control logic 814. The ports 812, 815, 816, and 817 (AXI-HP0 through AXI-HP3) exchange data with external DDR4 memory 818; DMA logic 821 handles high-volume transfers between processor system 811 and the programmable logic. AXI Interconnects 822 and 831 serve to route transactions among the masters and slaves within Main FPGA 810, maintaining coherency and facilitating distributed communication among Chip2Chip blocks, resource channel interfaces, and memory 828.

Main FPGA 810 can communicate with DFPGAs 850 and 860 via a compact device-to-device interface (e.g., Chip2Chip & Aurora IP) for high-speed data transfer.

DFPGA 850 and DFPGA 860 can serve as intermediate aggregation and distribution nodes. Each DFPGA can include local memory and other processing or buffering logic. DFPGAs 850 receive stimulus/control paths from Main FPGA 810 (via blocks such as 851, 861, 823-827) and fan out data and control to Resource Channels 872A / 872B, for example, through their respective endpoints.

One embodiment of the present disclosure achieves (i) centralized stimulus and control distribution through Main FPGA 810, (ii) parallel buffering, relay, aggregation, and data fan-out via DFPGAs 850 and 860; and (iii) large-scale expansion of Resource Channels 872A / 872B for high channel-count measurement. By integrating endpoints (blocks 823-837, 851, 861) with AXI interconnect architecture (ports 812 / 812A / 812B, interconnects 822 / 831), local DMA logic (821, 852), and buffer memories (DDR4 818 / 828, DDR3 modules in Resource Channels), the system provides high throughput, scalable, low-latency multi-channel test capabilities.

In some embodiments, the Resource Channels 870 may include optional local buffering (e.g., DDR3 or DDR4) to accommodate bursts of measurement data, so that the downstream DFPGAs 850 and 860 or Main FPGA 810 need not keep up continuously in real time. This buffering helps because measurement data (especially for waveforms, transient responses, capacitance sweeps, etc.) can come in bursty fashion. Also, the architecture may allow for local processing (filtering, averaging, correlation) inside resource channels to reduce data volume passed upstream.

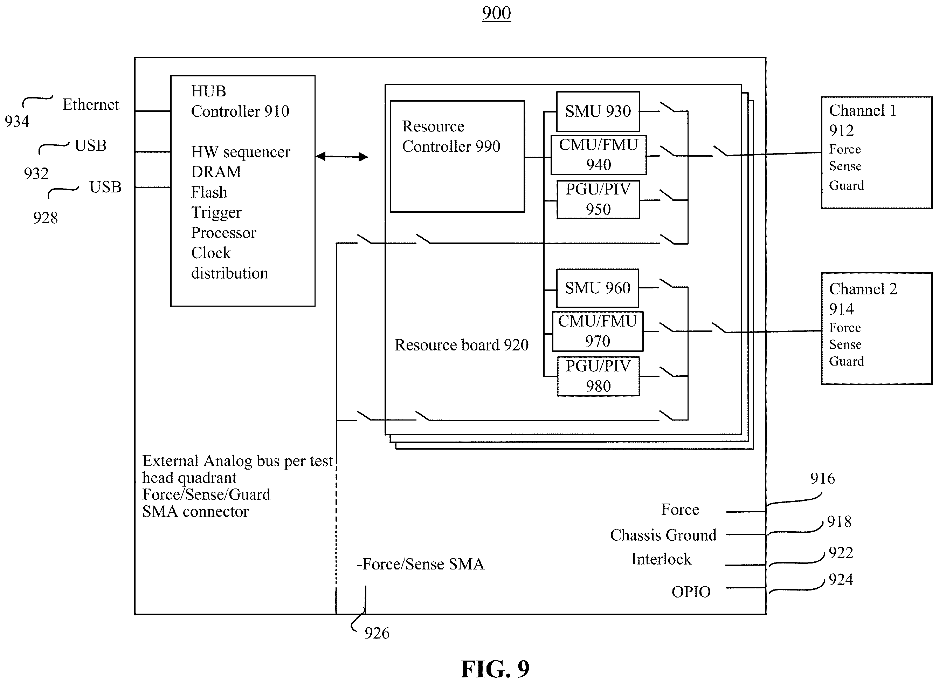

FIG. 9 illustrates a hub controller 900 of multi-channel parallel device testing system 100 according to an embodiment of the present disclosure.

HUB controller 910 may communicate with a host computer via Ethernet and Universal Serial Bus (USB) interfaces, and provides system-level triggering and clock distribution to synchronize downstream measurement modules. The system further may include an external analog bus and Force/Sense/Guard SMA connectors for precision electrical connections to a DUT.

HUB controller 910 may include, but is not limited to, a hardware sequencer, Dynamic Random-Access Memory (DRAM) for temporary data storage, flash memory for firmware and test programs, a trigger processor for generating or receiving trigger signals and dispatching them to resource boards 920, and a clock distribution network to provide synchronized clocks to each board. HUB controller 910 communicates bidirectionally with each resource controller 990, as shown by the double arrow in FIG. 9.

Each resource board 920 may include a resource controller 990 equipped with a hardware sequencer, DRAM, and flash for managing local timing and parameter configurations. Resource board 920 is further provided with multiple measurement and excitation modules, such as SMUs 930, 960 that can supply precise voltage or current and perform corresponding measurements while supporting Kelvin four-wire connections to minimize lead resistance. Resource board 920 also may include CMU/FMU 940, 970 for impedance, capacitance, or frequency-related measurements, and pulse generator units/parametric I-V units (PGU/PIV) 950, 980 for generating pulsed signals and performing parametric current-voltage measurements.

HUB controller 910 also may include status and monitoring outputs including lines 916, 918, 922, and 924. Line 916 ("Force") can carry the force command or the force bias to the force pins of the channels (e.g., to control source currents or voltages). Line 918 ("Chassis Ground") can provide reference ground potential tied to the chassis enclosure of the test head to ensure proper grounding and safety. Line 922 ("Interlock OK") can be set as a safety/status signal indicating that interlocks (mechanical or electrical) are in a proper state before enabling high-voltage or high-current operations. Line 924 ("OPIO") may be used for optional parallel I/O or operational I/O line used for auxiliary signaling, control or multiplexed signals to/from external instrumentation or calibration devices.

The external analog bus per test-head quadrant is accessed via SMA (SubMiniature version A) connectors, such as connector 926, which carry multiple lines per channel including Force, Sense, and Guard. These force/sense/guard SMA connectors can be configured with precision coaxial interfaces intended to maintain low parasitic and low noise paths. Guard lines help shield sense or ground lines from leakage or noise by surrounding force or sense conductors with driven or guarded potentials.

Resource board 920 is shown with multiple channel-specific modules: for example, SMU 930, 960 units that act as source measure units to both inject stimulus (voltage or current) and measure response, CMU/FMU modules 940, 970 for capacitance or frequency measurements or front-end filtering / frequency measurement, and PGU/PIV units 950, 980 that are pulse generator units or parametric I-V units, used for pulsed stimulus (such as for memory cell programming) or performing dynamic I-V sweeps. Channels such as Channel 1 (912) and Channel 2 (914) each include force, sense, and guard connections configured via the modules on the board.

Resource controller 990 can coordinate among the modules on resource board 920, managing local sequencing, configuration settings (e.g., compliance, range, measurement mode), and local timing. It may act on instructions from HUB controller 910 to gate stimuli, route measurement data, and regulate modules (SMU, CMU/FMU, PGU/PIV). The resource controller may also provide feedback via line 922 to ensure each module is safely connected and operational before stimulus is applied.

Test-head housing defines physical partitioning between HUB controller 910, resource board 920, and the external connectors. Housing may include mounting for SMU, CMU/FMU and PGU/PIV modules, cabling harnesses from these modules to the external analog bus, and mechanical support for channels (912, 914). The entire assembly is arranged so that force/sense/guard paths are tightly controlled, shields or grounds are maintained, and signal integrity (low leakage, low capacitance parasitics) is preserved.

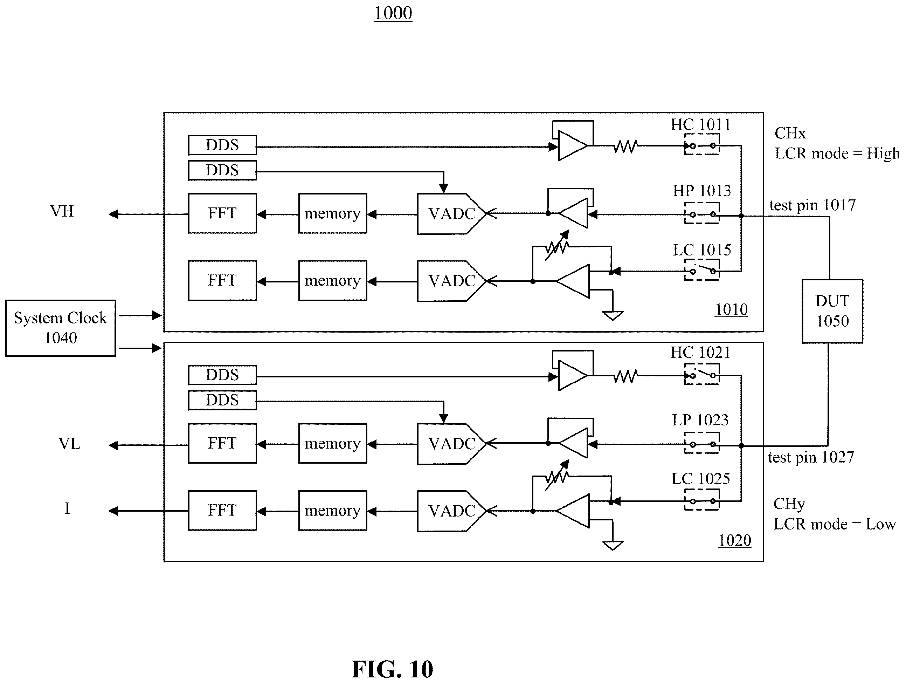

FIG. 10 illustrates a schematic circuit 1000 of test channels 1010, 1020 in multi-channel parallel device testing system 100 according to an embodiment of the present disclosure. In some embodiments, circuit 1000 may implement one or more of the elements in resource board 920. For example, circuit 1000 may implement one or more of the SMU, CMU, FMU, and/or PGU.

Multi-channel parallel device testing system 100 may include a plurality of test channels 1010, 1020. Each of test channels 1010, 1020 may include a high current (HC) switch, a low current (LC) switch, a potential node, a channel clock (e.g., a per-test channel clock), and a system clock. As shown in FIG. 10, test channel 1010 may include HC switch 1011, potential node 1013, and LC switch 1015, and test channel 1020 may include HC switch 1021, potential node 1023, and LC switch 1025. Each of the channel clocks may be configured with a phase offset. The phase offset compensates a phase shift associated with each of the test channels 1010, 1020 during calibration.

Potential node 1013 may be configured for high potential (HP) testing when HC switch 1011 is closed, and may be configured for low potential (LP) testing when LC switch 1021 is closed. In other words, test channel 1010, 1020 of the present disclosure may have only one potential node which happens to be high potential when HC switch 1011 is closed and LC switch 1015 is opened, and happens to be low potential when HC switch 1011 is opened and LC switch 1015 is closed. Therefore, each test channel 1010, 1020 may be a high channel or a low channel. Further, HC switch 1011 and LC switch 1015 can be configured as alternately operable, such that when one is in a closed state the other is maintained in an open state.

In multi-channel parallel device testing system 100, test channels can operate under the same clock to ensure proper synchronization. When a common clock is distributed to each test channel 1010, 1020, the measurement data across test channels 1010, 1020 may share a uniform time reference that allows the results to be aligned and compared accurately. For example, impedance or capacitance measurements rely on precise phase relationships between voltage and current signals. If test channels 1010, 1020 do not share the same clock, phase offsets will occur, which may directly introduce errors into the computed impedance, capacitance, or inductance values.

If different test channels 1010, 1020 operate on different clocks, several problems may arise. First, the measurement data from each test channel 1010, 1020 may not correspond to the same instant in time, and may make the results incomparable across channels. Second, algorithms that require simultaneous multi-channel data. For example, pin-to-pin impedance calculations or multi-source excitations may fail because the inputs are misaligned. Third, the presence of multiple unsynchronized clocks may generate jitter, beat frequencies, or noise coupling between channels, thereby degrading resolution and repeatability.

Accordingly, the present disclosure employs a centralized clock distribution system such that test channels 1010, 1020 share the same reference clock which ensures phase coherence, synchronized triggering, and reliable high-accuracy parallel measurements.

In some embodiments, each test channel 1010, 1020 may have a channel clock. The channel clock in test channels 1010, 1020 has a frequency and a phase. However, in order to measure multiple DUTs 1030 in multi-channel parallel device testing system 100, the channel clocks needs to be the same. Therefore, system clock 1040 may be coupled to test channels 1010, 1020, and may distribute system clock to test channels 1010, 1020 for synchronizing the clock channels. As a result, the channel clock in each of test channels 1010, 1020 can have a frequency and a phase synchronized to system clock.

In some embodiments, each of test channels 1010, 1020 may further include a force line and a sense line. The force line may be connected to potential node 1013, 1023 via HC switch 1011 or LC switch 1025. The force line may provide a signal to DUT 1050. The sense line may be connected to potential node 1013, 1023. The sense line may detect a voltage at the DUT.

Test channels 1010 and 1020 can each be arranged with multiple DDS blocks and FFT + memory + Voltage/Analog-to-Digital Converter (VADC) front ends. In channel 1010, two DDS blocks feed into circuitry that drives the high current (HC) path when HC switch 1011 is closed; similarly, in channel 1020, the DDS blocks feed into its HC path via HC switch 1021. However, this is only a potential implementation and other implementations are possible. Further, the DDS blocks can generate periodic test waveforms under control of the system or channel clock, which may be fed into either the high-voltage amplifier path (HP) 1013 / 1023 or through HC / LC as configured. FFT + memory units in each channel serve to capture time-domain or frequency-domain data: signals from VADC blocks are stored in memory, and processed via FFT engines to extract spectral content or phase information.

The VADC blocks in test channels 1010, 1020 can convert analog signals (coming from the potential node 1013 / 1023 or from sense lines) to digital form. The outputs of the VADC are routed both to memory for buffering, and to the FFT engines for analysis. The outputs of the DDS blocks are also routed toward the amplifiers that feed the test pin 1017 / 1027 through the HC, HP, or LC switches. The signal path may include amplifiers or gain stages (shown between DDS and HC / HP / LC switches) to set appropriate level for force or measurement. Resistive elements (e.g. shown as small variable resistor in test channel 1010 in the HP or LC path) may be used to limit or adjust current or to implement compliance control.

Switches for HC 1011 / 1021, HP 1013 / 1023, and LC 1015 / 1025 can allow selection among different modes: when HC switch is closed and LC switch is open, the potential node (1013 / 1023) is in a high potential mode; when LC is closed and HC open, low potential mode; HP switch may represent high precision or high potential mode with different gain or compliance characteristics. These switches allow a single potential node per channel to be flexibly reconfigured between high and low potential testing modes. Test pins 1017 (for channel 1010) and 1027 (for channel 1020) are the actual electrical nodes that contact the DUT 1050, carrying force, sense and guard connections (guard possibly optionally grounded or driven) depending on measurement requirements.

System clock 1040 can be configured to drive timing in the two test channels 1010, 1020. Each channel has its own channel clock derived from system clock 1040, with configurable phase offset for calibration. The synchronization ensures that when measurements are made across both channels (for example, simultaneous impedance, capacitance, or dual-channel stimulus), data align in time and phase. Without a common reference (system clock), measurements involving phase (like impedance or reactive components) would become uncertain.

DUT 1050 can be connected to both test pins 1017 (of channel 1010) and 1027 (of channel 1020) for force / sense / guard paths. The sense line from DUT 1050 may return voltage to the sense inputs of the respective channels (via sense path through switches and VADC), and the guard line may surround or shield force/sense to reduce leakage or noise. Force line drives stimulus (voltage or current) via the switches and amplifiers. The LC / HP / HC paths carry different current or voltage ranges: LC for very low current / low potential measurements (e.g. leakage), HP for higher precision or high potential mode, HC for high current mode when needed.

As shown in FIG. 10, a system may include a plurality of test channels (e.g., 1010, 1020). The test channels 1010, 1020 may include a high current (HC) switch 1011, 1021, a low current (LC) switch 1015, 1025, and a potential node 1013, 1023 coupled to corresponding test pins 1017, 1027. Each test channel 1010, 1020 may also be associated with a channel clock that derives timing from system clock 1040. Potential node 1013 may be configured for high potential (HP) testing when HC switch 1011 is closed, and potential node 1023 may be configured for low potential (LP) testing when LC switch 1025 is closed. System clock 1040 distributes a common time reference so that channel clocks of test channels 1010, 1020 are synchronized in frequency and phase.

In some embodiments, each test channel 1010, 1020 may further include a force line and a sense line. For example, the force line may be coupled to potential node 1013 through HC switch 1011 or LC switch 1015, and may deliver a signal from test channel 1010 to DUT 1050. The sense line may be connected directly to potential node 1013 and may detect a voltage developed at DUT 1050. Similarly, test channel 1020 may route its force line through HC switch 1021 or LC switch 1025, while its sense line monitors DUT 1050 via potential node 1023.

In one embodiment, the plurality of test channels 1010, 1020 may be part of a larger array of channels in system 100. A first, second, and third test channel may be configured with potential nodes 1013 set to a first dynamic potential by coordinating their respective HC and LC switch states, while a fourth test channel may be configured with potential node 1023 set to a different dynamic potential. Using this arrangement, multi-channel parallel device testing system 100 may perform capacitance-voltage analysis by sweeping the first dynamic potential across multiple channels and comparing capacitance as a function of the second dynamic potential provided by another channel.

As illustrated in FIG. 10, each of test channels 1010, 1020 may include direct digital synthesizer (DDS) circuits. The DDS blocks may generate periodic test signals whose frequency and phase are synchronized to system clock 1040. For example, DDS outputs in test channel 1010 may be routed toward amplifiers and then applied through HC switch 1011 or LC switch 1015 to potential node 1013. Similarly, test channel 1020 may apply its DDS output to potential node 1023 through HC switch 1021 or LC switch 1025. By synchronizing all DDS circuits to system clock 1040, test channels 1010, 1020 may measure DUT 1050 simultaneously with timing coherence derived from system clock 1040.

Each of test channels 1010, 1020 may further include memory, first and second Voltage/Analog-to-Digital Converters (VADC), and first and second DDS circuits. As shown in FIG. 10, outputs from potential nodes 1013, 1023 may be digitized by corresponding VADC blocks, whose outputs are stored in memory. The first DDS may drive potential node 1013 or 1023, while a second DDS may be coupled to one or more of the VADC circuits to provide sampling or reference signals. In this way, each channel 1010, 1020 may include both generation and measurement resources.

Moreover, each channel clock of test channels 1010, 1020 may include a programmable phase offset. During calibration, a processor may measure the relative phase shift introduced by each of test channels 1010, 1020 when driven by system clock 1040 and may store an offset value in the corresponding channel clock. The stored phase offset compensates mismatches so that channels 1010, 1020 maintain phase coherence when performing parallel testing of DUT 1050.

In some embodiments, each of test channels 1010, 1020 may also include Fast Fourier Transform (FFT) engines connected to the VADC outputs and memory. For example, FFT blocks may process digitized data from potential node 1013 in channel 1010 or potential node 1023 in channel 1020. The FFT circuits may transform the time-domain VADC output into frequency-domain results, enabling precise measurement of amplitude and phase characteristics at DUT 1050.

At least one of the DDS circuits in each of test channels 1010, 1020 may be configured to generate a test signal for DUT 1050. For example, DDS blocks in test channel 1010 may produce a sinusoidal excitation signal that is driven through HC switch 1011 into potential node 1013, while DDS blocks in test channel 1020 may provide either a synchronous reference signal or an independent excitation waveform for DUT 1050.

Multi-channel parallel device testing system 100 may include eight or more test channels, such as channels 1010 and 1020. Each of the channels may be configurable with a phase and amplitude setting. By synchronizing amplitude and phase across all channels with system clock 1040, system 100 may perform high-density parallel measurements with phase coherence among at least eight channels applied to a DUT array.

In some embodiments, system 100 may include a processor coupled to system clock 1040. Each of test channels 1010, 1020 may include a DDS. The processor may cause system clock 1040 to deliver a calibration signal to test channels 1010, 1020. By comparing responses of DDS-generated signals with the calibration signal, the processor may measure a phase shift for each test channel and program correction values into phase shift registers of the DDS circuits.

In one example, each DDS circuit in test channels 1010, 1020 may implement a numerically controlled oscillator (NCO) driven by system clock 1040. A programmable phase offset may be applied to the NCO to compensate for measured channel-specific delays. As a result, DDS signals applied through HC switch 1011 or LC switch 1015 into potential node 1013 remain in-phase with those applied through HC switch 1021 or LC switch 1025 into potential node 1023. Accordingly, the DDS circuits of test channels 1010, 1020 may be configured to generate test signals that are phase-aligned with system clock 1040. The alignment ensures that measurements across channels 1010, 1020 remain synchronized, enabling simultaneous multi-channel measurement of DUT 1050.

As illustrated in FIG. 10, in some embodiments, each of test channels 1010, 1020 may include both a high potential (HP) circuit and a low potential (LP) circuit. For example, test channel 1010 may route signals through potential node 1013 and HC switch 1011 for HP mode, or through potential node 1013 and LC switch 1015 for LP mode. By reconfiguring HC and LC switches, the test channel can alternate between HP and LP operation depending on test requirements.

In some embodiments, system 100 may include a processor coupled to test channels 1010, 1020. The processor may multiplex a reference signal into both HP and LP circuits by driving through system clock 1040. Synchronization with a trigger signal may align phase across channels 1010, 1020. The processor may then calibrate amplitude and phase of both HP and LP circuits, generate an internally produced second signal to route to the HP circuit, and calibrate based on comparing results between the first and second signals.

The first signal may be a sine wave provided by system clock 1040, and the second signal may be generated by a DDS within test channels 1010, 1020. The processor may measure a phase difference between HP and LP circuits, such as between a potential node in HP mode and potential node in LP mode, and calibrate the LP circuit accordingly.

In some embodiments, calibration results may be stored in memories of test channels 1010, 1020. Correction values may include amplitude gain or phase shift adjustments relative to the first calibration signal. Stored correction values may then be applied during runtime to ensure accurate measurement at DUT 1050.

Disclosed systems may also support a parallel testing mode. For example, processor and system clock 1040 may configure test channels 1010, 1020 and additional channels to operate as high channels, low channels, or measurement channels, depending on the state of HC and LC switches. Each channel may include a DDS that may generate test signals with unique frequency or phase. By synchronizing to system clock 1040, test channels may simultaneously measure multiple pins of DUT 1050.

In some embodiments, each test channel such as 1010, 1020 may include a local processor or controller configured to execute FFT operations on digitized data from its VADC. Channel outputs may be isolated in frequency space by assigning distinct frequency offsets to DDS waveforms, allowing FFT bins to isolate per-channel measurements even during simultaneous excitation of DUT 1050.

Each DDS in test channels 1010, 1020 may include a programmable phase shift register. The register may store a calibration offset unique to its corresponding channel. By applying the stored offset, DDS waveforms across channels are aligned in phase, ensuring synchronous measurement across DUT 1050.

In some embodiments, each test channel 1010, 1020 may include a channel processing circuit, HC switch (1011, 1021), LC switch (1015, 1025), at least one potential node, and DDS. Each channel may be configurable to act as a high channel, low channel, or measurement channel. DDS blocks may be configured to generate test signals at unique frequencies or phases, calibrated to system clock 1040. Channel processing circuits, which may include VADC, FFT, and memory, may perform operations such as converting analog to digital signals, transforming time-domain signals to frequency domain, or transmitting digital measurement data to a processor for analysis.

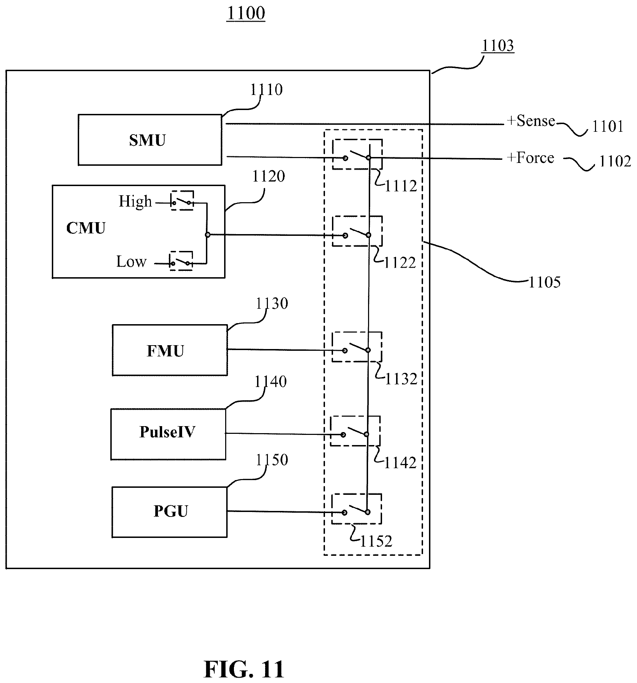

Reference is made to FIG. 11, which illustrates a block diagram for an adaptable testing channel 1100 according to an embodiment of the present disclosure. Channel 1100 interfaces to a device under test (DUT) through a +Sense conductor or line 1101 and a +Force conductor or line 1102 that terminate at a pin interface 1103. As shown in FIG. 11, in channel 1100 a mode switch 1105 couples a plurality of instrument paths to a potential node internal to the assembly. The potential node in turn drives the +Force conductor or line 1102 (and, in some embodiments, a companion sense sub-network in mode switch 1105 routes the associated sense lead to +Sense conductor or line 1101 to maintain a Kelvin connection to the DUT).

Channel 1100 may include multiple instrument blocks: a source measure unit (SMU) 1110, a capacitance measurement unit (CMU) 1120, a frequency measurement unit (FMU) 1130, a PulseIV unit 1140, and a pulse generator unit (PGU) 1150. In various embodiments, SMU 1110, CMU 1120, FMU 1130, and PGU 1150 can be collectively configured to provide a measuring resource. Moreover, PulseIV 1140 can be configured to provide a pulse resource. For example, the measuring resource can have a high-current (HC) switch and a low-current (LC) switch to select operating range and thereby establish high-potential (HP) or low-potential (LP) measurement modes at the potential node. In the example shown, CMU 1120 depicts selectable "High" and "Low" paths that can implement the HC and LC switching; in other embodiments, the HC/LC selection may be distributed across the SMU, FMU, PGU, or a shared front-end of the measuring resource.

Mode switch 1105 can be implemented as a multi-component selection network rather than a single device. As illustrated, mode switch 1105 can include independently controllable sub-switches 1112, 1122, 1132, 1142, and 1152 disposed, respectively, in the SMU, CMU, FMU, PulseIV, and PGU paths. The sub-switches can be relays, solid-state analog switches, a cross-point fabric, or combinations thereof, and may be ganged or interlocked to enforce mutually exclusive selections. The sub-switch outputs converge at the potential node of mode switch 1105. In some embodiments, mode switch 1105 further may include break-before-make timing, bleed/clamp elements, or charge-management networks to minimize transients during instrument handoffs.

In some implementations, when mode switch 1105 connects PulseIV 1140 (the pulse resource) to the potential node, the potential node is configured for pulse testing the DUT via +Force line 1102 while +Sense line 1101 monitors the pin potential. When mode switch 1105 connects the measuring resource to the potential node with the HC switch closed, the potential node is configured for HP testing; when the LC switch is closed, the potential node is configured for LP testing. Thus, the mode switch determines whether the channel performs pulse generation or measurement, and the HC/LC selection within the measuring resource determines the potential range of that measurement.

Channel 1100 can represent one of a plurality of test channels that are coupled to a system clock. The system clock provides timing used to synchronize pulse testing (delivery and measurement) events across channels. A controller or processor can assert timing and configuration strobes to the sub-switches of mode switch 1105 and to the HC/LC selection of the measuring resource to implement disclosed operations, including rapid, deterministic reconfiguration between pulse measurement, HP measurement, and LP measurement at the potential node while preserving Kelvin sensing and isolation of inactive resources.

In some embodiments, SMU 1110, CMU 1120, FMU 1130, and PGU 1150 collectively form a measuring resource selectable to the DUT, and PulseIV 1140 provides a pulse resource that delivers pulsed excitation to the DUT. By way of example, an SMU can force and measure voltage and/or current for DC/parametric tests, a CMU can stimulate a DUT with an AC bias to resolve capacitance/impedance for C-V characterization, and an FMU can acquire frequency-domain quantities referenced to a timing standard; a PGU can provide precisely timed stimulus that the measuring resource uses in time- or frequency-domain measurements.

In some implementations, mode switch 1105 operates as a multi-component selection network rather than a single device. As depicted, mode switch 1105 can include a set of independently controllable sub-switches-e.g., sub-switch 1112 in line with the SMU path, sub-switch 1122 in line with the CMU path, sub-switch 1132 in line with the FMU path, sub-switch 1142 in line with the PulseIV path, and sub-switch 1152 in line with the PGU path. The outputs of the sub-switches converge to a potential node at the interior of mode switch 1105 that feeds the +Force conductor 1102; in some embodiments, a companion sense-side sub-network within mode switch 1105 also routes the selected instrument's sense lead to +Sense line 1101 to maintain connections during measurement.

As shown in FIG. 11, CMU 1120 can internally present "High" and "Low" paths (shown schematically) corresponding to high-range and low-range operating conditions; these paths may embody the high-current (HC) and low-current (LC) switching described elsewhere, enabling the system to configure the potential node for high-potential (HP) or low-potential (LP) testing when the mode switch 1105 connects the measuring resource to the node. When mode switch 1105 connects PulseIV 1140 to the potential node, the channel delivers pulsed waveforms suitable for minimizing self-heating or capturing transient device behavior; examples of pulsed-IV techniques and pulse-generator modules usable in such embodiments are well known in semiconductor parametric testing.

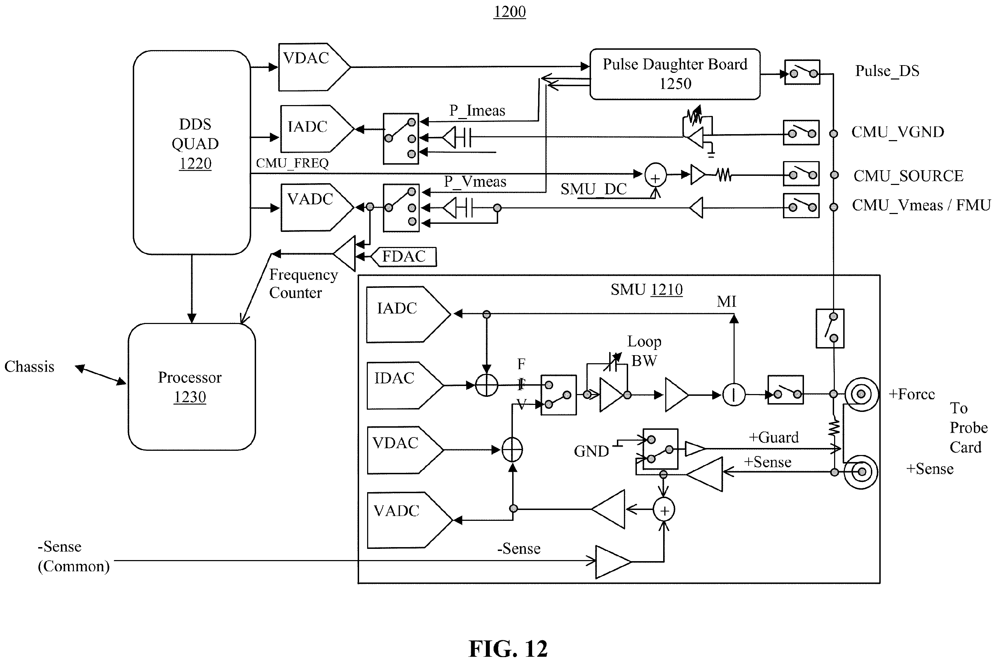

FIG. 12 illustrates a block diagram of a resource card 1200 according to an embodiment of the present disclosure. Stimulus and measurement functions may be implemented by DDS 1220, processor 1230, SMU 1210, and pulse daughter board 1250. DDS 1220 can be implemented as a quad-channel direct digital synthesizer. DDS 1220 may drive three high-speed front ends, e.g., multiple VDAC, IADC, and DDS units. One DDS path may be coupled for frequency counter and DAC for fine frequency or phase trim.

As shown, DDS outputs may pass through nodes "P_Imeas" and "P_Vmeas", each of which may be gated with different switching elements and routed on CMU lines. In some embodiments, CMU voltage path may be summed with SMU lines by a summing amplifier, and bidirectional links may connect to pulse daughter board 1250. Pulse daughter board 1250 may present four front-panel connections, which may route the pulse drive, the CMU virtual ground, the CMU source drive, and the CMU voltage or FMU measurement to the right-hand I/O block identified as to probe card. Resource card 1200 may communicate with the chassis backplane and a-Sense common may provide the shared return reference at the bottom of FIG. 12.

A measurement path may be realized by SMU 1210. SMU 1210 may include IADC for high-resolution current capture, IDAC as a precision current source, and a VDAC as a precision voltage source, and VADC for voltage measurement. A mode selector may switch between force current and force voltage, and a compensation loop may close around the output stage while measurement branch may sense current.

Front-end connections may include +Force and +Sense to the probe card, a driven +Guard referenced to GND to minimize leakage, and a return -Sense path with a large span (e.g., 100 V to 0.5 V). Processor 1230 may configure VDAC, IADC, VADC, FDAC, CMU, SMU units and pulse daughter board 1250, and may collect digitized data from SMU 1210 for transfer across chassis card cage.

As illustrated in FIG. 12, in some embodiments resource card 1200 Pulse Daughter Board 1250 can expose discrete front-panel connections allowing parts of the stimulus / measurement chain to be isolated or used separately. This allows external measurement paths or calibration modules to be appended without disturbing core SMU circuits.

In FIG. 12, the inclusion of separate measurement gating nodes (P_Imeas / P_Vmeas) and programmable gain amplifiers in the CMU / AWG (Arbitrary Waveform Generator) paths can improve control over which path is active and how it is conditioned.

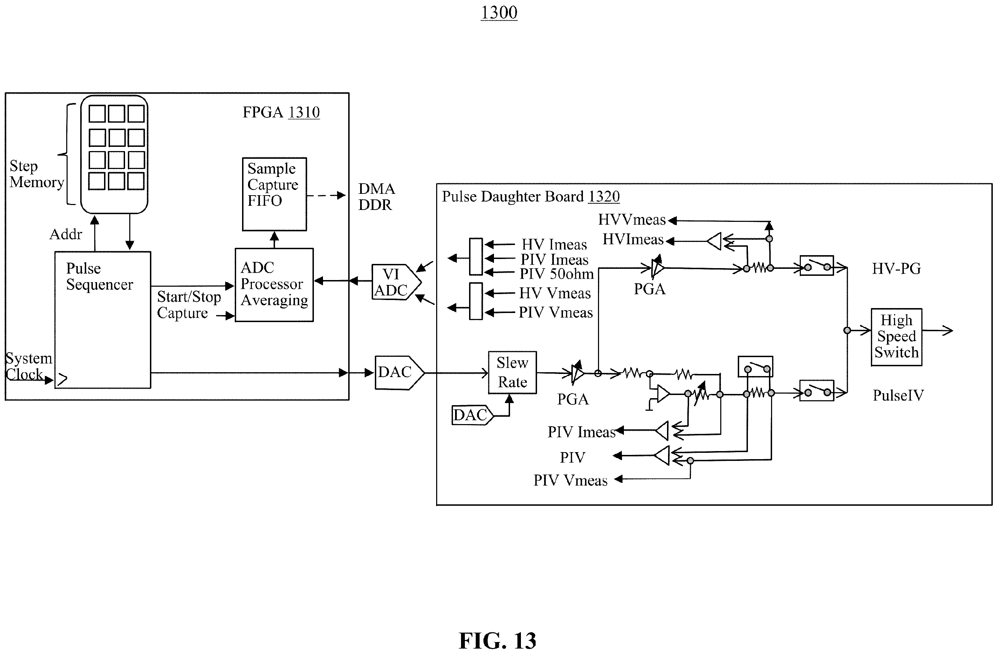

FIG. 13 illustrates a schematic circuit of pulse daughter board system 1300 according to an embodiment of the present disclosure. In some implementation, pulse daughter board system 1300 can be configured for a per-test channel pulse resource and as a pulse analyzer. Control and data-plane functions may be partitioned between FPGA 1310 and pulse daughter board 1320. Inside FPGA 1310, a memory may store opcode sequences addressed by Pulse Sequencer using Opcode List under a system clock. Sequence events may assert Start/Stop Capture toward an ADC, whose results may be queued in a Sample Capture FIFO and transferred to a DDR. Analog observables from the daughter board may be digitized by an ADC, while control waveforms or biases may be produced by DAC and forwarded to the daughter board.

On pulse daughter board 1320, the DAC waveform may first pass a Slew Rate limiter before entering the source path. The high-voltage branch may include a Programmable Gain Amplifier (PGA) and selectable output ranges. Current-range selection may steer the drive into a pulse-IV path where monitored nodes PIV Imeas, PIV, and PIV Vmeas may be buffered for measurement. High-voltage feedback nodes HV Imeas and HV Vmeas may return to an ADC in FPGA 1310 for closed-loop observation and averaging. The output side may provide two logically distinct drives. Collectively, FPGA 1310 and pulse daughter board 1320 may generate programmable pulses with controlled slew, selectable voltage ranges, selectable current ranges, and real-time capture of voltage and current measurements at both high-voltage and pulse-IV nodes. Further, pulse daughter board 1320 may include a high-speed switch positioned at the output stage to steer the drive path between a high-voltage pulse-generation (HV-PG) branch and a pulse-IV (PIV) branch. The high-speed switch may be implemented using a solid-state device such as a GaN or MOSFET-based driver network capable of fast transition times. When commanded by control strobes from FPGA 1310, the switch rapidly connects or isolates the selected branch, enabling transition between voltage-driven and current-driven operation without external relays. In the HV-PG path, the high-speed switch applies the conditioned high-voltage waveform produced by the PGA to the DUT pin, while in the PIV path, it routes the output through the precision current-sense and voltage-measurement network for low-level pulsed characterization. This configuration minimizes parasitic capacitance, preserves waveform fidelity during fast edge transitions, and allows precisely timed pulses to be delivered or measured with minimal distortion. As a result, pulse daughter board 1320 can produce tightly shaped pulses synchronized to the FPGA's sequencer timing, achieving both high-voltage accuracy and high-speed pulse control within the same hardware platform.

In some embodiments, control-plane functions are executed by FPGA 1310 and analog stimulus/measurement functions are executed by a pulse daughter board 1320. In such embodiments, within FPGA 1310, a Step Memory may store the opcode sequences. An Addr line can provide addressing into Step Memory, and a Pulse Sequencer may read the opcodes and issues control strobes under a System Clock. In such embodiments, the sequencer may assert a Start/Stop Capture signal to an ADC Processor/Averaging block that performs per-pulse accumulation or averaging. Averaged samples are written into a Sample Capture FIFO (e.g., at 128K), and a DMA-to-DDR path streams the FIFO contents to system memory for host retrieval.

FPGA 1310 may further include a VI ADC (voltage/current acquisition ADC) and a DAC. The VI ADC can digitize analog observables returned from the daughter board 1320 (described below) and provides those samples to the ADC Processor/Averaging block. The DAC produces an analog control/bias waveform that exits FPGA 1310 and enters pulse daughter board 1320 as the drive/control input to the stimulus chain.

Further, as previously discussed, in some embodiments on pulse daughter board 1320, the DAC drive from FPGA 1310 can be configured to first pass through a Slew Rate limiter, thereby shaping transitions before they enter the analog front end. Further, in the high-voltage branch, the drive may be applied to a PGA (programmable-gain amplifier) whose gain is digitally set to match the required output range. PGAs are commonly used to extend dynamic range and maintain signal-to-noise performance in instrumentation front ends.

Moreover, in some embodiments a board system 1300 may provide three buffered, separately routable measurement nodes: PIV Imeas (pulse-IV current measurement), PIV ohm (a measurement across a defined sense path), and PIV Vmeas (pulse-IV voltage measurement). Further, a second PGA can be configured to condition this branch so the same VI ADC in FPGA 1310 can accurately digitize the PIV observables across a wide dynamic range. Multiplexer symbols at each measurement cluster denote that any of the listed nodes may be selected onto the VI-ADC return line under Pulse Sequencer control. Solid-state analog switches/multiplexers are a standard way to route such analog measurement paths.

In some embodiments, FPGA 1310 may include a high-speed pulse sequencer that executes an opcode/operand program to control waveform synthesis. The sequencer, operating from Step Memory under the System Clock, can decode opcodes with associated operands. By writing operand-defined data values to the DAC at deterministic update intervals, the sequencer generates complex, repeating waveforms such as stepped ladders, ramps, bursts, multi-level pedestal-plus-pulse patterns, or arbitrary sequences. The opcode flow can target the HV-PG or PulseIV path selection lines, enabling coordinated switching and waveform shaping without firmware latency. The opcode stream can also schedule data acquisition. Capture-related opcodes assert Start/Stop gating, define sampling windows, and specify the number of samples M to take directly from the VI ADC during a given waveform interval (e.g., pulse flat-top).

Moreover, an on-FPGA averaging engine accumulates the M samples to compute a mean (and optionally variance or baseline subtraction), producing a decimated, low-noise measurement aligned to the programmed waveform timing. The averaged result is written to the Sample Capture FIFO for DMA transfer, while optional modes permit raw sample streaming. Performing timing, sampling, and averaging entirely within the FPGA reduces host bandwidth, improves SNR, and preserves phase-coherent alignment between stimulus and measurement.

In some embodiments, pulse daughter board 1320 may be configured as a pulse resource and may include a first branch (e.g., the top branch in FIG. 13), a second branch (e.g., the bottom branch in FIG. 13), and a high-speed output switch coupled to both branches (e.g., the High Speed Switch in FIG. 13). A common drive input to the pulse resource may be provided by the DAC path from FPGA 1310 after transition shaping by the Slew Rate limiter. The first branch may implement a voltage-oriented pulse generation path (HV-PG) and may include a pulse generator configured to synthesize a time-varying waveform from the DAC input, a programmable-gain amplifier (PGA) that scales the waveform to selectable output ranges, and a first branch switch positioned electrically downstream of the PGA. The pulse generator may include a driver stage and associated conditioning network arranged to provide fast edge transitions with controlled slew as dictated by opcode-scheduled DAC updates, and the PGA may be digitally set to maintain signal-to-noise performance over multiple high-voltage spans. The first branch switch may be realized as a solid-state analog gating element (e.g., a back-to-back MOSFET or GaN device) operative, under Pulse Sequencer control, to isolate the HV-PG path during off-intervals, to pre-charge or hold a defined output potential, and to mitigate charge injection into the downstream load. The high-speed output switch, which may be implemented using a low-parasitic, fast-transition device, may be coupled to an output node of the first branch and arranged to selectively connect that node to a device-under-test (DUT) pin or to isolate it, thereby steering the conditioned high-voltage pulse toward the DUT with minimal parasitic capacitance and preserved waveform fidelity.

The second branch may implement a pulse-IV characterization path and may include circuitry for pulse current and voltage measurements together with a second branch switch operative to gate the measurement path. The measurement circuitry may include a precision current-sense element and transimpedance/buffer stages to generate a pulse current measurement signal (PIV Imeas), along with Kelvin-referenced voltage taps arranged to provide a pulse voltage measurement signal (PIV Vmeas) and, in some implementations, a defined-resistance observation leg (e.g., a PIV ohmic path) for calibration or range extension.

One or more conditioning amplifiers, which may include a PGA dedicated to the PulseIV path, may scale the sensed signals so that the VI ADC on FPGA 1310 can accurately digitize across wide dynamic ranges. Multiplexer elements may be provided so that any selected measurement node (e.g., PIV Imeas, PIV Vmeas, or an ohmic reference) is routed back to the VI-ADC return under sequencer control for synchronous averaging. The second branch switch may be disposed between the stimulus node and the PIV network to define sampling windows with sub-microsecond precision, to protect the measurement amplifiers during high-energy events, and to reduce settling time by decoupling stray capacitances outside of active intervals. During operation, the Pulse Sequencer may coordinate the first branch switch, the second branch switch, and the high-speed output switch so that the pulse resource alternates, in a time-deterministic manner, between a voltage-drive mode that delivers a shaped HV-PG waveform to the DUT and a pulse-IV mode that routes the stimulus through the current-sense and voltage-sense network for acquisition, enabling high-accuracy delivery and capture within a single hardware platform.

In some embodiments, the pulse resource comprises a digital-to-analog converter (e.g., the DAC driven by FPGA 1310) that fans out to a plurality of programmable-gain amplifiers on pulse daughter board 1320, where the PGA outputs are selectable by a high-speed switch positioned at the output stage. Additionally, or alternatively, the pulse resource may include an analog-to-digital converter for voltage/current (VI ADC) coupled to measurement buffers. For example, the DAC output may concurrently drive a first PGA in the high-voltage pulse-generation (HV-PG) branch and a second PGA in the PulseIV branch, with the high-speed switch steering the selected PGA output toward the DUT pin to realize output ranges. The VI ADC may be coupled to a buffer network that includes, by way of example, (a) unity-gain voltage followers that isolate Kelvin-tapped voltage nodes (HV Vmeas, PIV Vmeas) from ADC sampling kickback; (b) a transimpedance-amplifier (TIA) current buffer that converts sensed current to voltage for the PIV Imeas path and supports selectable feedback elements for range scaling; and (c) instrumentation-amplifier or differential buffers that receive divider-conditioned high-voltage feedback for the HV Imeas path. In one configuration, the HV measurement options can use a resistor-divider with an HV-tolerant buffer into the VI ADC to report HV Vmeas, while a current-sense element with a TIA provides HV Imeas. In another configuration, the PulseIV options selectable by on-board multiplexers include PIV Imeas (through the TIA buffer for low-level pulsed current), PIV Vmeas and an optional PIV 50-ohm leg for calibrated, high-bandwidth measurements. These buffered measurement paths present a low source impedance to the VI ADC, reduce settling time during windowed sampling, and permit the controller to select among HV, PIV, and Imeas observables while the high-speed switch concurrently selects the desired PGA-conditioned drive, thereby supporting the claimed architecture.

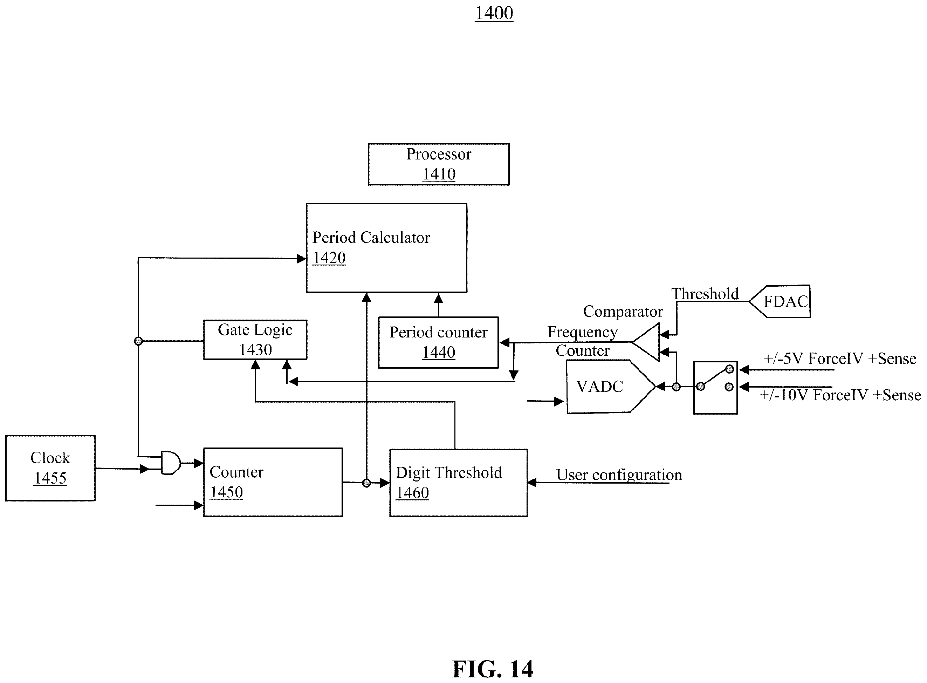

FIG. 14 illustrates a block diagram of a FMU reciprocal mode 1400 according to an embodiment of the present disclosure. Frequency and period measurement may be supervised by microprocessor 1410, which may compute frequency from timing data delivered by downstream counters. Edge timing from a device under test may be acquired by VADC through a range selector that may switch between "ForceIV +Sense" and "ForceIV +Sense". The digitized stream may be applied to a frequency counter and to a comparator whose reference may be set by FDAC to establish an adjustable detection threshold.

Comparator edges may drive period counter 1440 while also feeding gate logic 1430. A counter 1450 may provide the time base, and digit threshold 1460 may accept a user-specified resolution so that counting may continue for a known number of DUT periods. Gate logic 1430 may enforce actions such as stop next DUT edge after digit threshold," thereby closing the measurement window after the user-defined period and asserting capture.

Period calculator 1420 may then determine the known elapsed time for DUT periods using a counter value, and microprocessor 1410 may compute the corresponding frequency. The arrangement may support input frequencies while allowing threshold control and input ranging (e.g., via the +/-5 V and/or +/-10 V selections). Other selections, however, are also possible and within the scope of the disclosed embodiments.

As shown in FIG. 14, in some embodiments DUT signals can be range-selected (e.g., "±5 V ForceIV +Sense" or "±10 V ForceIV +Sense") and routed in parallel to VADC and a comparator whose trip point is set by FDAC. The comparator can be configured to produce clean timing edges for counting; in some implementations a small hysteresis window can be used to suppress noise-induced chatter and improve edge-time repeatability.

Edges from comparators or counters can be used to drive Period Counter 1440 and Gate Logic 1430. Counter 1450 can supply the time base, while Digit Threshold 1460 may accept a user-chosen timing. Gate Logic 1430 can be configured to stops on the next DUT edge after the digit threshold, so the window spans exactly periods configured by the user.

The arrangement shown in FIG. 14 can have adjustable frequencies and inputs via FDAC, range selection at the front end, and time-base-limited resolution. The parallel VADC path can also archive waveform snapshots for diagnostics or adaptive thresholding, while overall accuracy benefits from a low-jitter time base and clocking (since sampling/clock jitter directly degrades high-speed measurement SNR and timing).

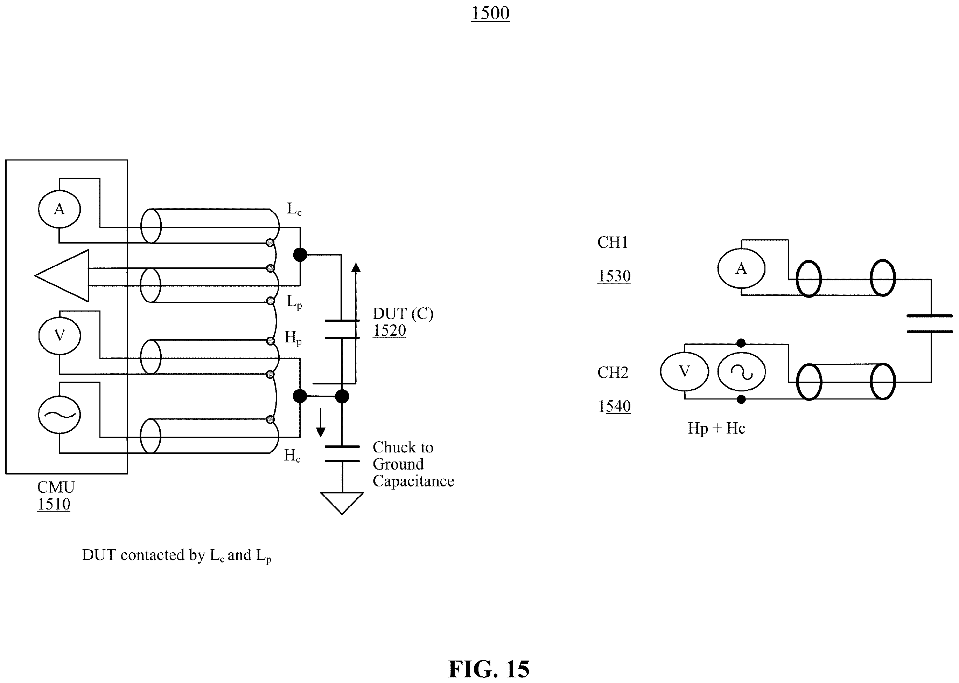

FIG. 15 illustrates a measurement paths 1500 of a CMU according to an embodiment of the present disclosure.

CMU 1510 may contact DUT 1520 with four terminals such "Lc", "Lp", "Hp", and "He." CMU 1510 may provide an AC excitation source, a voltmeter V, a current meter A, and a high-input-impedance amplifier so that stimulus may be applied on "Hp" with return on "Hc", while voltage may be sensed across "Lp" and "Lc" to realize a four-terminal measurement of DUT 1520.

In FIG. 15, CH1 may denote a test channel 1530 and CH2 may denote a test channel 1540. Test channel 1530 may be assigned as a low-side AC current-measurement channel, represented by A. Test channel 1540 may be assigned as a high-side source with voltage sense, depicted by V and the sine source, and "Hp + Hc" indicate the driven high node and its guarded return. The channels may connect to the same capacitor of DUT 1520, demonstrating that any channel in the multi-channel system may be configured as the source side or as the current-measurement side to emulate a classic CMU four-terminal method. Accordingly, the figure does correspond to the previously described multi-channel system and illustrates how one device under test may be measured without a single shared LCR meter while still preserving four-wire accuracy.

Further, as shown in FIG. 15, in the four-terminal pair topology on the left, CMU 1510 sources an AC stimulus between Hp (high-potential) and Hc (high-current/return), senses voltage between Lp (low-potential) and Lc (low-current), and measures current in the Hc/Lc path. This can be implemented for an auto-balancing bridge: the ammeter resides in the low current return, a high-impedance voltmeter senses Hp-Lp, and a guard/shield drives the fixture to minimize stray admittance. Correct assignment and cabling of Hc/Hp/Lp/Lc are standard practice for accurate CV/impedance work.

FIG. 15 also shows chuck-to-ground capacitance from the wafer chuck tied to Hc. In wafer probing parasitic can divert measurement current unless guarded or compensated; therefore, four-wire sensing and driven-guard practice are applied, and open/short (and, where applicable, load) compensation is performed at the fixture to remove residual cable/fixture errors.

Test channel 1530 and 1540 show how the disclosed system can be configured to emulate CMU measurement: CH2 is configured as the source + high-side voltage sense (symbol V with sine, "Hp + Hc/guard"), while CH1 is configured as the low-side current-measurement channel (symbol A). Both channels connect to the same DUT capacitor 1520 so that current is measured in the low return path while voltage is sensed across separate potential leads, preserving four-wire accuracy without a single shared LCR instrument. This arrangement implements the same four-terminal sensing principle used in precision impedance meters.

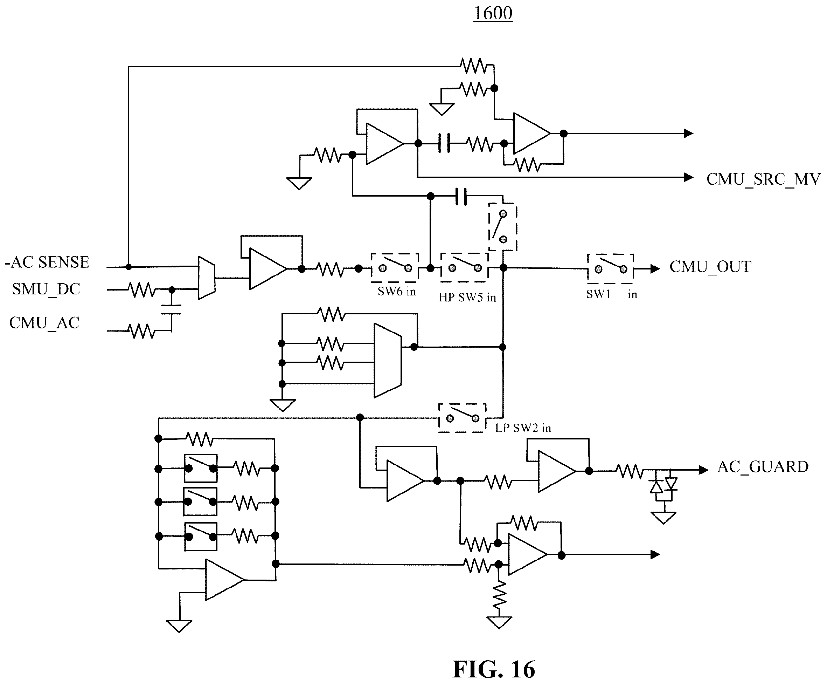

FIG. 16 illustrates a block diagram 1600 of CMU circuit configuration according to an embodiment of the present disclosure. A programmable routing and amplification network may establish the relationship among the measurement node, the source node, and the guard node for a multi-channel system. Inputs "AC_SENSE", "SMU_DC", and "CMU_AC" may enter a buffer chain. The path may include series element (e.g., 50 OHM) and selectable switches SW6, SW5, SW4, and SW1, which may be implemented as MEMS or photo relays. Selectable switches can be specific for different potentials. For example, while SW5 may be a high switch while SW2 may be a low switch. In one embodiment, SW5 (HP_SW5_in) resides in the high-potential branch while SW2 (LP_SW2_in) resides in the low-potential branch; SW6 inserts the series element (e.g., 50 Ω) for damping/protection and SW1 provides output isolation to CMU_OUT during reconfiguration. The controls are interlocked so the HP and LP branches cannot be closed at the same time, and a break-before-make sequence (with optional bleed/clamp) manages charge injection. When the LP branch is selected, an AC_GUARD driver follows the measurement node to suppress leakage and stray capacitance. HP-rated switches prioritize standoff and surge capacity, whereas LP switches use ultra-low-leakage devices to preserve femtoampere-level accuracy.

Further, a programmable resistor network and a shunt node may be tied to and may set ranges and bias. Similarly, the switch blocks may be implemented with MEMS and/or photo relays, including a combination. Through these selections the signal may be directed to output "CMU_OUT" for capacitance or other AC measurements.

In some embodiments, CMU may use a high-speed op amp configured as a buffer followed by a coupling network into a different op amp configured for high-speed amplification. And by switching SW4, SW5, and SW6 the system may change gain and range while coordinating with the left-side measurement shunt network to maintain accuracy.

Further CMU may use an op amp configured for buffering and a selectable resistor ladder to set effective gain and impedance. And cascaded op amp stages may supply drive strength and stability and may produce the guard output "AC_GUARD."

In combination, the operational amplifiers and switches may provide flexible mixing among "AC_SENSE", "SMU_DC", and "CMU_AC", and may expose the three key endpoints "CMU_OUT", "CMU_SRC_MV", and "AC_GUARD."

In some embodiments, inputs AC_SENSE, SMU_DC, and CMU_AC can be configured to enter a high-impedance buffer chain headed by a FET-input, wideband op amp to minimize loading of high-impedance nodes. Downstream, selectable switches SW6, SW5, SW4, and SW1 can establish which source or sense path is active and isolate inactive paths without contact bounce. Further, in such embodiments, a programmable shunt/bias network can be configured to dynamically set input range or DC bias during AC measurements.

In some embodiments, switch states SW4-SW6 can select gain/range combinations that are coordinated with the left-side shunt network so that the effective transconductance and voltage compliance remain within calibration across ranges. Op amps can be used to implement this function, supporting multi-MHz excitation with stable loop response under capacitive loads of DUTs and cabling.

In some embodiments, a low-noise wideband buffer can be configured to feed a selectable resistor ladder (e.g., 160 kΩ, 160 Ω, 1.6 kΩ, 16 kΩ) that sets effective gain/impedance for the guard amplifier pair. The output can be actively driven to track the potential of the adjacent high node, thereby reducing leakage and effective stray capacitance from cabling, probe cards, and wafer chucks to ground.

In some implementations, the circuit in FIG. 16 may be used to enable selection of the input (AC_SENSE, SMU_DC, or CMU_AC), asserting SW1-SW6 to configure range and path, biases the node with the 100 MΩ/100 kΩ network as required, drives CMU_SRC_MV with the programmed excitation, and sets the guard gain/filter so AC_GUARD tracks the source node. The measurement front end then acquires CMU_OUT while the monitor taps verify stimulus integrity.

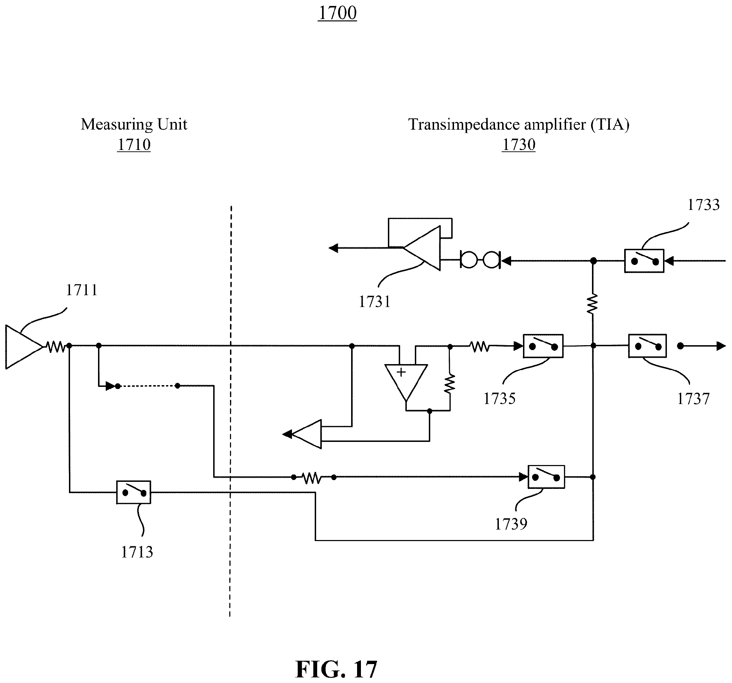

FIG. 17 illustrates a block diagram of circuit 1700 of measuring unit 1710 with TIA 1730 according to an embodiment of the present disclosure. Measuring unit 1710 may receive a signal from a device under test and may precondition or route that signal, as previously discussed in connection with FIGS. 10-16. Front-end buffer 1711 may present a high-impedance input, and selectable switch 1713 may shunt or bypass the input to establish a reference or protection path before the signal reaches transimpedance amplifier TIA 1730.

TIA 1730 may implement precision current-to-voltage conversion. An operational amplifier in 1730 may be configured with a feedback impedance to set the transimpedance gain, and the inverting node may form the summing junction tied to the output of measuring unit 1710. Guard or bootstrapped buffer 1731 may drive a surrounding shield or auxiliary node so that leakage and stray capacitance are reduced at the summing node. Range-select switch 1735 may insert or remove feedback elements to change the effective gain or bandwidth of the TIA. Output-enable switch 1737 may couple the conditioned voltage to a downstream bus or converter, while bypass switch 1739 may route the preconditioned input directly to the output path when voltage sensing rather than current sensing is desired.

In some embodiments, measuring unit 1710 can be configured to condition current or voltage from a DUT and presents it to the transimpedance stage. Front-end buffer 1711 may be set as a high-input-impedance amplifier used to minimize loading of picoamp-level sources; suitable devices include electrometer amplifiers with integrated guard drivers. The selectable path with switch 1713 provides input protection and mode setup-e.g., a low-leakage relay or PhotoMOS that can shunt the node to a reference during range changes, connect clamp elements, or short the input for zero/offset calibration before engaging the transimpedance path. Low-capacitance relays can be advantageous here.

In certain embodiments, transimpedance amplifier 1730 may convert input current to voltage using an op-amp with a feedback impedance (Rf // Cf) selected by range-select switch 1735. For example, switch 1735 may select among Rf values (e.g., from 1 kΩ to 1 GΩ) with parallel compensation capacitors. The inverting input of 1730 forms a summing junction tied to the output of measuring unit 1710; the noninverting input may be referenced to a quiet analog ground or a programmable bias for offsetting.

In some embodiments buffer 1731 can be configured as a guard/bootstrapped buffer to drive a surrounding shield (e.g., PCB guard ring or coax guard) at approximately the same potential as the summing node so that leakage and parasitic capacitance from board, socket, or cabling do not steal current from the DUT. In one implementation, buffer 1731 can be an amplifier integrated guard buffer or a dedicated unity-gain stage that drives guard planes and rings around the 1730 inputs; the layout may employ continuous guard rings, guard vias, and keep-outs around the inverting node to suppress leakages.

The conditioned output of 1730 is routed by output-enable switch 1737 to downstream circuitry such as a filter and ADC driver. Further, control of 1713, 1735, 1737, and 1739 can allow multiple modes: (i) high-sensitivity current mode, using a large-value Rf and small Cf for leakage/photocurrent measurement; (ii) wide-band current mode, selecting smaller Rf and larger Cf for higher-speed stimuli; and (iii) voltage mode, engaging switch 1739 and disabling TIA 1730. Range switching may be implemented with low-leakage relays.

Through coordinated control of 1713, 1735, 1737, and 1739, circuit 1700 may operate in multiple modes, including a high-sensitivity current-measurement mode using TIA 1730 and a pass-through voltage-measurement mode using the bypass path. Buffer 1731 together with the selectable feedback network in 1735 may protect the front end and stabilize the summing node.

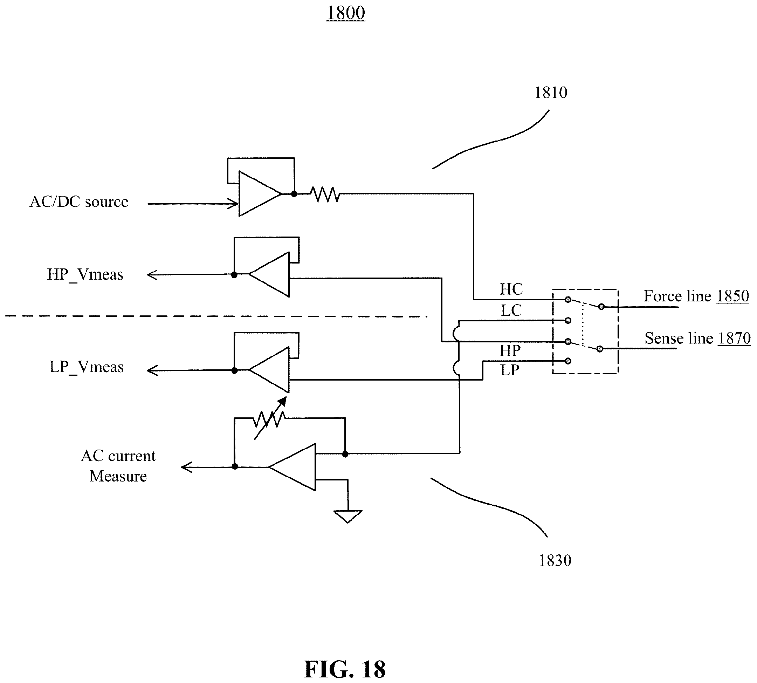

FIG. 18 illustrates a schematic circuit 1800 of the test channel 1810, 1830 of the multi-channel parallel device testing system according to an embodiment of the present disclosure. As shown in FIG. 18, upper test channel 1810 and lower test channel 1830 may be used in multi-channel parallel device testing system 100, where multi-channel parallel device testing system 100 may be connected to multiple DUTs via force line 1850 and sense line 1870.

In some embodiments, circuit 1800 may be implemented with a dual-path test channel architecture with an upper test channel 1810 and a lower test channel 1830 that terminate at a configurable, switching block. The switch can be configured to connect independently selectable nodes to the device interface: force line 1850 and sense line 1870.

In some embodiments, by actuating the switch a given channel can be configured as either a "high" channel (HC with HP closed) or a "low" channel (LC with LP closed), thereby realizing a Kelvin, four-terminal style connection in which current is forced on one pair and voltage is sensed on a separate, high-impedance pair to minimize lead-drop errors.

Upper test channel 1810 can include an AC/DC source driver (left-top op-amp triangle) feeding the switch block through a series resistor (shown inline) that provides current limiting, damping, and cable-match when driving the DUT through force line 1850. A second amplifier can be configured to provide the high-potential (HP) voltage sense. And this node can be routed to the sense line when HP is selected. In one implementation, a driver can be configured as a wide-band op amp to provide DC or AC stimulus.

Lower test channel 1830 may be configured to measure low-potential sense. Additionally, or alternatively, lower test channel 1830 can be configured to provide a complementary measurement. In lower test channel 1830 an amplifier sense can return current from the switch block; the symbolized resistor to ground indicates a transimpedance or shunt-based conversion of DUT current to a voltage for digitization. The amplifier can furnish the low-potential voltage sense lead. However, when the switch selects LC (for Force) and LP (for Sense), the channel acts as the low-side measurement leg: current is measured in the return while voltage is sensed with high impedance at the low-potential node, enabling accurate impedance/C-V measurements even in the presence of series lead resistance and chuck-to-ground parasitics. (Transimpedance conversion and guarding techniques are commonly used for picoamp-to-milliamp AC measurements.)

In FIG. 18, the switch (shown in dashed lines) can be implemented with low-leakage analog switch elements (e.g., PhotoMOS or MEMS relays) chosen to isolate inactive paths. In operation, any two channels in the multi-channel system can be paired: one configured HC+HP to act as the driven source/sense leg, and another configured LC+LP to act as the current-measurement/low-sense leg, thereby emulating a classic LCR/CMU four-terminal setup without a single shared meter. Channel roles can be reassigned under program control to test multiple DUT pins in parallel.

During a measurement, the AC/DC source in upper test channel 1810 can drive the DUT through force line 1850 when HC is closed; simultaneously HP reports the applied terminal voltage on sense line 1870. The DUT return current flows back through the lower path to the AC current measure stage when LC is closed, and LP reports the low-potential terminal voltage.

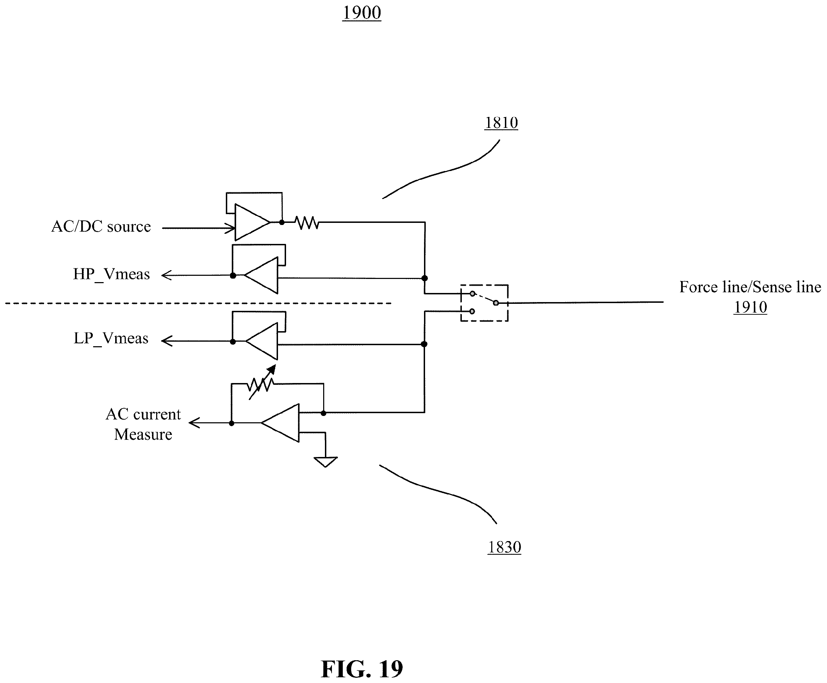

FIG. 19 illustrates a schematic circuit 1900 of the test channel 1910, 1930 of the multi-channel parallel device testing system 100 for high impedance DUT according to an embodiment of the present disclosure. FIG. 19 describes a streamlined design optimized for high-impedance DUTs, using a two-wire connection and omitting Kelvin separation where it is unnecessary.

In FIG. 19 a single Force/Sense line in test channel 1910 driven by a compact channel switch connects the DUT, rather than a switch with independent poles. Selection ties the DUT to either the upper test channel 1810 or lower test channel 1830 as a two-wire connection. Kelvin separation can be purposely omitted because the DUT impedance is sufficiently large that lead/contact resistance is negligible relative to the measured value.

Functionally, test channel 1810 can retain the AC/DC source driver (with series damping) and an HP monitor, and test channel 1830 can retain LP monitor and an AC current Measure stage. Unlike FIG. 18-where HP and LP were routed to a separate high-impedance sense pole-both voltage monitors in FIG. 19 observe the same selected node at the Channel-Select output, so either leg can source/measure without a distinct sense lead. The AC-current stage continues to sense return current for impedance/C-V extraction; however, because only one external conductor is used for both force and sense, the reading reflects the DUT plus any small lead series element (acceptable in the high-impedance regime). This streamlining reduces switch count and associated leakage/capacitance, which is advantageous when measuring very high impedances or small capacitances.

Some embodiments may combine circuits 1800 and 1900. Circuit 1800 in FIG. 18 can be set as a four-terminal option used when accuracy would be limited by lead resistance or contact drops (separate HC/LC force and HP/LP sense to enforce Kelvin), while FIG. 19 can be the two-terminal option used when the DUT impedance is high and a simpler topology improves throughput and minimizes parasitics (single Channel-Select to the Force/Sense line in test channel 1910).

The circuit 1800, 1900 respectively shown in FIG. 18 and FIG. 19 may improve alternative systems that use a single LCR meter. Multi-channel parallel device testing system 100 that uses the circuit 1800, 1900 shown in FIG. 18 and FIG. 19 may measure multiple DUTs at the same time because any test channel 1810, 1820, 1910, 1920 can act as the LCR meter and all test channels can be measured at the same time.

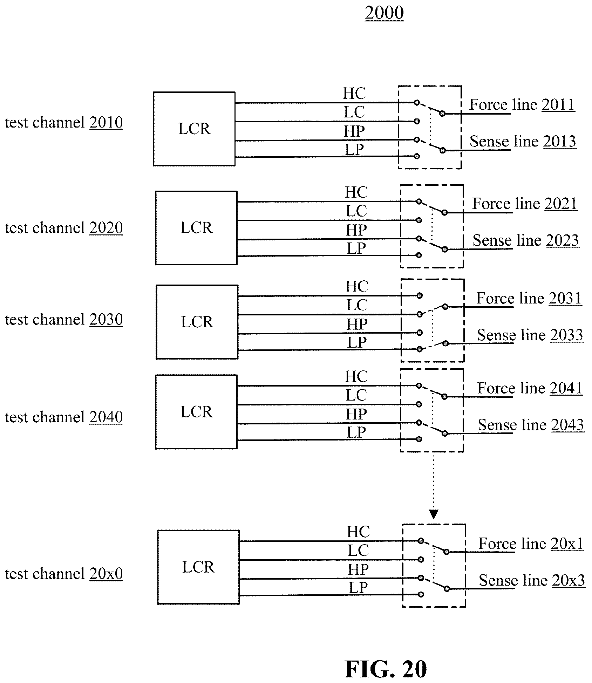

FIG. 20 illustrates a block diagram 2000 describing a system with multiple test channels of the multi-channel parallel device testing system according to an embodiment of the present disclosure. As shown in block diagram 2000, the system may include multiple test channels configurable with dual switches for upper and lower test channels, as discussed in connection with FIG. 18.

FIG. 20 depicts a scalable, per-channel LCR topology that mirrors the dual-path architecture of FIG. 18 but replicates it across many channels. Four representative test channels 2010, 2020, 2030, and 2040 are shown explicitly, with an additional channel 20x0 indicating continuation. Each test channel can integrate an LCR block that provides the four internal terminals HC (high-current force), LC (low-current force/return), HP (high-potential sense), and LP (low-potential sense). These four nodes can implement a four-terminal topology inside each channel so that current is forced on one pair while voltage is sensed on a separate, high-impedance pair.

For example, for test channel 2010 the four LCR nodes feed a two-pole switching module (shown with a dashed outline) that presents a dedicated Force line 2011 and Sense line 2013 to the probe interface. The same structure is repeated for test channel 2020 with Force line 2021 and Sense line 2023, for test channel 2030 with Force line 2031 and Sense line 2033, and for test channel 2040 with Force line 2041 and Sense line 2043. In each instance, the switch selects which internal nodes (HC vs. LC, HP vs. LP) appear on the external force and sense conductors, permitting the channel to operate as a high leg (HC+HP) or a low leg (LC+LP) of a four-terminal pair, as described in FIG. 18. Additional channel 20x0 indicates that the same scheme extends to additional channels, each with its own Force line 20x1 and Sense line 20x3.

At run time, a controller programs the per-channel switch so any channel can serve as the driven source/sense leg (HC+HP) or as the return/current-measurement leg (LC+LP). Because each channel exposes its own force and sense outputs (2011/2013, 2021/2023, 2031/2033, 2041/2043, 20x1/20x3), multiple DUT pins or multiple DUTs can be stimulated and measured in parallel, with true four-terminal accuracy preserved per site. This "per-pin resource" style (one measurement resource per contacted pin) is a recognized way to increase parallelism and eliminate long switch-matrix paths that add leakage and capacitance.

FIG. 20 shows how the system can scale: the left-hand LCR block in each channel generates the AC stimulus and performs voltage/current sensing; the dashed two-pole switch assigns the four internal nodes (HC/LC/HP/LP) to the external Force and Sense conductors unique to that channel; the conductors (2011/2013, 2021/2023, 2031/2033, 2041/2043, 20x1/20x3) route directly to the probe card. By combining four-terminal sensing at the channel with per-pin fan-out, the architecture achieves accurate impedance/C-V results while supporting high-throughput, multi-site testing-an approach consistent with best practices for Kelvin sensing and driven-guarded measurements in precision LCR work.

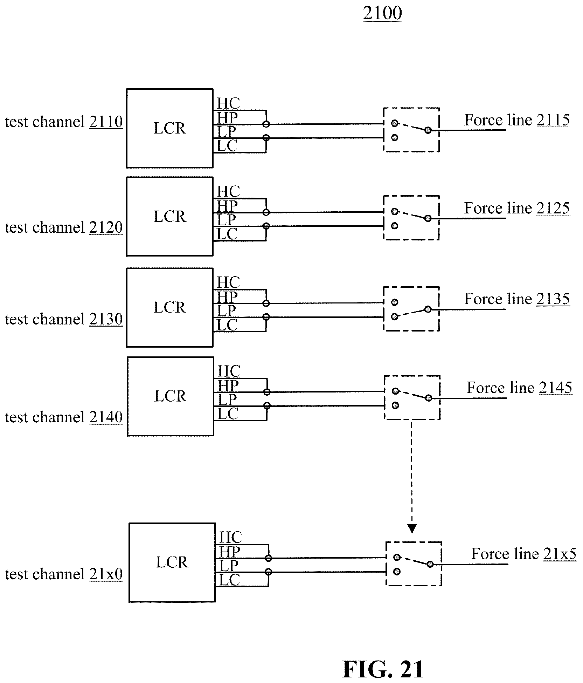

FIG. 21 illustrates a block diagram 2100 describing a system with multiple test channels of the multi-channel parallel device testing system according to an embodiment of the present disclosure. As shown in block diagram 2100, the system may include multiple test channels configurable with compact switches for upper and lower test channels, as discussed in connection with FIG. 19.

FIG. 21 shows a multi-channel topology derived from the two-wire configuration of FIG. 19. Five representative channels-test channel 2110, 2120, 2130, 2140, and 21x0-are illustrated. Each channel may include an LCR block exposing the four internal nodes HC, HP, LP, and LC, but only the HP and LP nodes are routed forward to a compact channel-select switch. The switch selects either HP or LP onto a single external conductor Force line 2115, 2125, 2135, 2145, or 21x5 (one per channel). As shown in FIG. 19, this implements a two-wire, high-impedance connection where the same conductor carries the force and sense function for that channel-appropriate when DUT impedance is sufficiently large that lead/contact resistance is negligible compared with the measured value.

The per-channel HP/LP selection allows each site to be bound to the "high" leg (HP referenced) or to the "low" leg (LP referenced) without a separate Kelvin sense return. Internally, the LCR block can still measure stimulus and response using the channel's own voltage and current monitors, but external cabling can be reduced to the single force line per site. Relative to FIG. 20, FIG. 21 arrangement can reduce the number of cables and switch poles, lower fixture capacitance/leakage and improving practicality for high-Z components or structures where two-wire accuracy is adequate.

The dashed channel-select switches in FIG. 21 may be realized with solid-state relays (e.g., PhotoMOS) or MEMS relays to preserve picoamp-level off currents and low parasitic capacitance at each site. These devices provide bounce-free operation and stable on-resistance across life, making them well-suited to multiplexing high-impedance measurements without corrupting the reading.

In operation, a controller programs each channel's switch to connect either HP or LP to its force line, applies the desired AC/DC stimulus from the LCR block, and acquires voltage/current internally per channel. Because only one conductor exits each site, routing density on the probe card increases and inter-site coupling is reduced.

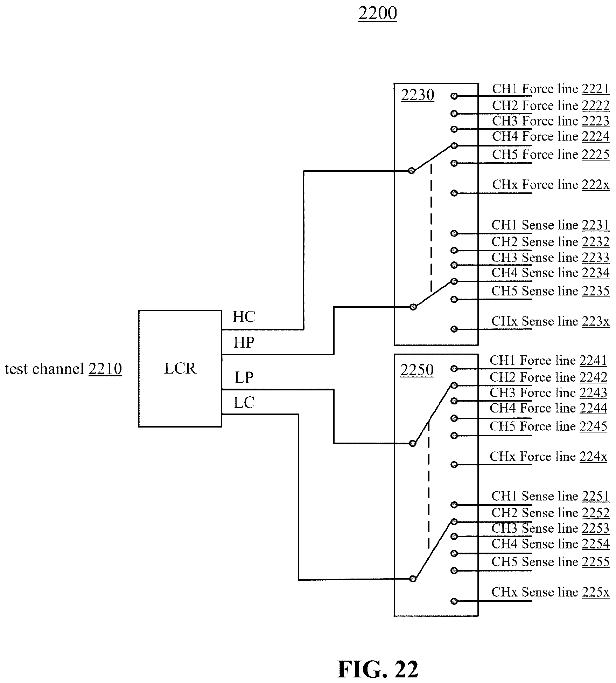

FIG. 22 illustrates an alternative test system 2200 according to an embodiment of the present disclosure. In FIG. 22, one test channel 2210 can be coupled with multiple sense and force lines with a high multiplexer 2230 and a low multiplexer 2250.

As shown in FIG. 22, in the test system 2200 single test channel 2210 exposes four nodes-HC, HP, LP, and LC-to high multiplexer 2230 and low multiplexer 2250. High multiplexer 2230 fans the HC/HP pair to a bank of external lines identified as CH1 Force line 222 to 2225 (plus an expansion port CHx Force line 222x indicating additional force lines can be added) and CH1 Sense line 2231 to 2235 (plus CHx Sense line 223x indicating additional sense lines can be included). Low multiplexer 2250 similarly fans the LC/LP pair to CH1 Force line 2241 to Force line 2245 (plus CHx Force line 224x) and CH1 Sense line 2251 to CH5 Sense line 2255 (plus CHx Sense line 225x).

In some embodiments, one selection is made in the high multiplexer 2230 and one in the low multiplexer 2250 so that the instrument's high (HC/HP) and low (LC/LP) terminals are routed to the same DUT site, preserving a true four-terminal-pair (4TP) connection. The 4TP scheme separates force and sense paths to eliminate lead drops and is standard practice for precision LCR/impedance measurements.

Further, in some embodiments, any one DUT site in the high bank and one in the low bank are selected because each pin can be independently configured. For example, a controller can sequence the two multiplexers so that, for example, to measure Site 3 the system closes the HC→CH3 Force line 2223 and HP→CH3 Sense line 2233 paths in the high multiplexer 2230 while simultaneously closing the LC→CH3 Force line 2243 and LP→CH3 Sense line 2253 paths in the low multiplexer 2250.

The line set in FIG. 22 represents a scan topology. For example, the CH1-CH5 Force lines 2221-2225 (and 2241-2245) can be configured to carry the current-forcing terminals for the selected high and low legs, respectively; the CH1-CH5 Sense lines 2231-2235 (and 2251-2255) carry the corresponding high-impedance voltage sense returns. Expansion identifiers 222x/223x/224x/225x indicate that additional sites can be added in the same manner without altering test channel 2210.

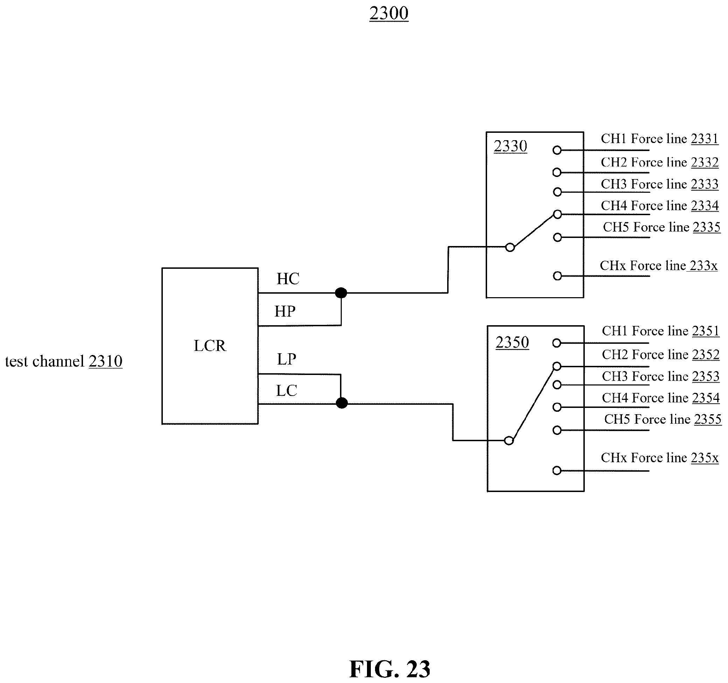

FIG. 23 illustrates the alternative test system 2300 for high impedance DUT according to an embodiment of the present disclosure. The alternative test system 2200 and 2300 may use a single LCR meter that is multiplexed to any 2 pins. One pin gets the high side AC source, and the other one pin gets the low side AC current measure.

In test system 2300 a single test channel 2310 (LCR) HC/HP and LC/LP are shorted and routed. HC/HP feeds a high multiplexer 2330 that fans out to CH1 Force line 2331, CH2 Force line 2332, CH3 Force line 2333, CH4 Force line 2334, CH5 Force line 2335, and an expansion output CHx Force line 233x. In parallel, LC/LP feeds a low multiplexer 2350 that fans out to CH1 Force line 2351, CH2 Force line 2352, CH3 Force line 2353, CH4 Force line 2354, CH5 Force line 2355, and CHx Force line 235x (representing any number of force lines). During a measurement the controller closes one path in 2330 and one path in 2350 so that HC and LC land on the same site number, establishing a two-wire drive/measure connection to that DUT pin.

Moreover, as shown in FIG. 23 two multiplexers (2330 and 2350) are configured without separate HP/LP sense. In FIG. 22, each side (high and low) had two banks (one for Force and one for Sense) to maintain a four-terminal connection. FIG. 23 omits two route relying instead on two lines. One benefit is a substantial reduction in switched paths and connectors, which reduces added leakage and parasitic capacitance from the matrix and harness, speeds scanning (fewer contacts to actuate), and lowers cost/size-advantages that are especially helpful with high-impedance DUTs where two-wire accuracy is adequate.

FIG. 23 configuration may be intended for applications where the DUT impedance is large relative to lead resistance (e.g., high-Z components or structures), while FIG. 22 configuration can be selected for higher accuracy. In some embodiments the multiplexers 2330/2350 are implemented with break-before-make low-leakage switching devices so that only one site per bank is ever connected and no two sites are momentarily shorted during transitions. Using solid-state relays with low C×R and low off-state leakage preserves accuracy with high-impedance sources and maintains bandwidth for AC measurements. The CHx designators (233x, 235x) show that additional sites can be added without changing test channel 2310, allowing time-multiplexed two-wire measurements across many DUT pins with a single precision LCR resource.

The LCR meter of the alternative system shown in FIG. 22 and FIG. 23 may be multiplexed to each pair of pins for a single measurement 24 times. By using the circuit shown in FIG. 18 and FIG. 19 and the multi-channel test system shown in FIG. 20 and FIG. 21, the measurement could be faster than one LCR meter being multiplexed. Therefore, multi-channel parallel device testing system 100 may provide faster testing time, and the faster testing time may provide lower testing cost per DUT.

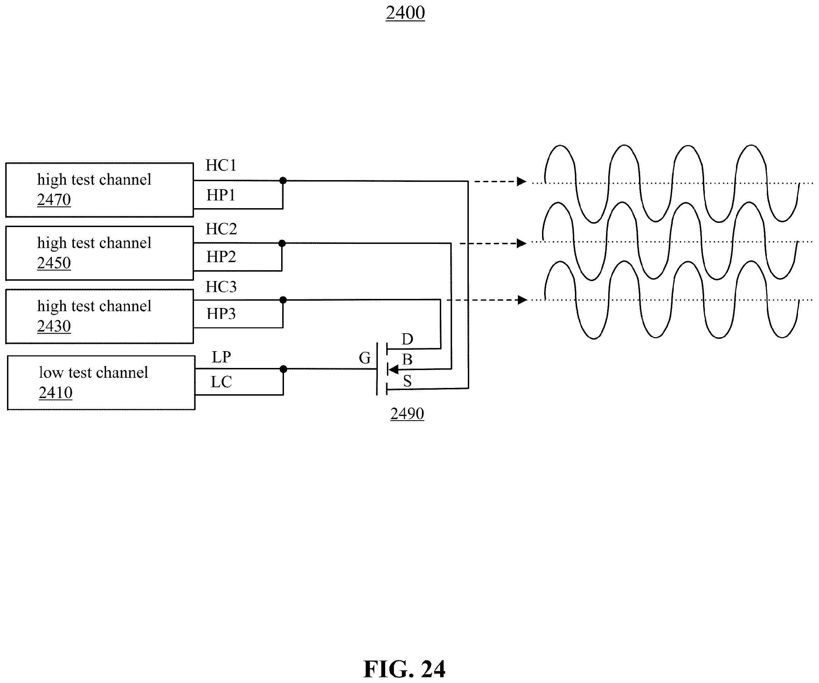

FIG. 24 illustrates a schematic circuit 2400 for measuring a C-V characteristic of a MOSFET on a wafer that multi-channel parallel device testing system 100 is mounted according to an embodiment of the present disclosure. As shown in FIG. 24, test channels may include a first test channel CH1, a second test channel CH2, a third test channel CH3, and a fourth test channel CH4. Multi-channel parallel device testing system 100 may be configurable to set the potential node of first test channel CH1, second test channel CH2, and third test channel CH3 to a first dynamic potential. Multi-channel parallel device testing system 100 may also set the potential node of the fourth test channel CH4 to a second dynamic potential. The second dynamic potential is different than the first dynamic potential. Multi-channel parallel device testing system 100 may perform a capacitance-voltage analysis by applying a voltage and measuring capacitance as a function of the first dynamic potential and the second dynamic potential.

In FIG. 24, three high test channels, test channel 2470 (HC1/HP1), test channel 2450 (HC2/HP2), and test channel 2430 (HC3/HP3), are routed respectively to a DUT that can be a MOSFET 2490 D, B, and S terminals. A low test channel 2410 (nodes LP/LC) is routed to MOSFET 2490 G terminal to provide the low-side reference and measurement return. Waveforms sketched to the right indicate that the three high channels can be driven with identical AC/DC stimuli (equal amplitude, DC offset, frequency, and phase), while the gate is biased/scanned by the low channel to realize a gate-to-(D,S,B) C-V measurement. This arrangement can be the functional equivalent of tying drain/source/bulk together and measuring against the gate, a standard MOSFET/MOS-capacitor C-V technique.

Implementing three synchronized high-side drivers as shown in FIG. 24 can have benefits such as each terminal is driven through its own calibrated path, allowing per-terminal guarding and leakage control; the drivers remain phase-locked so D, S, and B track together, emulating the tied-node condition used in MOS C-V practice; and the architecture can optionally introduce deliberate, known offsets (phase or DC) for advanced methods such as split-C-V or body-bias studies without rewiring.

Test channels 2470/2450/2430 can provide a force node (HCx) and a high-impedance sense node (HPx) to the DUT terminals (D/B/S), the test channel 2410 provides the return (LC) and the low-potential sense (LP) to the G terminal. The three sinusoidal traces emphasize that HC1/HC2/HC3 are equal in amplitude, offset, frequency, and phase, while the gate bias is swept by channel 2410.

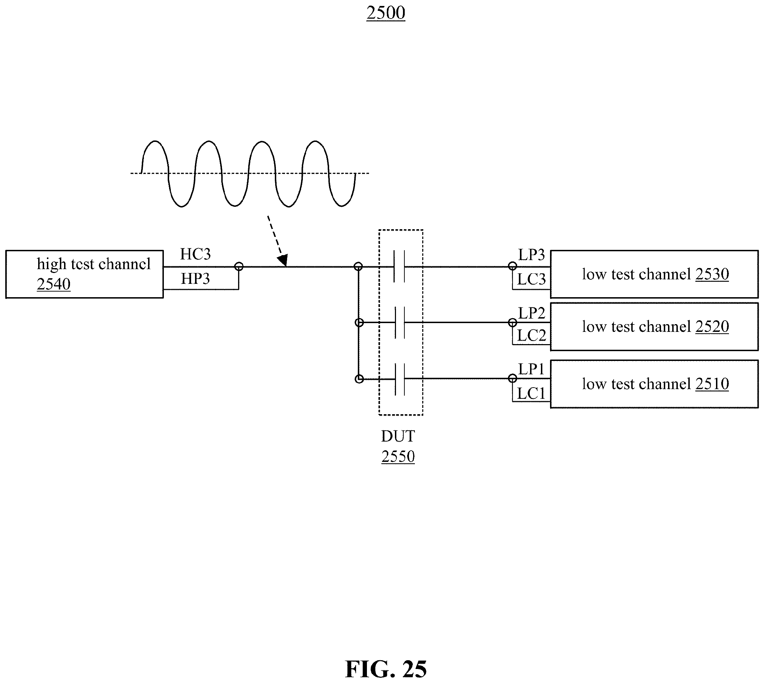

FIG. 25 illustrates a schematic circuit 2500 for measuring a C-V characteristic of a DUT according to an embodiment of the present disclosure. As shown in FIG. 25, test channel 2540 may be configured as a high-side channel to drive the common node through a high current switch HC3 and a potential node HP3 with synchronized AC excitation and optional DC bias. Potential node HP3 may be configured as high potential when the high current switch HC3 is closed. A sinusoid may indicate the applied AC stimulus.

A common node may fan out to multiple branches of a device under test (DUT) 2550. Each lower end connected to a low-side channel, i.e., test channel 2510, 2520, 2530. Each test channel 2510, 2520, 2530 may connect via corresponding low potential node LP1, LP2, LP3 and corresponding low current switch LC1, LC2, LC3 to provide separated low-side voltage-sense and AC current-measure paths.

In some embodiments, DUT 2550 branches may be three parallel capacitors. In some embodiments, resistors, diodes, or other passive or nonlinear elements may also be used. During measurement, high-side drive from test channel 2540 may be generated by a DDS and monitored at high potential node HP3 for accurate amplitude and phase.

In the FIG. 25, test channel 2540 may include the nodes HC3 (high-current force) and HP3 (high-potential sense) that can be shorted. HC3 is closed via a high-current switch when driving the common node of DUT 2550.

The common node from the high-side branch fans out to multiple branches inside DUT 2550, each branch terminating in a separate low-side test channel: test channels 2510, 2520, and 2530. Each of these applies its own low potential node (LP1, LP2, LP3) and low current switch (LC1, LC2, LC3). The LP nodes serve as voltage sense points, while the LC switches provide the return (force) or current measuring path, depending on how routed. These low channels can each measure the capacitance or current associated with their branch, allowing the system to capture multiple branch capacitances in parallel under the same common drive. In practice, each low channel has internal calibration and sense circuitry to resolve small currents and voltages with high fidelity.

The multiple-branch configuration supports performing capacitance-voltage (C-V) sweeps where the gate or common node is driven by the high-side channel while the voltage at the gate (or low side) is varied or stepped by one of the low channels, or by using all low channels concurrently to measure each branch's response. For example, in a MOS array where three source/drain/bulk terminals are tied together (or driven together), this configuration enables measuring the total capacitance to those nodes as a function of gate bias.

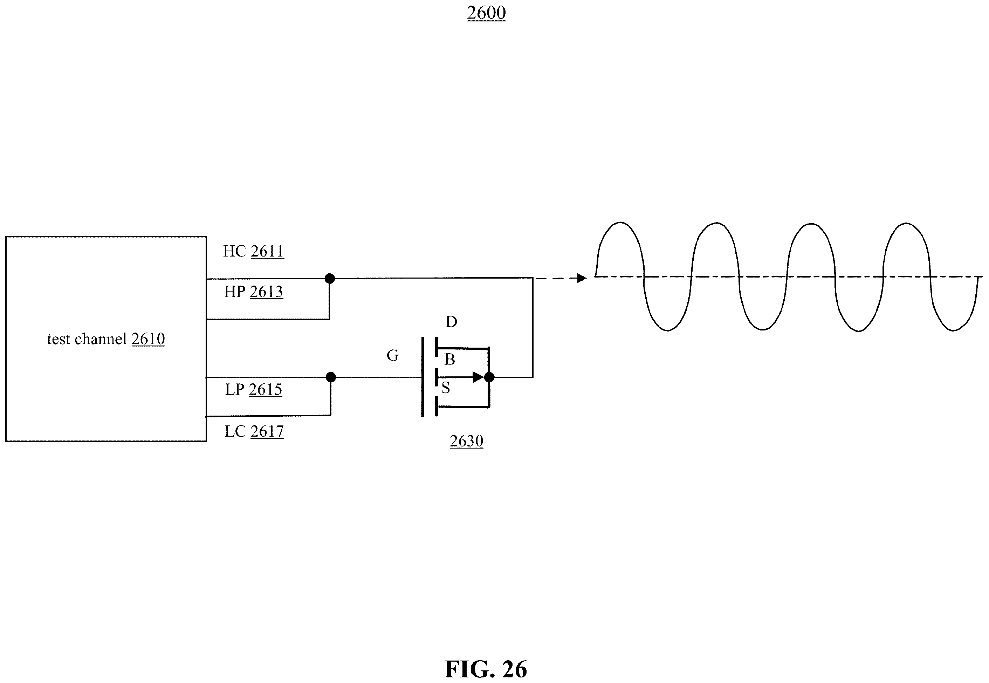

FIG. 26 illustrates a schematic circuit 2600 for a single high channel and other low channels testing according to an embodiment of the present disclosure.

As illustrated in FIG. 26, and previously discussed, HC node 2611, HP node 2613, LP node 2615, and LC node 2617 can be configured to be coupled for a two connection configuration. Specifically, as described above, the potential nodes may be configured as a high-potential node HP/HC and a low-potential node LP/LC. In some embodiments, the node connection shown in FIG. 26 may not be simultaneously active during normal measurement, aside from brief transitions that may occur during calibration. This single-node, programmable-role topology may reduce parasitics and routing imbalance while maintaining four-wire Kelvin separation and amplitude and phase coherence when a channel is assigned as the high side or the low side.

In some embodiments, circuit 2600 may be implemented as a single programmable switchable potential node to implement force/sense separation without requiring separate physical sense leads for high and low roles. As shown in FIG. 26, by reusing the same physical node under different switch states (HC closed → high-potential sense; LC closed → low-potential sense), the hardware avoids duplication of routing and associated parasitic capacitance, leakage, and phase / amplitude mismatch between separate paths.

With the implementation in FIG. 26, accurate matching of phase and amplitude between force and sense during calibration is enabled because the same source amplifier and clock drive both configurations. Example calibration routines might close HC, measure amplitude/phase at HP, open HC, close LC, measure at LP, then store correction coefficients. These corrections compensate for switch-and-routing induced delay or gain differences. Such practices are common in precision LCR / CMU instruments.

Another benefit of the topology of FIG. 26 can be that during non-measurement modes (e.g. during calibration or idle), the unused switch (HC or LC) can be opened, thereby isolating the non-active path. This minimizes the chance of parasitic leakage or capacitive coupling influencing the measurement. Also, because the same physical node is reused, its capacitance and routing layout can be made symmetric for both roles (HP vs LP), helping to reduce systematic error in phase or amplitude when the channel switches role.

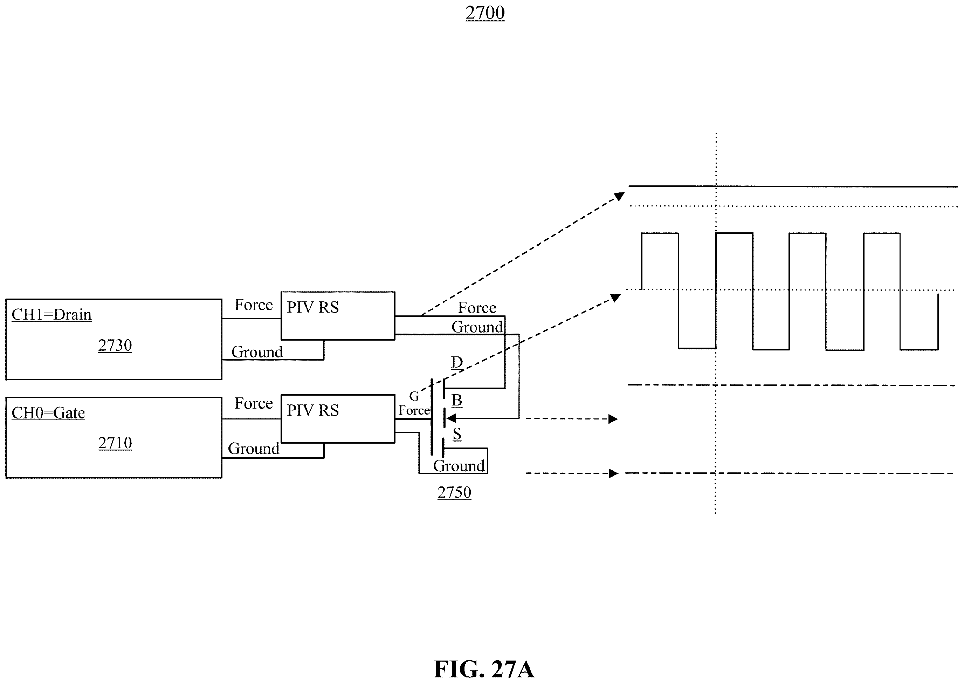

FIG. 27A also illustrates a schematic circuit 2700 for high-speed pulse IV test according to an embodiment of the present disclosure. As illustrated in FIG. 27A, two independently programmable test channels 2710, 2730 may be used. Test channel 2710 may drive the gate G of a device under test through a Pulsed I-V Remote Sense (PIV RS) module, and Test channel 2730 may apply a pulsed bias to the drain D and acquire voltage and current through another Pulsed IV (PIV) Remove Sense (RS) module. Each channel may provide Force and Ground returns to its respective PIV RS module, which may then connect to the device terminals. The PIV RS module may include high-speed switching, programmable source and measure stages, a current sense resistor, and impedance matching so that pulse edges are well controlled, peak current is limited, and sampled values are reported to a controller.

As shown in FIG. 27A MOSFET 2750 can have a source terminal S and body terminal B are shorted to ground, drain terminal D is driven by test channel 2730 through the force line with the corresponding ground return, and gate terminal G is biased by test channel 2710 with its own ground return. The timing diagram on the right may illustrate a drain waveform with an adjustable direct-current pedestal and superimposed pulses, a gate waveform that may be a step or a pulse train, and the source and body held at ground. A vertical dotted line denotes a common trigger instant at which both channels may align their pulse edges to minimize timing jitter.

During the test sequence a controller may program test channel 2730 pulse amplitude, width, rise time, fall time, and repetition rate, and may program a gate bias sweep on test channel 2710. At each pulse flat-top the system may sample drain voltage and the current reported by PIV RS module to form a single IV data point. Repeated sweeps may produce transfer characteristics, output characteristics, or pulsed Rds_on. The pulsed method may reduce self-heating and contact drift errors, and PIV RS module may provide over-voltage, over-current, and short-circuit protection suitable for fast wafer-level characterization.

In some embodiments, circuit 2700 may enable precise high-speed switching (for opening and closing the HC/LC switches). For example, the configuration shown in circuit 2700 can allow pulse rise/fall times on the order nanoseconds or faster, depending on device capacitance and measurement bandwidth.

FIG. 27A describes a possible representation of pulse resources in each test channel including a first branch and a second branch that are coupled by a high-speed switch. In the configuration of FIG. 27A, the PIV-RS force lines may define potential nodes at the DUT drain and gate, each coupled to a corresponding testing pin with a ground return. A mode switch in the test channels can selectively couple the respective potential node either to a pulse resource (e.g., delivering a pedestal-biased pulse train whose edges are aligned to the dotted timing mark) or to a measuring resource. The dotted vertical trigger can indicate timing derived from a common system clock so that pulse application and measurement windows are phase-aligned across the test channels.

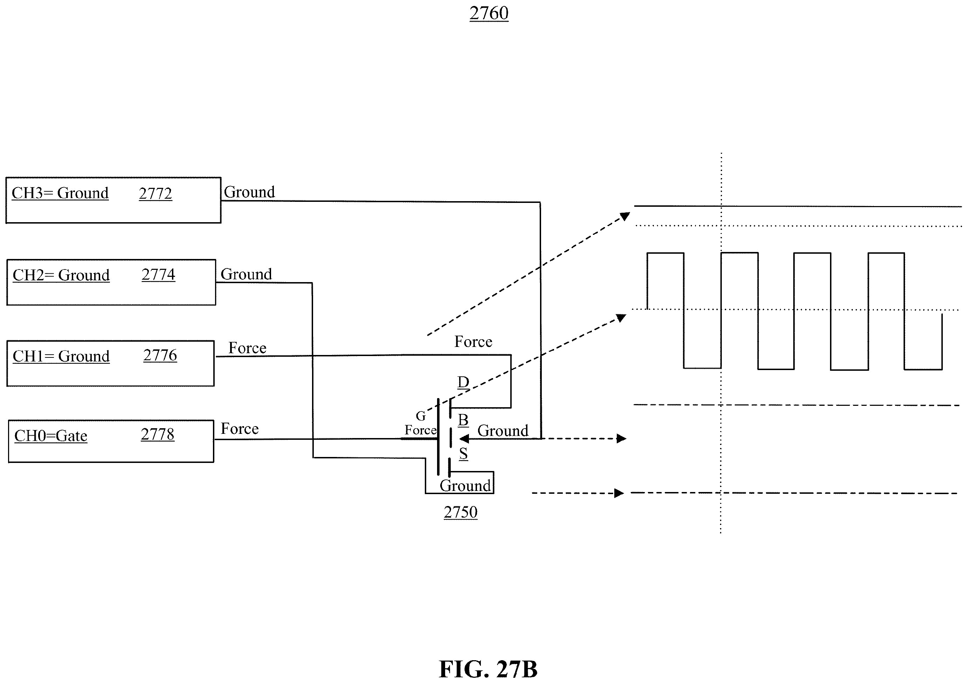

FIG. 27B illustrates a schematic 2760 of a second high-speed pulse IV test according to an embodiment of the present disclosure. As shown, four independently programmable test channels 2772, 2774, 2776, and 2778 may be used. Test channel CH0 (2778) can be configured to drive the gate G of the device under test (DUT) 2750 with a pulsed excitation (Force lead shown). Test channel CH1 (2776) is configured as a low-impedance reference on the drain D; in the illustrated embodiment CH1 forces the drain to a selected reference potential (e.g., ground), thereby providing a stable clamp and, when enabled, a measurement return for drain voltage and/or current. Test channels CH2 (2774) and CH3 (2772) provide ground connections for the body B and source S terminals, respectively, establishing a well-defined reference for the pulsed measurement. In alternative embodiments, CH1 may instead force a fixed DC drain bias while CH2/CH3 continue to provide body/source ground returns.

The right-hand timing diagram corresponds to the configuration of FIG. 27B. The top trace depicts the drain potential held substantially constant by CH1 (either at ground or at a programmed DC bias). The second trace depicts the gate waveform provided by CH0, which may be a pulsed train with programmable amplitude, width, rise time, fall time, and repetition rate. The lower dashed traces indicate the body and source remaining at ground potential via CH2 and CH3. A vertical dotted line denotes a common trigger instant; the channels align their operations to this trigger to minimize timing jitter between the gate pulse and any sampling or monitoring performed on the drain clamp channel.

During a test sequence, a controller may program CH0 to generate the desired gate pulse profile while commanding CH1 to maintain the drain clamp and optionally report drain voltage and current. At each pulse flat-top (or other sampling window), the system may sample the relevant quantities (e.g., gate-referenced current, clamp voltage) to form individual IV data points. Repeating the pulse sequence while sweeping the gate amplitude enables extraction of transfer characteristics (Id-Vg) under pulsed conditions; maintaining the drain at ground can support threshold-voltage or gate-charge-related measurements with minimal self-heating.

In the arrangement of FIG. 27B, the force leads establish potential nodes at the DUT gate and drain that are coupled to corresponding testing pins, and the dotted timing mark represents a trigger derived from a system clock. The mode switch in the gate-drive channel can select a pulse resource so that the gate potential node receives a pedestal-biased pulse train; a high-speed switch within the pulse resource may select between a shaping branch that may include a pulse generator and PGA and a sampling/verification branch used for pulse monitoring. By reconfiguring switches associated with pulse resource, the test channels can be assignable as a pulse channel and their operations can be phase-aligned to the system-clock trigger to support simultaneous pulse delivery and synchronized measurement (either voltage or current measurement) consistent with the disclosed architecture.

The arrangement of FIG. 27B complements the configuration of FIG. 27A. Whereas FIG. 27A employs Pulsed I-V Remote Sense (PIV RS) modules on the drain and gate paths to deliver and measure fast pulses with remote sensing, FIG. 27B illustrates a simplified ground-clamped topology in which additional channels provide dedicated ground or DC-bias references to device terminals while a separate channel supplies the pulsed gate drive. In some embodiments, PIV RS modules may also be inserted in the CH0 and/or CH1 paths of FIG. 27B to add remote sense, current-sense resistors, impedance matching, and protection features similar to those described with respect to FIG. 27A, while preserving the ground-clamped operating mode shown here.

In the configuration of FIG. 27B, the system can designate any of the available test channels as a ground unit. Because this role assignment can be performed within the test system, the user need not add external modules or modify the probe card to perform stress measurements such as NBTI (e.g., gate stress with source/body/drain clamped). The ground units provide the required clamps while another channel supplies the programmed gate pulse or bias. As a result, voltage errors during pulse testing due to IR drop in cables, probe contacts, or the on-resistance (R_on) of internal switches are substantially eliminated at the DUT terminals, yielding accurate stress conditions and repeatable NBTI results without fixture changes.

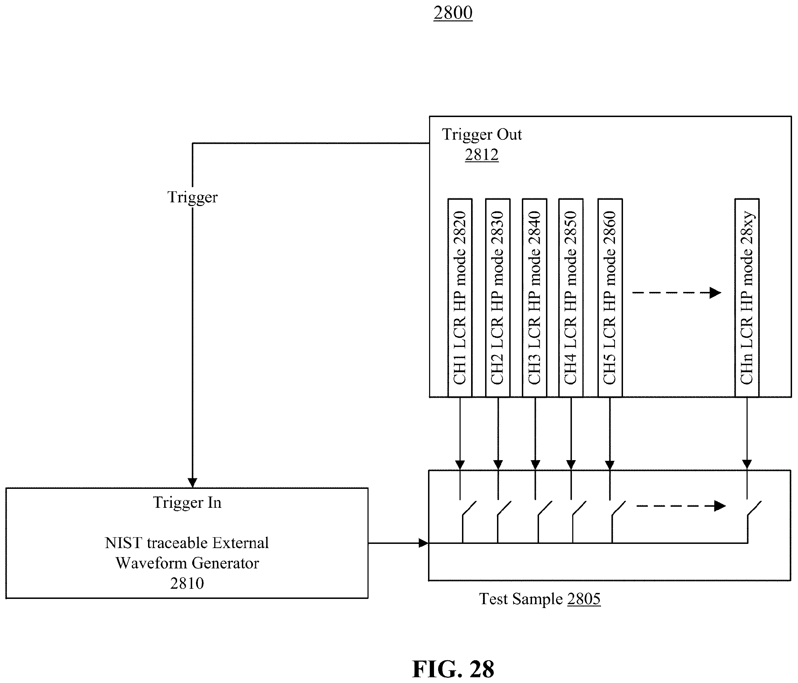

FIG. 28 illustrates a calibration block diagram 2800 according to an embodiment of the present disclosure. In block diagram a trigger out block 2812 may transmit signals to a trigger in block 2812, and both of these may be connected to a test of calibration sample 2805. Test channels 2820, 2830, 2840, 2850, 2860 may be configured in CH1 LCR HP mode, CH2 LCR HP mode 2830, CH3 LCR HP mode 2840, CH4 LCR HP mode 2850, CH5 LCR HP mode 2860, and a representative CHn LCR HP mode 28xy. The system may assert a hardware synchronization signal on trigger out block 2812 and route it to trigger in generator 2810, which may be implemented as an external waveform generator 2810. Receipt of the trigger by trigger in generator 2810 may start a sine source that is phase-locked to the system clock.

The output of the external generator 2810 may be routed through a system-controlled switching network that sequentially connects the reference signal to each channel under calibration. In some embodiments, the calibration may be sequential. For example, dashed arrows in FIG. 28 indicate the progression of this per-channel handoff. When a given channel is selected, the LCR high-potential measurement node may digitize the applied sine and the onboard signal processing may estimate amplitude and phase, for example by coherent detection or FFT. The measured values may be compared to the known reference from the external source in order to compute a per-channel gain correction and a phase offset.

Calibration may be performed at multiple frequencies and at several input levels to cover the intended operating range. The gain and phase corrections obtained for each channel and frequency point may be stored in non-volatile memory associated with that channel and automatically applied during normal measurements. The same arrangement may be used for periodic self-verification in production, allowing the system to refresh correction tables to compensate temperature shifts and long-term drift.

Moreover, each of the HP mode test channels (2820-28x0) can be arranged with measurement paths to receive the reference sine waveform from the external generator as well as generate its own measurement of the AC voltage, capturing both amplitude and phase. The routing block may include switches for each channel that select the calibration input. In this configuration, each channel can compare its internal sense (amplitude/phase) measurement against the external reference to determine offset, gain, and phase error. In this configuration, test channels in HP mode share a synchronized system clock and common reference, so that the calibration of amplitude and phase is consistent across channels. Proper calibration ensures that when the DUT is later driven by AC signals in LCR mode, the internal phase and amplitude response of each channel is known and can be corrected.

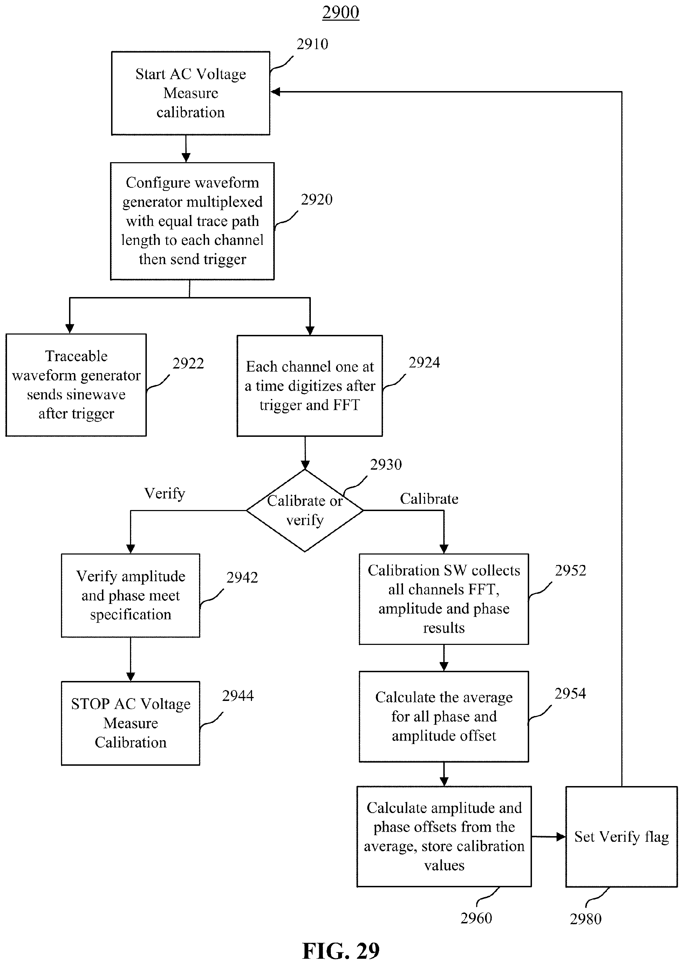

FIG. 29 illustrates a flow chart of a calibration method 2900 according to an embodiment of the present disclosure. Method 2900 may be executed by one or more processors. For example, method 2900 may be executed by elements in system 100. For example, method 2900 may be performed by processing system 711, processor 1230, and/or other processing systems described herein. While in some embodiments all steps may be performed by the same processing system, in other embodiments different steps in method 2900 may be performed by different systems. For example, certain steps in method 2900 may be performed by channel 1100 while others may be performed by other elements in processing system 711.

In step 2910, a processor may start AC voltage measure calibration. For example, a processor may use a waveform generator multiplexed with equal trace path length to each channel, then sends trigger. The processing system can initiate the AC voltage measurement calibration by driving a known AC reference signal into the measurement circuitry of the test instrument. In some embodiments, the processor can also select a traceable AC waveform from an internal waveform generator and routes it through a precision multiplexing network to the input of each test channel under calibration. The multiplexing paths to channels can be equal in length (or otherwise time-aligned) to ensure that each channel receives the reference waveform with the same phase delay. The processing system can then issue a trigger signal (for example, via a trigger output 2812) to simultaneously start the measurement capture on each channel receiving the reference. This coordinated start ensures that the phase of the acquired waveform can be consistently referenced across channels during calibration.

In step 2920, a processor may configure waveform generator multiplexed with equal trace path length to each channel then send trigger. For example, a processor may configure one or more DDS in test channels to generate unique test signal characteristics (frequency or phase). Further, in step 2920 the processor can optionally configure the DDS modules of the test channels to help distinguish or isolate each channel's calibration signal. In an embodiment, the processor adjusts the waveform generator in each channel (or the routing to each channel) such that each test channel's reference signal has a unique identifying characteristic, for example a slight difference in frequency or a known phase offset relative to a global reference. This configuration, performed via a processing system controlling each channel's DDS, can be used to ensure that even if multiple channels are calibrated concurrently, their measurement data can be separated or individually analyzed without interference.

In some implementations, unique phase offsets are introduced between channels' test signals while maintaining the same amplitude, allowing the processor to calibrate phase measurement offset of each channel relative to the common trigger reference. By configuring the test signals in this manner, step 2920 can enable a calibration process that can simultaneously exercise multiple channels, and the processor can attribute any measured differences to specific channels' response characteristics.

In step 2922, a processor may configure a traceable waveform generator to send a sinewave after trigger. For example, a processor may assert a hardware trigger to the external, traceable waveform generator (e.g., trigger input from generator 2810) and programs its setpoints. The processor can write a calibration frequency and desired phase. In step 2922 the processor may also wait for the generator's locked and settled status. The processor can then enable the generator's output and routes the sinewave through a fan-out or multiplexer with equalized trace lengths so that the phase delay to each selected channel is the same. The processor may record the generator identification, the certificate number, and the exact setpoints used, and compensates the commanded level for known cable loss or fixture attenuation so that the voltage at the channel input matches.

In step 2924, the processor may configure each channel at a time and digitizes after trigger and FFT. For example, a processor can configure sequences through the channels and performs a coherent capture for each. In some embodiments, the channel ADC can be configured to set a sampling rate, apply a window function, and receive the trigger edge. The processor may also acquire samples, compute a discrete Fourier transform, and extract a complex phasor. From that phasor the processor can calculate amplitude (for example Vrms after window and scale corrections) and phase relative to the trigger reference, and computes noise metrics from adjacent bins, if required. Further in step 2924, the processor may repeat the capture to average amplitudes and phases.

In step 2930, a processor may determine whether to calibrate or verify each channel. For example, a processor may measure AC waveform on measurement channel and acquire amplitude/phase data. For example, a processor may measure the response of each AC voltage measurement channel to the known reference signal. Each channel's ADC or measurement circuit can capture the incoming AC waveform triggered in step 2910. The processor may read the digitized waveform data from the measurement channel's ADC and computes the observed amplitude and phase. In step 2930, the processor may also quantify each channel's measurement error by comparing the channel's measured amplitude and phase to the expected reference values. While FIG. 29 shows calibration and verification as alternatives, in some embodiments these processes can be performed in sequence and/or in series.

If a processor determines to verify in step 2930, the processor may continue to step 2942. In step 2942, a processor may verify amplitude and phase error against specification. For example, the processor can evaluate whether the measurement error for each channel is within acceptable limits. Further in step 2942 the processor can compute the gain error and phase offset error for the channel's measurement system. It then compares these errors to predefined calibration tolerances or specifications stored in memory. If the channel's amplitude and phase measurements already meet the accuracy specification (i.e., the errors are below threshold), the processor may determine that no significant calibration adjustment is required for that channel (the measurement system is already within calibration). If the errors exceed the allowable specification, the processor flags calibration adjustment in the next step.

In step 2944, a processor may stop the AC voltage measure calibration. For example, the processor may terminate the verification run after step 2942 has confirmed that amplitude and phase meet specification. The processor may de-assert the calibration trigger, commands the NIST-traceable waveform generator to output-off, returns the channel fan-out/multiplexer to an open or safe default state, and restores each channel's normal routing (e.g., disconnects the verify path and re-enables standard measurement paths).

If a processor determines to calibrate in step 2930, the processor may continue to step 2952. In step 2952, the processor may use calibration software and collect FFT, amplitude and phase results from the different channels. For example, a processor may aggregate the calibration outputs from participating measurement channel by retrieving, for each channel, the complex FFT bin, the derived amplitude and phase values, and associated metadata including channel identifier, capture index, timestamp, temperature/voltage telemetry, selected range, gain setting, sampling rate, window type, record length, and number of averages. The processor may also acquire these data either by initiating DMA reads of per-channel ADC buffers and performing the FFT centrally, or by reading per-channel registers when the channels compute the FFT locally.

In step 2952 the processor may also normalize each result for ADC scale, window loss, and record length; converts amplitude into the configured units (e.g., Vrms or Vpk); unwraps and references phase to the common trigger; and applies any stored fixed delays (e.g., cable/fixture delay) to align phases. Quality metrics such as coherence, SNR, residual noise floor, and bin leakage are computed to score each capture; outliers are rejected and, if necessary, the processor re-arms the affected channel for a replacement capture.

In step 2954, the processor may calculate the average for all phase and amplitude offset. For example, processor may computes per-channel, per-range, and per-frequency summary offsets from the capture set assembled in step 2952. In some embodiments, the processor may perform iterative computations involving identification of rejected points and moving averages to identify offsets and associated statistics keyed by channel identifier, operating range, calibration frequency, temperature bin, and supply telemetry.

In step 2960, the processor may calculate amplitude and phase offsets from the average and store calculation values. For example, the processor may execute calibration processes to determine the correction factors needed to bring the channel's measurements into alignment with the reference. Based on the amplitude errors determined (e.g., a percentage gain error or offset) and any measured phase error (phase lead or lag), the processor may calculate new calibration coefficients for that channel's measurement path. These coefficients may include a gain correction factor to adjust the channel's measured amplitude and an offset or phase correction value to adjust timing or phase readings. The processor can then apply these calibration coefficients to the channel's calibration registers or software correction tables in the calibration circuit. For instance, the processor may program a calibration DAC or adjust a digital correction filter in the measurement channel to implement the calculated gain correction, and apply a phase calibration offset to the channel's timing or Digital Signal Processing (DSP) algorithms. By applying these adjustments, the measurement channel's output is virtually "calibrated" such that subsequent measurements may accurately reflect true amplitude and phase.

Also in step 2960, the processor may store calibration data and confirm calibration for AC voltage measurement. For example, the processor can finalize the calibration for the AC voltage measurement channel and store the updated calibration constants (gain and phase offsets determined in step 2960) in memory associated with the test channel 2610 or in a dedicated calibration data store.

In step 2980, the processor may set a verify flag. For example, a processor may set a per-channel bit in a register and write a corresponding system-level verify token. Upon asserting the verify flag, the processor may also: (i) mark the active coefficient set as read-only to prevent unintended edits until the flag is cleared; (ii) publish a calibration event to the host/controller and update any UI/telemetry; and/or (iii) bind the measurement pipeline to the verified coefficient image (e.g., by loading fast registers from the tagged table) and log the verify epoch for audit. The processor may further register guard conditions that automatically clear the verify flag if a material change occurs, such as a frequency/range change outside the verified envelope, a device temperature excursion beyond a stored threshold, replacement of the reference source, or a firmware/configuration mismatch detected by CRC/hash comparison.

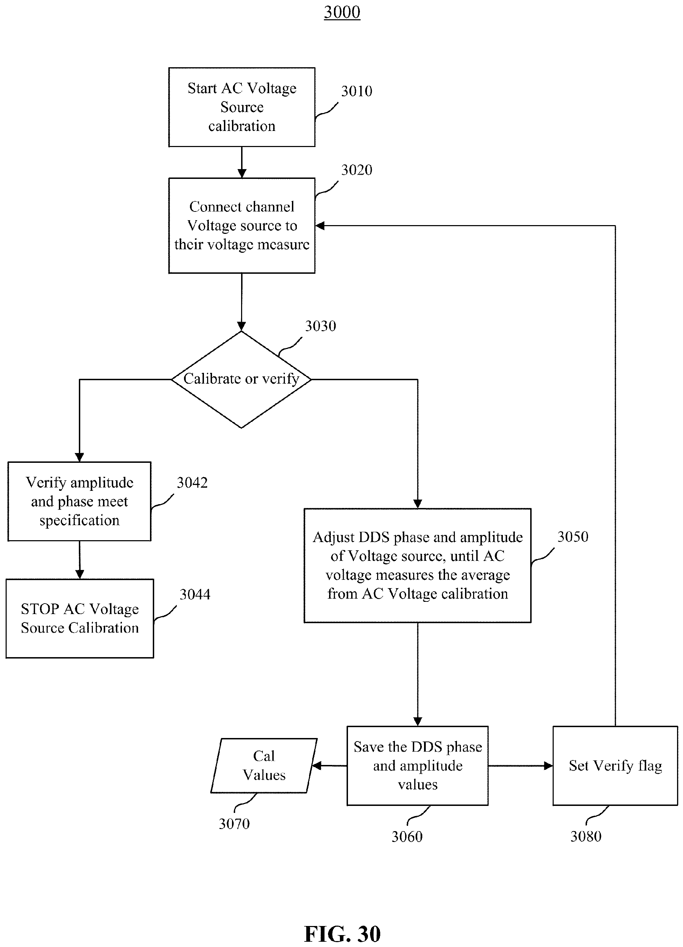

FIG. 30 illustrates a flow chart of a first calibration method 3000 according to an embodiment of the present disclosure. Method 3000 may be executed by one or more processors. For example, method 3000 may be executed by elements in system 100. For example, method 3000 may be performed by processing system 711, processor 1230, and/or other processing systems described herein. Alternatively, or additionally, while in some embodiments all steps may be performed by the same processing system, in other embodiments different steps in method 3000 may be performed by different systems. For example, certain steps in method 3000 may be performed by processor system 811 or channel 1100 while others may be performed by other elements in processing system 711.

In step 3010, a processor may start AC current measure calibration and select a reference load. Step 3010 may be similar as step 2910 described in connection with FIG. 29.

In step 3020, a processor may connect channel voltage source to their respective voltage measure. For example, a processor may configure an internal switch matrix to loop each selected channel's AC voltage source output to its corresponding AC voltage measurement input. The processor can first force the source output to a safe state (output-off or minimum amplitude), select the appropriate measurement range and input termination, and route guard/shield conductors as required for the chosen frequency band. The processor can then close the designated loopback relays for the channel under calibration, verify continuity and isolation by reading relay sense/health bits or by issuing a low-level probe stimulus and checking the measured impedance, and arms the digitizer. Once the loopback is confirmed, the processor records the channel identifier, range, relay states, and environmental telemetry, and transitions the source from safe state to the programmed calibration setpoint so subsequent steps can acquire the measurement of the channel's own output.

In step 3030, a processor may determine whether to calibrate or verify. For example, processor may perform a determination similar to the one described for step 2930 in connection with FIG. 29.

In step 3042, a processor may verify amplitude and phase meet specification. For example, a processor may perform a verification similar to the one described in step 2942 described in connection with FIG. 29.

In step 3044, a processor may stop AC voltage source calibration. For example, a processor may stop to the voltage source calibration as described in step 2944 described in connection with FIG. 29.

In step 3050, a processor may adjust DDS phase and amplitude of voltage source, until AC voltage measures the average from AC voltage calibration. For example, a processor can execute a routine that programs the channel's DDS amplitude word and phase offset register and computes the complex phasor at the calibration tone. The processor can compare the measured voltage and phase to the averaged targets produced during AC-voltage calibration and derives residual gain and phase errors. The processor then increments or decrements the DDS amplitude scaler and phase offset by bounded step sizes, reapplies the waveform, and repeats acquisition until the magnitude error and the phase error are both within predetermined tolerances.

In step 3060, a processor may save the DDS phase and amplitude values. For example, the processor may write a converged amplitude scaler and phase offset to a non-volatile calibration image indexed by channel identifier, frequency bin, range, and operating mode, computes and stores a checksum or hash over the record. The processor can also stage a shadow copy for rollback, marks the new image as active in the channel's calibration directory, and preloads the corresponding fast registers so that the corrected coefficients are applied in normal operation.

In step 3070, a processor may store the calibration values or offsets. And in step 3080 a processor may set a verify flag, as discussed above in step 2980 in connection to FIG. 29.

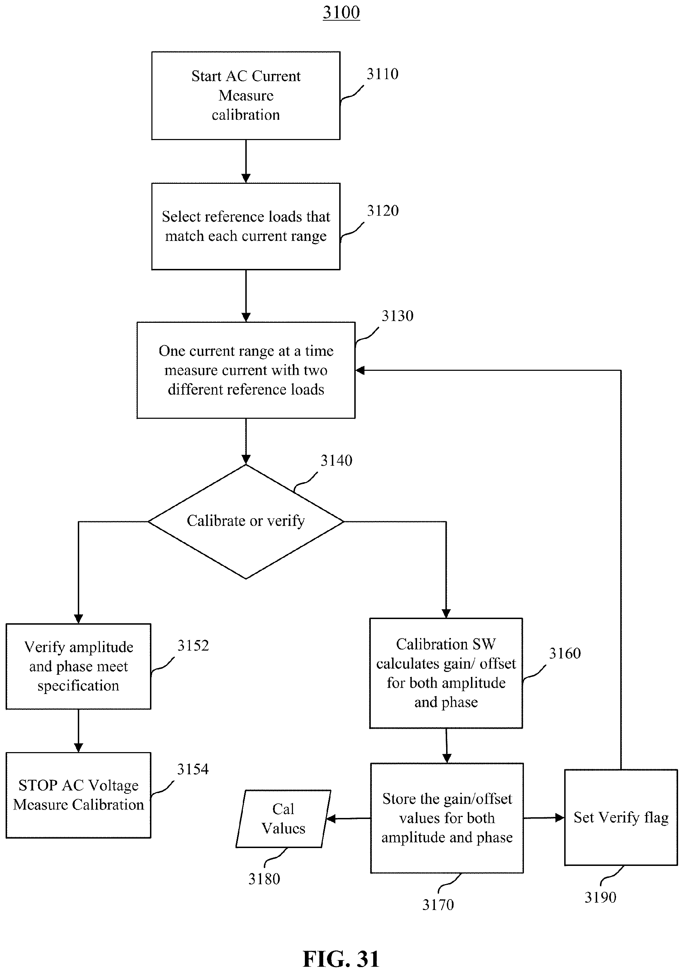

FIG. 31 illustrates a flowchart of an exemplary method 3100 for calibrating an AC voltage source output's amplitude and phase accuracy. Method 3100 may be executed by one or more processors. For example, method 3000 may be executed by elements in system 100. For example, method 3100 may be performed by processing system 711, processor 1230, or any other processing systems discussed previously. Alternatively, or additionally, while in some embodiments all steps may be performed by the same processing system, in other embodiments different steps in method 3100 may be performed by different systems. For example, certain steps in method 3100 may be performed by processor system 811 or channel 1100 while others may be performed by other elements in processing system 711.

In step 3110, a processor may start AC current measure calibration and select a reference load. Step 3110 may be similar as step 2910 described in connection with FIG. 29.

In step 3120, a processor may select reference loads that match each current range. For example, a processor may load a calibration routine that maps each source-current range to one or more precision reference resistors whose values produce a target calibration drop and phase margin at the calibration frequency without overdriving the ADC or exceeding resistor power. The processor can compute the expected compliance requirements and verify that the source, relay ratings, and resistor wattage are adequate. The processor may then command the internal switch matrix to connect the selected reference resistor for the range under test.

In step 3130, a processor may pick one current range at a time measure current with two different reference loads. For example, a processor may isolate a single source range, connect the first mapped reference resistor, program the calibration tone (frequency and amplitude), triggers a coherent capture, and computes current from the measured voltage using the calibrated path. In some embodiments, the processor may store both measurements and the computed corrections keyed to the current range, frequency, channel identifier.

In step 3140, a processor may determine whether to calibrate or verify. For example, processor may perform a determination similar to the one described for step 2930 in connection with FIG. 29.

In step 3152, a processor may verify amplitude and phase meet specification. For example, a processor may perform a verification similar to the one described in step 2942 described in connection with FIG. 29.

In step 3154, a processor may stop AC voltage source calibration. For example, a processor may stop to the voltage source calibration as described in step 2944 described in connection with FIG. 29.

In step 3160, a processor may perform a calibration to calculate gain/ offset for both amplitude and phase. For example, a processor may perform a calibration similar to the one described in step 2952 in connection with FIG. 29.

In step 3170, a processor may store the gain/offset values for both amplitude and phase. For example, a processor may write the computed amplitude-scale (gain) correction and phase-offset value into a channel-specific calibration table in non-volatile memory, indexing each record by channel identifier, operating mode, range, and calibration frequency. The processor can attach metadata including timestamp, firmware revision, reference source identifier, temperature and supply telemetry, and a table revision number, computes a checksum or cryptographic hash over the record, and performs a write-then-read verification before marking the entry valid. In some embodiments, the processor may also preload the corresponding runtime registers (e.g., DSP gain/offset coefficients and phase-align values).

In step 3180, a processor may store the calibration values or offsets. And in step 3190 a processor may set a verify flag, as discussed above in step 2980 in connection to FIG. 29.

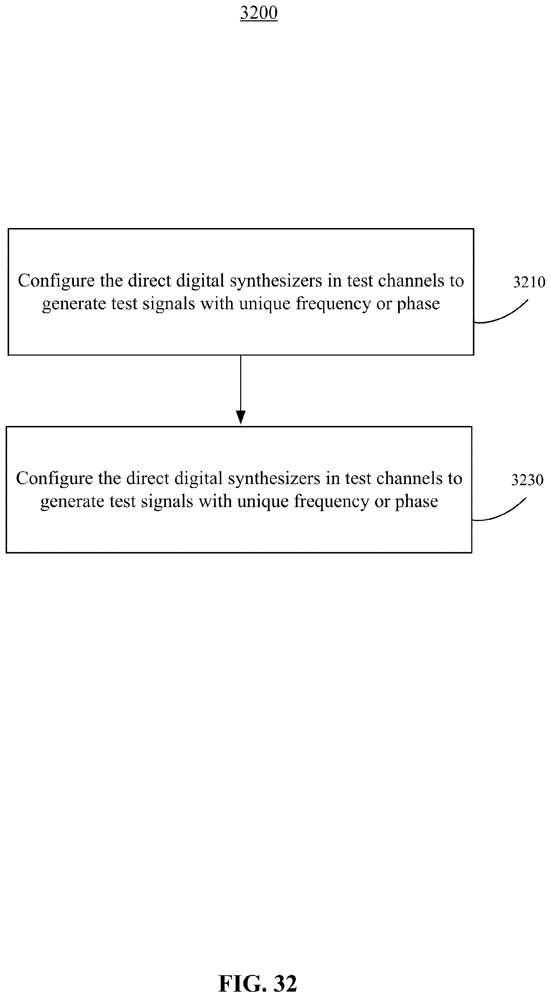

FIG. 32 illustrates a flowchart of an exemplary method 3200 for calibrating an AC voltage source output's amplitude and phase accuracy. Method 3200 may be executed by one or more processors. For example, method 3200 may be executed by elements in system 100. For example, method 3200 may be performed by processing system 711, processor 1230, or other processing devices discussed herein. Alternatively, or additionally, while in some embodiments all steps may be performed by the same processing system, in other embodiments different steps in method 3200 may be performed by different systems. For example, certain steps in method 3200 may be performed by processor system 811 or channel 1100 while others may be performed by other elements in processing system 711.

In step 3210, a processor may configure the direct digital synthesizers in test channels to generate test signals with unique frequency or phase. For example, a processor may select a set of resource channels and assigns each channel a distinct carrier plan derived from the common system clock. Moreover, in certain embodiments, the processor may write the corresponding frequency-tuning word and programmable phase-offset into each channel's DDS/NCO, loads per-range amplitude setpoints, and applies previously stored calibration coefficients (gain/phase trims) to pre-compensate the analog path.

In step 3230, a processor may configure the direct digital synthesizers in test channels to generate test signals with unique frequency or phase. For example, a processor may select a single carrier frequency for participating channels and programs distinct phase codes (for instance, evenly spaced into each channel's DDS phase-shift register) so that responses remain phase-coherent yet distinguishable by phase-sensitive detection. Alternatively, or additionally, when spectral separation is preferred, the processor can assign small frequency offsets chosen to land each tone at a dedicated FFT bin given the capture length and sampling rate, thereby minimizing inter-bin leakage and cross-talk. In both cases, a processor can gate channels with a common trigger and apply per-channel correction tables so reported amplitude/phase are aligned to the hub reference. This coordinated DDS programming allows simultaneous multipin, multi-DUT measurement with unambiguous channel separation in the frequency/phase domain, yielding higher site count, shorter dwell times, and better phase coherence than prior systems that relied on a single CMU and extensive switching.

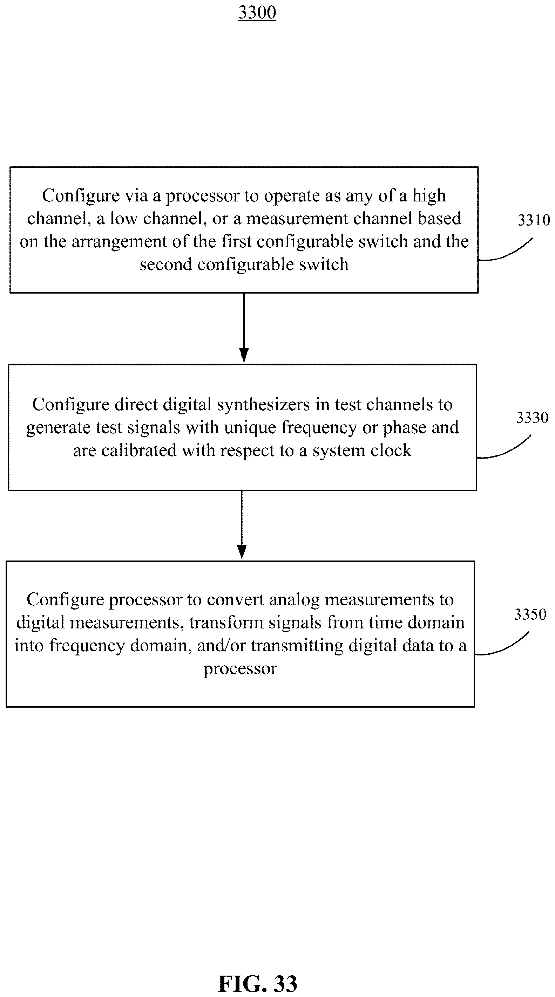

FIG. 33 illustrates a flow chart of a method 3300 for configuration processors and/or digital synthesizers according to an embodiment of the present disclosure.

. Method 3300 may be executed by one or more processors. For example, method 3300 may be executed by elements in system 100. For example, method 3300 may be performed by processing system 711, processor 1230, or any other processing system described herein. Alternatively, or additionally, while in some embodiments all steps may be performed by the same processing system, in other embodiments different steps in method 3300 may be performed by different systems. For example, certain steps in method 3300 may be performed by processor system 811 or channel 1100 while others may be performed by other elements in processing system 711.

In step 3310, a processor may configure channels to operate as any of a high channel, a low channel, or a measurement channel based on the arrangement of the first configurable switch and the second configurable switch. For example, the processor may configure a given test channel to operate as any of a high channel, a low channel, or a measurement channel by appropriately controlling a first configurable switch and a second configurable switch in that channel. For example, the processor may set the switches such that one test channel is connected to provide a high channel output while another channel is set as a low channel to serve as the return path or ground reference for that stimulus.

Alternatively, the processor can arrange the switches to isolate a channel's sensitive measurement circuitry, turning it into a measurement channel that monitors the device's response (voltage, current, etc.) without actively driving the node. In practice, this means any test channel can be dynamically assigned to source or measure roles on-the-fly, giving the system tremendous flexibility. Such per-pin configurability may eliminate the need for dedicated source/measure units tied to specific pins; every channel can perform any function as needed.

The flexibility not only simplifies the hardware architecture (since the same channel can act as a high-force output, a low-return, or a measurement unit), but also improves test coverage and efficiency. By enabling "All Per Pin Resources" functionality (i.e. each pin having full resources for force or measure), the processor's control of the switches fills the gap between benchtop and production test systems, allowing a single system to seamlessly handle legacy, advanced node, and even specialized tests without reconfiguration.

In step 3330, a processor may configure direct digital synthesizers in test channels to generate test signals with unique frequency or phase and are calibrated with respect to a system clock. For example, the processor may configure DDS in the test channels to generate test signals with unique frequencies or phases, all calibrated with respect to a common system clock. For example, the processor might program one channel's DDS to output a sinusoidal voltage at f₁ (e.g. 1.000 MHz) while another channel's DDS outputs a signal at a different frequency f₂ (e.g. 1.200 MHz), and a third channel could generate a waveform at the same frequency as the first but with a defined phase offset (ensuring a known phase relationship between channels). Each DDS is driven by and synchronized to the system clock, so these output waveforms are highly stable and phase-coherent, with frequency accuracy inherited from the reference clock. In some embodiments, each channel may receive a unique signal. By giving each test channel a unique stimulus (either at different frequencies or phases), the system can exercise multiple test conditions simultaneously on a single device or even across multiple devices.

For instance, one channel could stimulate a device's gate with a small AC signal at one frequency while another channel drives the device's substrate or drain with a signal at another frequency; a measurement channel can then discern each signal's effect by filtering or Fourier analysis. This parallel stimulus approach means that the responses to each unique frequency can be isolated and analyzed independently, enabling concurrent multi-frequency testing.

In step 3350, a processor may be configured to convert analog measurements to digital measurements, transform signals from time domain into frequency domain, and/or transmitting digital data to a processor. For example, the processor may configure a circuit (or onboard data acquisition system) to handle the incoming analog measurements and prepare them for analysis. This circuit can be responsible for converting analog measurements to digital form, performing signal processing (such as transforming signals from the time domain to the frequency domain), and transmitting the resulting digital data to a higher-level processor or host computer. For example, the processor may trigger high-speed analog-to-digital converters to sample the voltage or current waveforms obtained by the measurement channel(s), thus digitizing the device's response with high resolution. Once converted to digital data, the processing circuit can apply digital signal processing algorithms.
In some embodiments, the system may use a frequency-domain spectrum allowing the system to extract frequency-specific response components, such as measuring the amplitude and phase at the test frequencies f₁ and f₂ that were injected by the DDS sources in step 3330. By analyzing the frequency-domain data, the tester can directly determine device parameters (e.g. capacitance, resistance at certain frequencies, or gain and phase margin) that would be difficult to isolate in the raw time-domain signal. The ability to perform such transformations internally means the system can do things like LCR meter functions or spectral analysis on-chip, which aligns with advanced parametric test features (for example, measuring gate capacitance at high frequency even in the presence of leakage). Additionally, the processor can compress, filter, or average the digital data as needed to reduce noise and data volume, then transmit the refined digital results to an external controller or software suite for further evaluation.

In the foregoing specification, embodiments have been described with reference to numerous specific details that can vary from implementation to implementation. Certain adaptations and modifications of the described embodiments can be made. Other embodiments can be apparent to those skilled in the art from consideration of the specification and practice of the invention disclosed herein. It is intended that the specification and examples be considered as exemplary only. It is also intended that the sequence of steps shown in figures are only for illustrative purposes and are not intended to be limited to any particular sequence of steps. As such, those skilled in the art can appreciate that these steps can be performed in a different order while implementing the same method.

This disclosure may be described in the general context of customized hardware capable of executing customized preloaded instructions such as, e.g., computer-executable instructions for performing program modules. Program modules may include one or more of routines, programs, objects, variables, commands, scripts, functions, applications, components, data structures, and so forth, which may perform particular tasks or implement particular abstract data types. The disclosed embodiments may also be practiced in distributed computing environments where tasks are performed by remote processing devices that are linked through a communications network. In a distributed computing environment, program modules may be located in local and/or remote computer storage media including memory storage devices.

The present technology includes computer-readable storage mediums for storing instructions, and systems for executing any one of the methods embodied in the instructions addressed in the clauses of the present technology presented below:
Clause i. A system for parametric multi-channel testing, the system including: a plurality of test channels, each of the plurality of test channels including: a pulse resource; a measuring resource including a high current (HC) switch and a low current (LC) switch; a mode switch coupled to the pulse resource, the measuring resource, and a potential node, the potential node being coupled to a testing pin; and a system clock coupled to the plurality of test channels. The potential node is configured for pulse testing when the mode switch connects the pulse resource with the potential node; the potential node is configured for high potential (HP) testing when the HC switch is closed and the mode switch connects the measuring resource with the potential node; and the potential node is configured for low potential (LP) testing when the LC switch is closed and the mode switch connects the measuring resource with the potential node.
Clause ii. The system of clause i, wherein the plurality of test channels include a per-test channel clock; the per-test channel clock of each test channel has a frequency and phase synchronized to the system clock; the channel clocks are configured with a programmable phase offset to compensate a phase shift associated with individual ones of the test channels during calibration; and the LC switch and HC switch are alternately operable, such that when one is in a closed state the other is maintained in an open state.
Clause iii. The system of any of clauses i or ii, wherein each test channel includes a force line coupled to the potential node through at least one of the mode switch, HC switch, or LC switch, and a sense line coupled to the measuring resource and a device under test (DUT); wherein the force line is configured to provide a signal to the DUT and the sense line is configured to detect a voltage at the DUT.
Clause iv. The system of any of clauses i-iii, wherein the measuring resource includes a capacitance measuring unit (CMU) and a source measuring unit (SMU), and the plurality of test channels include a first test channel, a second test channel, a third test channel, and a fourth test channel. The system is configurable to: set the potential nodes of the first, second, and third test channels to a first dynamic potential; set the potential node of the fourth test channel to a second dynamic potential different from the first dynamic potential; and perform a capacitance-voltage (C-V) analysis by applying a voltage and measuring capacitance as a function of the first and second dynamic potentials.
Clause v. The system of any of clauses i-iv, wherein each test channel includes a direct digital synthesizer (DDS) configurable to generate a test signal; the test signal is synchronized in phase and frequency to the system clock; and the plurality of test channels are configured to simultaneously measure a DUT using a timing derived from the system clock.
Clause vi. The system of any of clauses i-v, wherein each test channel includes: a memory; a first analog-to-digital converter (ADC) coupled to the potential node and the memory; a second ADC coupled to the potential node and the memory; a first DDS coupled to the potential node; and a second DDS coupled to at least one of the first or second ADCs.
Clause vii. The system of any of clauses i-vi, wherein each of the test channels further includes: a first fast Fourier transform (FFT) circuit coupled to the first ADC and the memory; and a second FFT circuit coupled to the second ADC and the memory.
Clause viii. The system of any of clauses i-vii, wherein at least one of the first DDS or the second DDS is configured to generate a test signal for measuring a DUT.
Clause ix. The system of any of clauses i-viii, wherein the plurality of test channels include at least eight channels, each of which is configurable with a programmable phase and amplitude; the phase and amplitude are synchronized across the channels; and the pulse resource includes a digital-to-analog converter (DAC) driving a plurality of programmable gain amplifiers (PGAs) whose outputs are selectable by a high-speed switch.
Clause x. The system of any of clauses i-ix, further including a processor coupled to the system clock, wherein each of the plurality of test channels includes a DDS. The processor is configured to: cause the system clock to provide a calibration signal to the plurality of test channels; measure a phase shift of each test channel; and program the measured phase shift into a phase-shift register of a corresponding DDS.
Clause xi. The system of any of clauses i-x, wherein each DDS is configured to generate a test signal with a numerically controlled oscillator (NCO) driven by the system clock, and a programmable phase offset is applied to the NCO to compensate for the phase shift in the corresponding test channel.
Clause xii. The system of any of clauses i-xi, wherein the DDS in each test channel is configured to generate test signals in phase according to the system clock.
Clause xiii. The system of any of clauses i-xii, wherein each test channel includes a high-potential circuit and a low-potential circuit, and each of the test channels is configurable to alternate between the high-potential circuit and the low-potential circuit based on configuration of at least one of the HC or LC switches.
Clause xiv. The system of any of clauses i-xiii, further including a processor configured to: multiplex a first signal to each of the high-potential and low-potential circuits; synchronize the first signal with a trigger signal to align phase across the test channels; calibrate amplitude and phase of each high-potential and low-potential circuit based on the first signal; generate and route a second signal to the high-potential circuit; and calibrate amplitude and phase of the high-potential circuit by comparing the first and second signals.
Clause xv. The system of any of clauses i-xiv, wherein the first signal is a sine wave, the second signal is internally generated, and the processor is further configured to measure a phase difference between the high-potential and low-potential circuits after calibrating the high-potential circuit, and to calibrate the low-potential circuit based on the measured phase difference.
Clause xvi. The system of any of clauses i-xv, wherein the processor is configured to store correction values in memories of the test channels, the correction values including at least one of an amplitude gain or a phase shift relative to the first signal.
Clause xvii. A system for parallel testing, the system including: one or more processors; a system clock; and a plurality of test channels coupled to the processors, each of the test channels including a pulse resource, a measuring resource having a first configurable switch, a second configurable switch, and a direct digital synthesizer; a mode switch coupled to the pulse resource and the measuring resource; and a potential node coupled to a testing pin and the mode switch. Any channel from the plurality of test channels is configurable as a high channel, low channel, pulse channel, or measurement channel based on configuration of the switches, and the processors are configured to: control the DDS units to generate test signals with unique frequency or phase; and simultaneously measure a group of the test channels with phase and frequency determined by the system clock.
Clause xviii. The system of any of clauses xvii, wherein the test channels include a local processor configured to perform FFT on acquired data, the test channels are configured with a frequency offset for FFT bins to isolate channel measurements, and the pulse resource includes a pulse board having a programmable gain amplifier coupled to a slew-rate limiter and a high-speed switch.
Clause xix. The system of any of clauses xvii-xviii, wherein each DDS includes a programmable phase-shift register that stores an offset for the corresponding test channel.
Clause xx. A system for parametric multi-channel testing, the system including: a plurality of test channels, each of the plurality of test channels including a pulse resource, a measuring resource including a first configurable switch, a second configurable switch, and a direct digital synthesizer; a channel processing circuit; and a mode switch coupled to the pulse resource, the measuring resource, and the processing circuit. Each test channel is configurable via a processor to operate as any of a high channel, a low channel, a pulse channel, or a measurement channel based on an arrangement of the first configurable switch, the second configurable switch, and the mode switch. The DDS units in the test channels are configured to generate test signals with unique frequency or phase and are calibrated to the system clock, and the channel processing circuit performs operations including at least one of: converting analog measurements to digital data, transforming time-domain signals to the frequency domain, or transmitting digital data to a processor.
Clause xxi. A system for parametric multi-channel testing, the system including: a plurality of test channels. The plurality of test channels including: a high current (HC) switch; a low current (LC) switch; a potential node coupled to a testing pin, the HC switch, and the LC switch; a channel clock; and a system clock coupled to the plurality of test channels. Further, the potential node is configured for high potential (HP) testing when the HC switch is closed; the potential node is configured for low potential (LP) testing when the LC switch is closed; and the channel clock in each of the plurality of test channels has a frequency and a phase synchronized to the system clock.
Clause xxii. The system of clause xxi, wherein each of the test channels further includes: a force line connected to the potential node via the LC switch or the HC switch, the force line being configured to provide a signal to a device under test (DUT); and a sense line connected to the potential node, the sense line being configured to detect a voltage at the DUT.
Clause xxiii. The system of clauses xxi or xxii, wherein: the plurality of test channels include a first test channel, a second test channel, a third test channel, and a fourth test channel; and the system is configurable to: set the potential node of the first test channel, the second test channel, and the third test channel to a first dynamic potential; set the potential node of the fourth test channel to a second dynamic potential, the second dynamic potential being different than the first dynamic potential; and perform a capacitance-voltage analysis by applying a voltage and measuring capacitance as a function of the first dynamic potential and the second dynamic potential.
Clause xxiv. The system of any of clause xxi-xxiii, wherein each of the channel clocks is configured with a phase offset, the phase offset compensating a phase shift associated with each of the plurality of test channels during calibration.
Clause xxv. The system of any of clauses xxi-xxiv, wherein: each of the test channels includes a direct digital synthesizer (DDS) configurable to generate a test signal; the test signal is configured to be synchronized in phase and frequency to the system clock; and the test channels are configured to simultaneously measure a device under test (DUT) using a timing derived from the system clock.
Clause xxvi. The system of any of clauses xxi-xxv, wherein each of the test channels includes: a memory; a first analog to digital converter (ADC) coupled to the potential node and the memory; a second ADC coupled to connected to the potential node and the memory; a first direct digital synthesizer (DDS) coupled to the potential node; and a second DDS coupled to at least one of the first ADC and the second ADC.
Clause xxvii. The system of any of clauses xxi-xxvi, wherein each of the test channels further includes: a first Fast Fourier Transform (FFT) circuit coupled to the first ADC and the memory; and a second FFT circuit connected to the second ADC and the memory.
Clause xxviii. The system of any of clauses xxi-xxvii, wherein at least one of the first DDS or the second DDS is configured to generate a test signal for measuring a device under test (DUT).
Clause xxix. The system of any of clauses xxi-xxviii, wherein: the test channels include at least eight channels; each of the at least eight channels is configurable with a phase and an amplitude, and the phase and the amplitude are synchronized in each of the at least eight channels.
Clause xxx. The system of any of clauses xxi-xxix, further including: a processor coupled to the system clock; wherein each of the plurality of channels include a direct digital synthetizer (DDS); and the processor is configurable to: cause the system clock to provide a calibration signal to the plurality of test channels; measure a phase shift of each of the test channels; and program the phase shift into a phase shift register of a corresponding DDS.
Clause xxxi. The system of any of clauses xxi-xxx, wherein: the DDS is configurable to generate a test signal with a numerically controlled oscillator (NCO) driven by the system clock, and a programmable phase offset is applied to the NCO to compensate for the phase shift in the corresponding test channel.
Clause xxxii. The system of any of clauses xxi-xxxi, wherein the DDS in each of the plurality of test channels is configured to generate test signals in phase according to the system clock.
Clause xxxiii. The system of any of clauses xxi-xxxii, wherein: each of the test channels includes a high potential circuit and a low potential circuit; and each of the test channels is configurable to alternate between the high potential circuit and the low potential circuit with a configuration of at least one of the HC switch or the LC switch.
Clause xxxiv. The system of any of clauses xxi-xxxiii, further including a processor, wherein the processor is configured to: multiplex a first signal to each of the high potential circuit and the low potential circuit in the test channel; synchronize the first signal with a trigger signal to align a phase across the test channels; calibrate an amplitude and a phase of each of the high potential circuit and the low potential circuit based on the first signal; generate and route a second signal to the high potential circuit; and calibrate amplitude and phase of the high potential circuit based on comparing the first signal and the second signal.
Clause xxxv. The system of any of clauses xxi-xxxiv, wherein: the first signal is a sine wave; the second signal is internally generated; and the processor is further configured to: measure a current phase difference between the high potential circuit and the low potential circuit after calibrating the amplitude and phase of the high potential circuit; and calibrate the low potential circuit based on the measured phase difference.
Clause xxxvi. The system of any of clauses xxi-xxxv, wherein the processor is configured to store correction values in memories of the plurality of test channels, the correction values including at least one of an amplitude gain or a phase shift relative to the first signal.
Clause xxxvii. A system for parallel testing, the system including: one or more processors; a system clock; and a plurality of test channels coupled to the one or more processors, each of the plurality of test channels including: a potential node coupled to a testing pin; a first configurable switch coupled to the potential node; a second configurable switch coupled to the potential node; and a direct digital synthesizer. Further, any channel from the plurality of test channels is configurable as a high channel, low channel, or measurement channel, based on the configuration of corresponding first configurable switch and second configurable switch in the plurality of test channels; and the one or more processor are configurable to perform operations including: configuring the direct digital synthesizers in test channels to generate test signals with unique frequency or phase; and simultaneously measure a group of the plurality of pins by configuring corresponding direct digital synthesizer to generate test signals, the test signals having a phase and frequency determined based on the system clock.
Clause xxxviii. The system of clause xxxvii, wherein the test channels include a local processor, the local processor being configured to perform FFT, and the plurality of test channels are configured with a frequency offset for FFT bins to isolate channel measurements.
Clause xxxix. The system of clause xxxvii, wherein the DDS includes a programmable phase shift register and the phase shift register stores an offset for the corresponding one of the plurality of channels.
Clause xl. A system of parametric multi-channel testing, the system including: a plurality of test channels, each of the plurality of test channels including: a channel processing circuit; a first configurable switch; a second configurable switch; a node coupled to a testing pin, the first configurable switch, and the second configurable switch; and a direct digital synthesizer. Further, each test channel is configurable via a processor to operate as any of a high channel, a low channel, or a measurement channel based on the arrangement of the first configurable switch and the second configurable switch; the direct digital synthesizers in test channels are configured to generate test signals with unique frequency or phase and are calibrated with respect to a system clock; and the processing circuit is configured to performing operations including at least one of: converting analog measurements to digital measurements or transforming signals from time domain into frequency domain, or transmitting digital data to a processor.

## Claims

1. A system for parametric multi-channel testing, the system comprising:
a plurality of test channels, the plurality of test channels comprising:
a pulse resource;
a measuring resource comprising a high current, HC, switch and a low current, LC, switch; and
a mode switch coupled to the pulse resource, the measuring resource, and a potential node, the potential node being coupled to a testing pin;
wherein:
the potential node is configured for pulse testing when the mode switch connects the pulse resource with the potential node;
the potential node is configured for high potential, HP, testing when the HC switch is closed and the mode switch connects the measuring resource with the potential node; and
the potential node is configured for low potential, LP, testing when the LC switch is closed and the mode switch connects the measuring resource with the potential node.

2. The system of claim 1, wherein:
the system comprises a system clock coupled to the plurality of test channels;
the plurality of test channels comprise a per-test channel clock;
the per-test channel clock of test channels has a frequency and a phase synchronized to the system clock;
the channel clocks are configured with a phase offset, the phase offset compensating a phase shift associated with individual ones of the plurality of test channels during calibration; and
the LC switch and the HC switch are alternately operable, such that when one is in a closed state the other is maintained in an open state.

3. The system of claim 1 or 2, wherein the plurality of test channels comprise:
a force line coupled to the potential node and at least one of the mode switch, the LC switch, or the HC switch; and
a sense line coupled to the measuring resource and a device under test, DUT;
wherein:
the force line is configured to provide a signal to the DUT, and
the sense line is configured to detect a voltage at the DUT.

4. The system of any of claims 1 to 3, wherein:
the measuring resource comprises a capacitance measuring unit and a source measure unit;
the plurality of test channels comprise a first test channel, a second test channel, a third test channel, and a fourth test channel; and
the system is configurable to:
set the potential node of the first test channel, the second test channel, and the third test channel to a first dynamic potential,
set the potential node of the fourth test channel to a second dynamic potential, the second dynamic potential being different than the first dynamic potential, and
perform a capacitance-voltage analysis by applying a voltage and measuring capacitance as a function of the first dynamic potential and the second dynamic potential.

5. The system of any of claim 1 to 4, wherein:
each of the test channels comprises a direct digital synthesizer, DDS, configurable to generate a test signal;
the test signal is configured to be synchronized in phase and frequency to a system clock; and
the plurality of test channels are configured to simultaneously measure a device under test, DUT, using a timing derived from the system clock.

6. The system of any of claims 1 to 5, wherein each of the test channels comprises:
a memory;
a first analog to digital converter, ADC, coupled to the potential node and the memory;
a second ADC coupled to the potential node and the memory;
a first direct digital synthesizer, DDS, coupled to the potential node; and
a second DDS coupled to at least one of the first ADC and the second ADC.

7. The system of claim 6,
wherein the test channels further comprise:
a first Fast Fourier Transform, FFT, circuit coupled to the first ADC and the memory, and
a second FFT circuit connected to the second ADC and the memory; and/or
wherein at least one of the first DDS or the second DDS is configured to generate a test signal for measuring a device under test, DUT.

8. The system of any of claims 1 to 7, wherein:
the plurality of test channels comprise at least eight channels;
each of the at least eight channels is configurable with a phase and an amplitude;
the phase and the amplitude are synchronized in each of the at least eight channels; and
the pulse resource comprises one or more of:
a digital to analog converter driving a plurality of programmable gain amplifiers whose outputs are selectable by a high-speed switch, and
an analog to digital converter coupled a buffer.

9. The system of any of claims 1 to 8, further comprising:
a processor coupled a system clock;
wherein the plurality of channels comprise a direct digital synthesizer, DDS, and the processor is configurable to:
cause the system clock to provide a calibration signal to the plurality of test channels,
measure a phase shift of each of the test channels, and
program the phase shift into a phase shift register of a corresponding DDS.

10. The system of claim 9, wherein:
the DDS is configurable to generate a test signal with a numerically controlled oscillator, NCO, driven by the system clock, and
a programmable phase offset is applied to the NCO to compensate for the phase shift in the corresponding test channel.

11. The system of claim 9 or 10, wherein the DDS in each of the plurality of test channels is configured to generate test signals in phase according to the system clock.

12. The system of any of claims 1 to 11, wherein:
each of the test channels comprises a high potential circuit and a low potential circuit; and
each of the plurality of test channels is configurable to alternate between the high potential circuit and the low potential circuit with a configuration of at least one of the HC switch or the LC switch.

13. The system of claim 12, further comprising a processor,
wherein the processor is configured to:
multiplex a first signal to each of the high potential circuit and the low potential circuit in the test channels;
synchronize the first signal with a trigger signal to align a phase across the test channels;
calibrate an amplitude and a phase of each of the high potential circuit and the low potential circuit based on the first signal;
generate and route a second signal to the high potential circuit; and
calibrate amplitude and phase of the high potential circuit based on comparing the first signal and the second signal.

14. The system of claim 13, wherein:
the first signal is a sine wave;
the second signal is internally generated; and
the processor is further configured to:
measure a current phase difference between the high potential circuit and the low potential circuit after calibrating the amplitude and phase of the high potential circuit, and
calibrate the low potential circuit based on the measured current phase difference.

15. The system of claim 13 or 14, wherein the processor is configured to store correction values in memories of the plurality of test channels, the correction values comprising at least one of an amplitude gain or a phase shift relative to the first signal.
